(19) Europäisches Patentamt
European Patent Office
Office européen des brevets

(11) EP 4 444 061 A1

(12) EUROPEAN PATENT APPLICATION

(43) Date of publication:
09.10.2024 Bulletin 2024/41

(21) Application number: 23167016.7

(22) Date of filing: 06.04.2023

(51) International Patent Classification (IPC):
*H10K 50/19* (2023.01) *H10K 85/60* (2023.01)

(52) Cooperative Patent Classification (CPC):
**H10K 50/19; H10K 85/60; H10K 85/654; H10K 85/6572;** H10K 59/32

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Novaled GmbH**
**01099 Dresden (DE)**

(72) Inventors:
- **HUANG, Qiang**
  **01099 Dresden (DE)**
- **RUNGE, Steffen**
  **01099 Dresden (DE)**
- **SCHOLZ, Johannes**
  **01099 Dresden (DE)**
- **KIM, Hun**
  **01099 Dresden (DE)**

(74) Representative: **Michalski Hüttermann & Partner Patentanwälte mbB**
**Kaistraße 16A**
**40221 Düsseldorf (DE)**

# (54) ORGANIC ELECTROLUMINESCENT DEVICE COMPRISING A ORGANIC MATRIX COMPOUND AND ORGANIC ELECTRON TRANSPORT COMPOUND OF FORMULA (I), AND DISPLAY DEVICE COMPRISING THE ORGANIC ELECTROLUMINESCENT DEVICE

(57) The present invention relates to an electroluminescent device comprising a compound of formula (I) and a display device comprising the organic electroluminescent device.

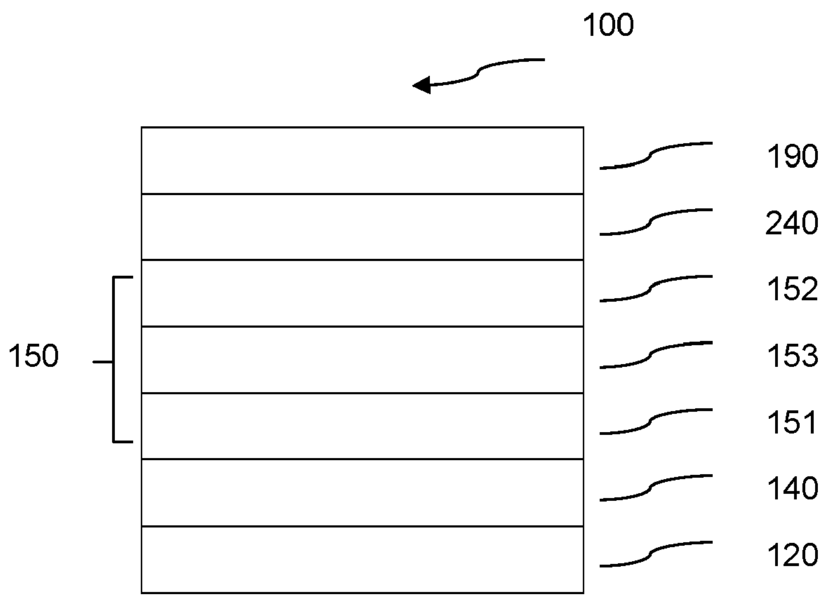


**Fig. 1**

EP 4 444 061 A1

## Description

### Technical Field

The present invention relates to an electroluminescent device comprising an organic matrix compound and organic electron transport compound of formula (I), and display devices comprising the organic electroluminescent device

### Background Art

Organic electroluminescent devices, such as organic light-emitting diodes OLEDs, which are self-emitting devices, have a wide viewing angle, excellent contrast, quick response, high brightness, excellent operating voltage characteristics, and color reproduction. A typical OLED comprises an anode, a hole transport layer HTL, an emission layer EML, an electron transport layer ETL, and a cathode, which are sequentially stacked on a substrate. In this regard, the HTL, the EML, and the ETL are thin films formed from organic compounds.

When a voltage is applied to the anode and the cathode, holes injected from the anode move to the EML, via the HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency and/or a long lifetime.

Performance of an organic light emitting diode may be affected by characteristics of the semiconductor layers, and among them, may be affected by characteristics of the compounds contained in the semiconductor layers.

There remains a need to improve performance of organic electroluminescent devices, in particular to achieve improved operating voltage, improved operating voltage stability over time and improved current efficiency.

### DISCLOSURE

An aspect of the present invention provides an organic electroluminescent device comprising an anode layer, a cathode layer, a first light-emitting unit, a second light-emitting unit and at least one intermediate connecting region, wherein the at least one intermediate connecting region is arranged between the first and the second light-emitting unit,

wherein the first light-emitting unit comprises a first emission layer,
wherein the second light-emitting unit comprises a second emission layer,
wherein the at least one intermediate connecting region comprises an n-type charge generation layer, an intermediate layer, and a p-type charge generation layer,
wherein the n-type charge generation layer is arranged closer to the anode layer than the p-type charge generation layer;
wherein the p-type charge generation layer is arranged closer to the cathode layer than the n-type charge generation layer; and
wherein the intermediate layer is arranged between the n-type charge generation layer and the p-type charge generation layer,
wherein the n-type charge generation layer is in direct contact to the intermediate layer.
wherein p-type charge generation layer comprises a p-dopant, or a p-dopant and a hole transport matrix compound,
wherein the n-type charge generation layer comprises a metal dopant and an organic matrix compound, wherein the organic matrix compound is a compound of formula (I)

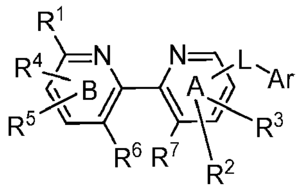
(I)

wherein A denotes pyridine moiety A, and B denotes pyridine moiety B;
wherein $R^1$ is selected from the group consisting of H, D, a substituted or unsubstituted $C_6$ to $C_{30}$ aryl or a substituted or unsubstituted $C_2$ to $C_{30}$ heteroaryl, a substituted or unsubstituted $C_1$ to $C_{16}$ alkyl, a substituted or unsubstituted $C_1$ to $C_{16}$ alkoxy, a substituted or unsubstituted $C_3$ to $C_{16}$ branched alkyl, a substituted or unsubstituted $C_3$ to $C_{16}$ cyclic alkyl, a substituted or unsubstituted $C_3$ to $C_{16}$ branched alkoxy, a substituted or unsubstituted $C_3$ to $C_{16}$ cyclic

alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy, $-PX^a(R^a)_2$, F or CN;

the one or more substituents on $R^1$ are independently selected from the group consisting of D, a substituted or unsubstituted $C_1$ to $C_{16}$ alkyl, a substituted or unsubstituted $C_6$ to $C_{30}$ aryl or a substituted or unsubstituted $C_2$ to $C_{30}$ heteroaryl, a substituted or unsubstituted $C_1$ to $C_{16}$ alkoxy, a substituted or unsubstituted $C_3$ to $C_{16}$ branched alkyl, a substituted or unsubstituted $C_3$ to $C_{16}$ cyclic alkyl, a substituted or unsubstituted $C_3$ to $C_{16}$ branched alkoxy, a substituted or unsubstituted $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy, $-PX^a(R^a)_2$, F or CN;

the one or more substituents are independently selected from the group consisting of D, $C_6$ to $C_{18}$ aryl, $C_3$ to $C_{20}$ heteroaryl, $C_1$ to $C_{16}$ alkyl, $C_1$ to $C_{16}$ alkoxy, $C_3$ to $C_{16}$ branched alkyl, $C_3$ to $C_{16}$ cyclic alkyl, $C_3$ to $C_{16}$ branched alkoxy, $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to C16 alkyl, partially or perdeuterated $C_1$ to $C_{16}$ alkoxy, $-PX^a(R^a)_2$, F or CN;

wherein $R^2$, $R^3$, $R^4$ and $R^5$ are independently selected from the group consisting of H, D, a substituted or unsubstituted $C_6$ to $C_{30}$ aryl or a substituted or unsubstituted $C_2$ to $C_{30}$ heteroaryl, a substituted or unsubstituted $C_1$ to $C_{16}$ alkyl, a substituted or unsubstituted $C_1$ to $C_{16}$ alkoxy, a substituted or unsubstituted $C_3$ to $C_{16}$ branched alkyl, a substituted or unsubstituted $C_3$ to $C_{16}$ cyclic alkyl, a substituted or unsubstituted $C_3$ to $C_{16}$ branched alkoxy, a substituted or unsubstituted $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy, - $PX^a(R^a)_2$, F or CN;

and whereby $R^2$, $R^3$, and /or $R^4$ and $R^5$ may form a substituted or unsubstituted ring, preferably a 5- or 6- membered ring, preferably an aromatic or heteroaromatic ring.

the one or more substituents $R^2$, $R^3$, $R^4$ and $R^5$ are independently selected from the group consisting of D, a substituted or unsubstituted $C_1$ to $C_{16}$ alkyl, a substituted or unsubstituted $C_6$ to $C_{30}$ aryl or a substituted or unsubstituted $C_2$ to $C_{30}$ heteroaryl, a substituted or unsubstituted $C_1$ to $C_{16}$ alkoxy, a substituted or unsubstituted $C_3$ to $C_{16}$ branched alkyl, a substituted or unsubstituted $C_3$ to $C_{16}$ cyclic alkyl, a substituted or unsubstituted $C_3$ to $C_{16}$ branched alkoxy, a substituted or unsubstituted $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy, $-PX^a(R^a)2$, F or CN;

the one or more substituents are independently selected from the group consisting of D, $C_6$ to $C_{18}$ aryl, $C_3$ to $C_{20}$ heteroaryl, $C_1$ to $C_{16}$ alkyl, $C_1$ to $C_{16}$ alkoxy, $C_3$ to $C_{16}$ branched alkyl, $C_3$ to $C_{16}$ cyclic alkyl, $C_3$ to $C_{16}$ branched alkoxy, $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to C16 alkyl, partially or perdeuterated $C_1$ to $C_{16}$ alkoxy, $-PX^a(R^a)_2$, F or CN;

wherein $R^6$ and $R^7$ are independently selected from the group consisting of a bond, H, D, a substituted or unsubstituted $C_1$ to $C_{16}$ alkyl, a substituted or unsubstituted $C_2$ to $C_8$ alkylene, a substituted or unsubstituted $C_6$ to $C_{30}$ aryl, a substituted or unsubstituted $C_6$ to $C_{30}$ arylene or a substituted or unsubstituted $C_2$ to $C_{30}$ heteroaryl, a substituted or unsubstituted $C_2$ to $C_{30}$ heteroarylene, a substituted or unsubstituted $C_1$ to $C_{16}$ alkoxy, a substituted or unsubstituted $C_3$ to $C_{16}$ branched alkyl, a substituted or unsubstituted $C_3$ to $C_{16}$ cyclic alkyl, a substituted or unsubstituted $C_3$ to $C_{16}$ branched alkoxy, a substituted or unsubstituted $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy, $-PX^a(R^a)_2$, F or CN;

the one or more substituents on $R^6$ and $R^7$ are independently selected from the group consisting of D, a substituted or unsubstituted $C_1$ to $C_8$ alkyl, a substituted or unsubstituted $C_6$ to $C_{30}$ aryl or a substituted or unsubstituted $C_2$ to $C_{30}$ heteroaryl, a substituted or unsubstituted $C_1$ to $C_{16}$ alkoxy, a substituted or unsubstituted $C_3$ to $C_{16}$ branched alkyl, a substituted or unsubstituted $C_3$ to $C_{16}$ cyclic alkyl, a substituted or unsubstituted $C_3$ to $C_{16}$ branched alkoxy, a substituted or unsubstituted $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy, $-PX^a(R^a)2$, F or CN;

the one or more substituents are independently selected from the group consisting of D, $C_6$ to $C_{18}$ aryl, $C_3$ to $C_{20}$ heteroaryl, $C_1$ to $C_{16}$ alkyl, $C_1$ to $C_{16}$ alkoxy, $C_3$ to $C_{16}$ branched alkyl, $C_3$ to $C_{16}$ cyclic alkyl, $C_3$ to $C_{16}$ branched alkoxy, $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to C16 alkyl, partially or perdeuterated $C_1$ to $C_{16}$ alkoxy, $-PX^a(R^a)_2$, F or CN;

wherein $R^6$ and $R^7$ can form a condensed ring system with the pyridine moiety A and B;

wherein $R^6$ and $R^7$ together can represent ethenylene, which can be further substituted, whereby the substituents are independently chosen from D, a substituted or unsubstituted $C_1$ to $C_{16}$ alkyl, a substituted or unsubstituted $C_2$ to $C_8$ alkylene, a substituted or unsubstituted $C_6$ to $C_{30}$ aryl, a substituted or unsubstituted $C_6$ to $C_{30}$ arylene or a substituted or unsubstituted $C_2$ to $C_{30}$ heteroaryl, a substituted or unsubstituted $C_2$ to $C_{30}$ heteroarylene, a substituted or unsubstituted $C_1$ to $C_{16}$ alkoxy, a substituted or unsubstituted $C_3$ to $C_{16}$ branched alkyl, a substituted or unsubstituted $C_3$ to $C_{16}$ cyclic alkyl, a substituted or unsubstituted $C_3$ to $C_{16}$ branched alkoxy, a substituted or unsubstituted

$C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy, -$PX^a(R^a)2$, F or CN;
wherein L-Ar can be bound to a part of the condensed ring system, if present, formed by $R^6$ and $R^7$ and the pyridine moiety A and B;
wherein L-Ar can be bound to ethenylene if $R^6$ and $R^7$ together represents ethenylene;
wherein L is selected from the group consisting of an substituted or unsubstituted $C_6$ to $C_{24}$ arylene or substituted or unsubstituted $C_3$ to $C_{22}$ heteroarylene,
wherein the one or more substituents on L are independently selected from the group consisting of D, a substituted or unsubstituted $C_1$ to $C_{16}$ alkyl, a substituted or unsubstituted $C_6$ to $C_{30}$ aryl or a substituted or unsubstituted $C_2$ to $C_{30}$ heteroaryl, a substituted or unsubstituted $C_1$ to $C_{16}$ alkoxy, a substituted or unsubstituted $C_3$ to $C_{16}$ branched alkyl, a substituted or unsubstituted $C_3$ to $C_{16}$ cyclic alkyl, a substituted or unsubstituted $C_3$ to $C_{16}$ branched alkoxy, a substituted or unsubstituted $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy, -$PX^a(R^a)_2$, F or CN;
the one or more substituents are independently selected from D, $C_6$ to $C_{18}$ aryl, $C_3$ to $C_{20}$ heteroaryl, $C_1$ to $C_{16}$ alkyl, $C_1$ to $C_{16}$ alkoxy, $C_3$ to $C_{16}$ branched alkyl, $C_3$ to $C_{16}$ cyclic alkyl, $C_3$ to $C_{16}$ branched alkoxy, $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to C16 alkyl, partially or perdeuterated $C_1$ to $C_{16}$ alkoxy, -$PX^a(R^a)_2$, F or CN;
wherein Ar is selected from the group consisting of a substituted or unsubstituted $C_6$ to $C_{30}$ aryl or a substituted or unsubstituted $C_2$ to $C_{30}$ heteroaryl,
the one or more substituents on Ar are independently selected from the group consisting of D, a substituted or unsubstituted $C_1$ to $C_{16}$ alkyl, substituted or unsubstituted $C_2$ to $C_{16}$ alkenyl, a substituted or unsubstituted $C_6$ to $C_{30}$ aryl or a substituted or unsubstituted $C_2$ to $C_{30}$ heteroaryl, a substituted or unsubstituted $C_1$ to $C_{16}$ alkoxy, a substituted or unsubstituted $C_3$ to $C_{16}$ branched alkyl, a substituted or unsubstituted $C_3$ to $C_{16}$ cyclic alkyl, a substituted or unsubstituted $C_3$ to $C_{16}$ branched alkoxy, a substituted or unsubstituted $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy, -$PX^a(R^a)_2$, F or CN;
the one or more substituents are independently selected from the group consisting of D, $C_6$ to $C_{18}$ aryl, $C_3$ to $C_{20}$ heteroaryl, $C_1$ to $C_{16}$ alkyl, $C_1$ to $C_{16}$ alkoxy, $C_3$ to $C_{16}$ branched alkyl, $C_3$ to $C_{16}$ cyclic alkyl, $C_3$ to $C_{16}$ branched alkoxy, $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to C16 alkyl, partially or perdeuterated $C_1$ to $C_{16}$ alkoxy, -$PX^a(R^a)_2$, F or CN;
wherein $X^a$ may be selected from S or O; and
wherein $R^a$ are independently selected from the group consisting of $C_6$ to $C_{12}$ aryl, $C_3$ to $C_{12}$ heteroaryl, $C_1$ to $C_{16}$ alkyl, $C_1$ to $C_{16}$ alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy;
and wherein the intermediate layer consists of or consists essentially of one or more organic electron transport compounds, wherein at least one of the one or more organic electron transport compounds is a compound of formula (I),
wherein the organic matrix compound and the organic electron transport compound of formula (I) can be selected the same or different,
wherein the organic electron transport compound has a LUMO energy level and the organic matrix compound has a LUMO energy level,
wherein the LUMO energy level of the organic matrix compound of formula (I) and the LUMO energy level of the organic electron transport compound of formula (I) in the intermediate layer have a difference of $\pm 0.5$ eV when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

It should be noted that throughout the application and the claims any $A^n$, $B^n$, $R^n$, $X^n$ etc. always refer to the same moieties, unless otherwise noted.

In the present specification, when a definition is not otherwise provided, "substituted" refers to one substituted with a deuterium, $C_1$ to $C_{12}$ alkyl and $C_1$ to $C_{12}$ alkoxy.

However, in the present specification "aryl substituted" refers to a substitution with one or more aryl groups, which themselves may be substituted with one or more aryl and/or heteroaryl groups.

Correspondingly, in the present specification "heteroaryl substituted" refers to a substitution with one or more heteroaryl groups, which themselves may be substituted with one or more aryl and/or heteroaryl groups.

In the present specification, when a definition is not otherwise provided, an "alkyl group" refers to a saturated aliphatic hydrocarbyl group. The alkyl group may be a $C_1$ to $C_{12}$ alkyl group. More specifically, the alkyl group may be a $C_1$ to $C_{10}$ alkyl group or a $C_1$ to $C_6$ alkyl group. For example, a $C_1$ to $C_4$ alkyl group includes 1 to 4 carbons in alkyl

chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an isopropyl group, a butyl group, an iso-butyl group, a sec-butyl group, a tert-butyl group, a pentyl group, a hexyl group.

The term "cycloalkyl" refers to saturated hydrocarbyl groups derived from a cycloalkane by formal abstraction of one hydrogen atom from a ring atom comprised in the corresponding cycloalkane. Examples of the cycloalkyl group may be a cyclopropyl group, a cyclobutyl group, a cyclopentyl group, a cyclohexyl group, a methylcyclohexyl group, an adamantly group and the like.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S.

In the present specification, "aryl group" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more aromatic rings linked by single bonds, like biphenyl, and polycyclic groups comprising fused rings, like naphtyl or fluoren-2-yl.

Analogously, under heteroaryl, it is especially where suitable understood a group derived by formal abstraction of one ring hydrogen from a heterocyclic aromatic ring in a compound comprising at least one such ring.

Under heterocycloalkyl, it is especially where suitable understood a group derived by formal abstraction of one ring hydrogen from a saturated cycloalkyl ring in a compound comprising at least one such ring.

The term "fused aryl rings" or "condensed aryl rings" is understood the way that two aryl rings are considered fused or condensed when they share at least two common $sp^2$-hybridized carbon atoms.

The term "cyano moiety" refers to a CN substituent.

The term "electron-withdrawing group" refers to a chemical group in a molecule, which can draw electrons away from an adjacent part of the molecule. The distance over which the electron-withdrawing group can exert its effect, namely the number of bonds over which the electron-withdrawing effect spans, is extended by conjugated pi-electron systems such as aromatic systems. Examples of electron-withdrawing groups include $NO_2$, CN, halogen, Cl, F, partially fluorinated or perfluorinated alkyl and partially fluorinated or perfluorinated $C_1$ to $C_{12}$ alkyl, partially fluorinated or perfluorinated alkoxy, partially fluorinated or perfluorinated $C_1$ to $C_6$ alkoxy.

The terms "-*", "-$*^1$", "-$*^2$" especially mean and/or include a bond at which the respective group, residue or moiety is bound to.

The term "$R^6$ and $R^7$ represents together an ethenylene" especially means and or includes that $R^6$ and $R^7$ forms with the pyridine moiety A and B a phenanthroline moiety.

In the present specification, the single bond refers to a direct bond.

The term "consisting essentially of" in the context of this invention especially ≥99.0 wt.-%, more preferably ≥99.5 wt.-%, more preferably ≥99.75 wt.-%, more preferably ≥99.80 wt.-%, more preferably ≥99.85 wt.-%, more preferably ≥99.9 wt.-%, more preferably ≥99.95 wt.-% and most preferred ≥99.99 wt.-%.

The term "n-type charge generation layer" is sometimes in the art also named n-CGL or electron generation layer and is intended to include the both.

The term "p-type charge generation layer" is sometimes in the art also named p-CGL or hole generation layer and is intended to include the both.

The term "free of", "does not contain", "does not comprise" does not exclude impurities which may be present in the compounds prior to deposition. Impurities have no technical effect with respect to the object achieved by the present invention.

The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.

The terms "OLED", "organic light-emitting diode" and "organic light-emitting device" are used synonymously.

The terms "anode", "anode layer" and "anode electrode" are used synonymously.

The terms "cathode", "cathode layer" and "cathode electrode" are used synonymously.

The term "top emission device" is understood to mean an organic electroluminescent device wherein the light is emitted through the cathode layer.

The term "bottom emission device" is understood to mean an organic electroluminescent device wherein the light is emitted through the substrate.

In the specification, hole characteristics refer to an ability to donate an electron to form a hole when an electric field is applied and that a hole formed in the anode may be easily injected into the emission layer and transported in the

emission layer due to conductive characteristics according to a highest occupied molecular orbital (HOMO) level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) level.

## Advantageous Effects

Surprisingly, it was found that the organic electroluminescent device according to the invention solves the problem underlying the present invention by enabling devices in various aspects superior over the organic electroluminescent devices known in the art, in particular with respect to improved operating voltage stability over time.

In the following certaing layers and/or compounds of the organic electroluminescent device are described in more detail; all embodiments may be combined *ad libitum.*

## Intermediate layer

According to an embodiment, the intermediate layer is free or essentially free of metal dopant.

According to an embodiment, wherein the **intermediate layer** consists of or consists essentially of one or more organic electron transport compounds, wherein the one or more organic electron transport compound is independently a compound of formula (I),

According to an embodiment, the intermediate layer consists of one or more organic electron transport compounds, wherein at least one of the one or more organic electron transport compounds is independently a compound of formula (I).

According to an embodiment, the intermediate layer consists of one or more organic electron transport compounds, wherein the one or more organic electron transport compounds is independently a compound of formula (I).

According to a preferred embodiment, the intermediate layer consists of one organic electron transport compound, wherein the organic electron transport compound is a compound of formula (I).

According to an embodiment, the intermediate layer has a thickness of equal or less than 5.0 nm, preferably equal or less than 4.0 nm, more preferably equal or less than 3.0 nm, and most preferably equal or less than 2.0 nm.

According to an embodiment, the intermediate layer has a thickness of 0.1 to 5.0 nm, preferably 1.0 nm to 5.0 nm, more preferably 1.0 nm to 3.0 nm, and most preferably 1.0 nm to 2.0 nm. Above 1 nm the voltage stability over time will be improved.

Using an intermediate layer having a thickness of equal or less than 5.0 nm can for many applications further reduce the operational voltage. Moreover, using an intermediate layer having a thickness of equal or less than 2.0 nm can further improve the operational voltage.

According to an embodiment, wherein the organic electron transport compound of formula (I) has a LUMO energy level and the organic matrix compound of formula (I) has a LUMO energy level,
wherein the LUMO energy level of the organic matrix compound of formula (I) in the n-type charge generation layer and the LUMO energy level of the organic electron transport compound of formula (I) in the intermediate layer have a difference of $\pm$0.50 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, preferably $\pm$0.30 eV, more preferably $\pm$0.25 eV, even more preferably $\pm$0.20 eV, even more preferably $\pm$0.10 eV, and most preferably of $\pm$0 eV. The lower the difference of the LUMO energy level of the n-type charge generation layer and the organic electron transport compound in the intermediate layer the better the improvement of the operational voltage, i.e. reduction of operational voltage while the stability of the device is improved at the same time.

According to an embodiment, the organic matrix compound of formula (I) and the organic electron transport compound of formula (I) are selected the same. If the same compound is used as organic matrix compound and as organic electron transport compound, the operational voltage can for many applications further be decreased while the stability of the device is improved at the same time.

According to an embodiment, wherein the organic electron transport compound of formula (I) has a LUMO energy level and the organic matrix compound of formula (I) has a LUMO energy level, wherein the LUMO energy level of the organic matrix compound of formula (I) in the n-type charge generation layer and the LUMO energy level of the organic electron transport compound of formula (I) in the intermediate layer have a difference of $\pm$0.25 eV, and wherein the compound of formula (I) has a LUMO energy level of equal or less than -1.47 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to an embodiment, wherein the organic electron transport compound of formula (I) has a LUMO energy level and the organic matrix compound of formula (I) has a LUMO energy level, wherein the LUMO energy level of the organic matrix compound of formula (I) in the n-type charge generation layer and the LUMO energy level of the

organic electron transport compound of formula (I) in the intermediate layer have a difference of ±0.25 eV, and wherein the compound of formula (I) has a LUMO energy level of equal or less than -1.50 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to an embodiment, wherein the organic electron transport compound of formula (I) has a LUMO energy level and the organic matrix compound of formula (I) has a LUMO energy level, wherein the LUMO energy level of the organic matrix compound of formula (I) in the n-type charge generation layer and the LUMO energy level of the organic electron transport compound of formula (I) in the intermediate layer have a difference of ±0.25 eV, and wherein the compound of formula (I) has a LUMO energy level of equal or less than -1.52 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to an embodiment, wherein the organic electron transport compound of formula (I) has a LUMO energy level and the organic matrix compound of formula (I) has a LUMO energy level, wherein the LUMO energy level of the organic matrix compound of formula (I) in the n-type charge generation layer and the LUMO energy level of the organic electron transport compound of formula (I) in the intermediate layer have a difference of ±0.25 eV, and wherein the compound of formula (I) has a LUMO energy level of equal or less than -1.54 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to an embodiment, wherein the organic electron transport compound of formula (I) has a LUMO energy level and the organic matrix compound has a LUMO energy level, wherein the LUMO energy level of the organic matrix compound of formula (I) in the n-type charge generation layer and the LUMO energy level of the organic electron transport compound of formula (I) in the intermediate layer have a difference of ±0.20 eV, and wherein the compound of formula (I) has a LUMO energy level of equal or less than -1.47 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to an embodiment, wherein the organic electron transport compound of formula (I) has a LUMO energy level and the organic matrix compound of formula (I) has a LUMO energy level, wherein the LUMO energy level of the organic matrix compound of formula (I) in the n-type charge generation layer and the LUMO energy level of the organic electron transport compound of formula (I) in the intermediate layer have a difference of ±0.20 eV, and wherein the compound of formula (I) has a LUMO energy level of equal or less than -1.50 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to an embodiment, wherein the organic electron transport compound of formula (I) has a LUMO energy level and the organic matrix compound of formula (I) has a LUMO energy level, wherein the LUMO energy level of the organic matrix compound of formula (I) in the n-type charge generation layer and the LUMO energy level of the organic electron transport compound of formula (I) in the intermediate layer have a difference of ±0.20 eV, and wherein the compound of formula (I) has a LUMO energy level of equal or less than -1.52 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to an embodiment, the organic electron transport compound of formula (I) has a LUMO energy level and the organic matrix compound of formula (I) has a LUMO energy level, wherein the LUMO energy level of the organic matrix compound of formula (I) in the n-type charge generation layer and the LUMO energy level of the organic electron transport compound of formula (I) in the intermediate layer have a difference of ±0.20 eV, and wherein the compound of formula (I) has a LUMO energy level of equal or less than -1.54 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to an embodiment, the organic electron transport compound of formula (I) has a LUMO energy level and the organic matrix compound of formula (I) has a LUMO energy level, wherein the LUMO energy level of the organic matrix compound of formula (I) in the n-type charge generation layer and the LUMO energy level of the organic electron transport compound of formula (I) in the intermediate layer have a difference of ±0.10 eV, and wherein the compound of formula (I) has a LUMO energy level of equal or less than -1.47 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to an embodiment, the organic electron transport compound of formula (I) has a LUMO energy level and the organic matrix compound of formula (I) has a LUMO energy level, wherein the LUMO energy level of the organic matrix compound of formula (I) in the n-type charge generation layer and the LUMO energy level of the organic electron transport compound of formula (I) in the intermediate layer have a difference of ±0.10 eV, and wherein the compound of formula (I) has a LUMO energy level of equal or less than -1.50 eV, when calculated with the program package

TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to an embodiment, the organic electron transport compound of formula (I) has a LUMO energy level and the organic matrix compound of formula (I) has a LUMO energy level, wherein the LUMO energy level of the organic matrix compound of formula (I) in the n-type charge generation layer and the LUMO energy level of the organic electron transport compound of formula (I) in the intermediate layer have a difference of ±0.10 eV, and wherein the compound of formula (I) has a LUMO energy level of equal or less than -1.52 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to an embodiment, the organic electron transport compound of formula (I) has a LUMO energy level and the organic matrix compound of formula (I) has a LUMO energy level, wherein the LUMO energy level of the organic matrix compound of formula (I) in the n-type charge generation layer and the LUMO energy level of the organic electron transport compound of formula (I) in the intermediate layer have a difference of ±0.10 eV, and wherein the compound of formula (I) has a LUMO energy level of equal or less than -1.54 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to an embodiment, the organic electron transport compound of formula (I) has a LUMO energy level and the organic matrix compound of formula (I) has a LUMO energy level, wherein the LUMO energy level of the organic matrix compound of formula (I) in the n-type charge generation layer and the LUMO energy level of the organic electron transport compound of formula (I) in the intermediate layer have a difference of 0 eV, and wherein the compound of formula (I) has a LUMO energy level of equal or less than -1.47 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to an embodiment, the organic electron transport compound has a LUMO energy level and the organic matrix compound of formula (I) has a LUMO energy level, wherein the LUMO energy level of the organic matrix compound of formula (I) in the n-type charge generation layer and the LUMO energy level of the organic electron transport compound of formula (I) in the intermediate layer have a difference of 0 eV, and wherein the compound of formula (I) has a LUMO energy level of equal or less than -1.50 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to an embodiment, the organic electron transport compound of formula (I) has a LUMO energy level and the organic matrix compound of formula (I) has a LUMO energy level, wherein the LUMO energy level of the organic matrix compound of formula (I) in the n-type charge generation layer and the LUMO energy level of the organic electron transport compound of formula (I) in the intermediate layer have a difference of ±0 eV, and wherein the compound of formula (I) has a LUMO energy level of equal or less than -1.52 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to an embodiment, the organic electron transport compound of formula (I) has a LUMO energy level and the organic matrix compound of formula (I) has a LUMO energy level, wherein the LUMO energy level of the organic matrix compound of formula (I) in the n-type charge generation layer and the LUMO energy level of the organic electron transport compound of formula (I) in the intermediate layer have a difference of 0 eV, and wherein the compound of formula (I) has a LUMO energy level of equal or less than -1.54 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to an embodiment, the organic matrix compound of formula (I) and the organic electron transport compound of formula (I) are selected the same, and wherein the compound of formula (I) has a LUMO energy level of equal or less than -1.47 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to an embodiment, the organic matrix compound of formula (I) and the organic electron transport compound of formula (I) are selected the same, and wherein the compound of formula (I) has a LUMO energy level of equal or less than -1.50 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to an embodiment, the organic matrix compound of formula (I) and the organic electron transport compound of formula (I) are selected the same, and wherein the compound of formula (I) has a LUMO energy level of equal or less than -1.52 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in

the gas phase.

According to an embodiment, the organic matrix compound of formula (I) and the organic electron transport compound of formula (I) are selected the same, and wherein the compound of formula (I) has a LUMO energy level of equal or less than -1.54 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

**Compound of formula (I)**

According to an embodiment, wherein the compound of formula (I) has a LUMO energy level of equal or less than -1.47 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, preferably equal or less than -1.50 eV, more preferably -1.52 eV most preferably equal or less than -1.54 eV. The use of a compound of formula (I) having a LUMO energy level of equal or less than -1.47 eV may further reduce the operational voltage while the stability of the device is increased. Moreover, the smaller the LUMO energy level of the compound of formula (I) the lower the operational voltage while the stability of the device is increased.

A particular improvement can be achieved for many applications if the organic matrix compound and the organic electron transport compound have a LUMO energy level equal or less than -1.47 eV. The use of a compound of formula (I) having a LUMO energy level of equal or less than -1.47 eV may further reduce the operational voltage while the stability of the device is increased. Moreover, the smaller the LUMO energy level of the compound of formula (I) the lower the operational voltage while the stability of the device is increased.

According to an embodiment, the compound of formula (I) has a LUMO energy level of ≥-2.2 eV and ≤ -1.47 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, preferably ≥-2.0 eV and ≤ -1.50 eV, more preferably ≥-1.9 eV and ≤ -1.52 eV, and most preferably ≥-1.85 eV and ≤ -1.54 eV. A further improvement of the operational voltage while the stability of the device is increased can be achieved by the aforementioned ranges for many applications within the present invention.

According an embodiment, the compound of formula (I) is selected from the compounds of formula (II)

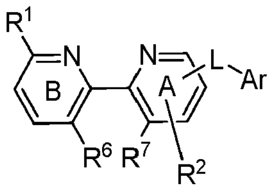

(II)

According to an embodiment, the compound of formula (I) is selected from formulae (IIIa) and (IIIb)

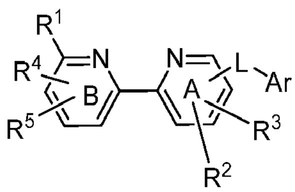

(IIIa)

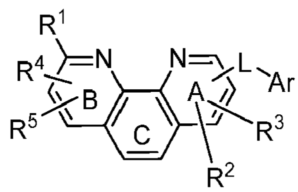

(IIIb)

wherein L-Ar can be bound to ring moiety A or ring moiety C, if present, preferably L-Ar is bound to the ring moiety A.

According to an embodiment, the compound of formula (I), (II), (IIIa), or (IIIb) is selected from formula (IVa) and (IVb)

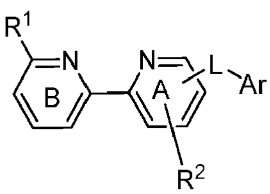

(IVa)

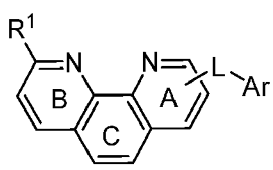

(IVb)

wherein L-Ar can be bound to ring moiety A or ring moiety C, if present, preferably L-Ar is bound to the ring moiety A.

According to an embodiment, wherein $R^6$ and $R^7$ in formula (I), (II), (III), (IVa), (IVb), if present, are independently selected from the group

consisting of a bond, H, D, a substituted or unsubstituted $C_1$ to $C_4$ alkyl, a substituted or unsubstituted $C_2$ to $C_8$ alkylene, a substituted or unsubstituted $C_6$ to $C_{12}$ aryl, a substituted or unsubstituted $C_3$ to $C_{12}$ heteroaryl,
the one or more substituents are independently selected from the group consisting of D, $C_6$ to $C_{18}$ aryl, $C_3$ to $C_{18}$ heteroaryl,
wherein $R^6$ and $R^7$ can form a condensed ring system with the pyridine moiety A and B;
wherein $R^6$ and $R^7$ together can represent ethenylene,
wherein L-Ar can be bound to a part of the condensed ring system, if present, formed by $R^6$ and $R^7$ and the pyridine moiety A and B;
wherein L-Ar can be bound to ethenylene if $R^6$ and $R^7$ together represents ethenylene;

According to an embodiment, $R^6$ and $R^7$ in formula (I), (II), (III), (IVa), (IVb), if present, are selected from H, D or $R^6$ and $R^7$ represent together an ethenylene, wherein L-Ar can be bound to ethenylene if $R^6$ and $R^7$ together represents ethenylene;

According to an embodiment, $R^1$ in formula (I), (II), (III), (IVa), (IVb), if present, is selected from the group consisting of H, D, a substituted or unsubstituted $C_6$ to $C_{18}$ aryl or a substituted or unsubstituted $C_3$ to $C_{18}$ heteroaryl, a substituted or unsubstituted $C_1$ to $C_6$ alkyl,;

the one or more substituents on $R^1$ are independently selected from the group consisting of D, a substituted or unsubstituted $C_6$ to $C_{30}$ aryl or a substituted or unsubstituted $C_2$ to $C_{30}$ heteroaryl,
the one or more substituents are independently selected from the group consisting of D, $C_6$ to $C_{18}$ aryl, $C_3$ to $C_{18}$ heteroaryl,
and wherein $R^2$, $R^3$, $R^4$ and $R^5$ in formula (I), (II), (III), (IVa), (IVb), if present, are independently selected from the group consisting of H, D, a substituted or unsubstituted $C_6$ to $C_{18}$ aryl or a substituted or unsubstituted $C_{18}$ to $C_{18}$ heteroaryl,
the one or more substituents $R^2$, $R^3$, $R^4$ and $R^5$ are independently selected from the group consisting of D, a substituted or unsubstituted $C_6$ to $C_{18}$ aryl or a substituted or unsubstituted $C_3$ to $C_{18}$ heteroaryl,
the one or more substituents are independently selected from the group consisting of D, $C_6$ to $C_{18}$ aryl, $C_3$ to $C_{18}$ heteroaryl.

According to an embodiment, $R^3$ to $R^5$ are H and $R^1$ and $R^2$ are selected from H, unsubstituted phenyl or unsubstituted pyridinyl.

According to an embodiment the moiety L-Ar is in $\alpha$-position to a nitrogen in either Ring A or B.

According to an embodiment, L in formula (I), (II), (III), (IVa), (IVb) is selected from the moieties L1 to L26:

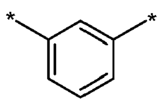
L1,

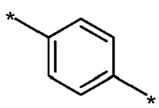
L2,

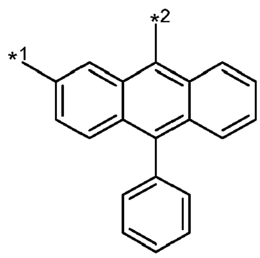
L3,

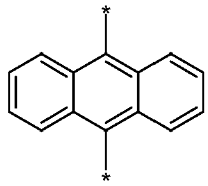
L4,
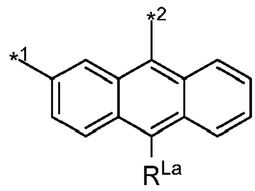
L5,
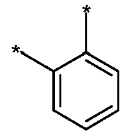
L6,

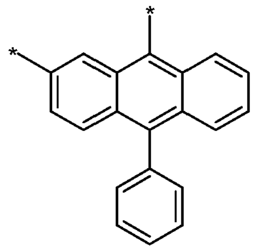
L7,
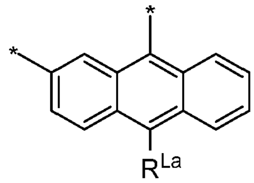
L8,
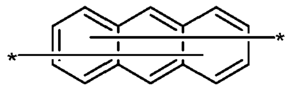
L9,

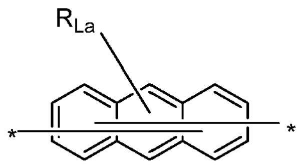
L10,
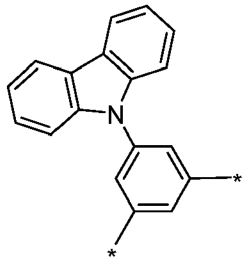
L11,
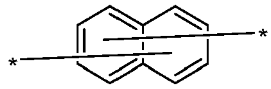
L12,

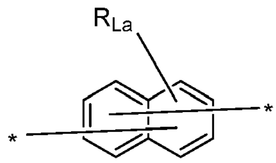
L13,
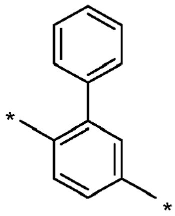
L14,
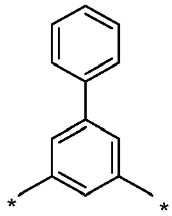
L15,

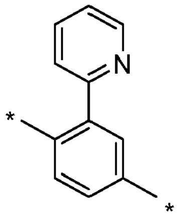
L16,
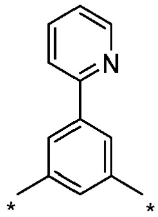
L17,
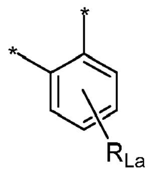
L18,

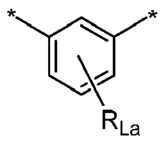

L19,

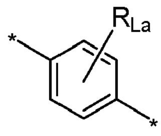

L20,

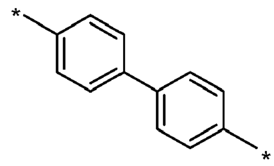

L21,

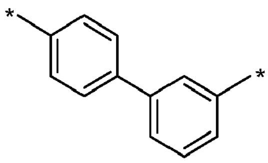

L22,

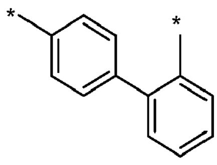

L23,

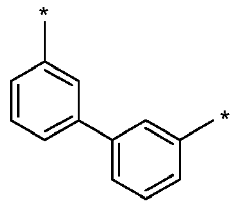

L24,

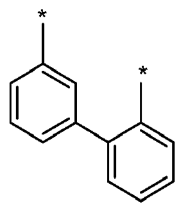

L25,

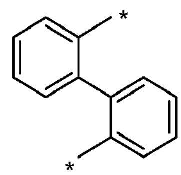

L26,

wherein

the asterisk "*" denotes the binding position to the pyridine moiety A or Ar, and wherein the asterisk "*1" denotes the binding position to the pyridine moiety A, and the asterisk "*2" denotes the binding position to Ar;

$R^{La}$ is selected from group consisting of D, a substituted or unsubstituted $C_1$ to $C_{16}$ alkyl, a substituted or unsubstituted $C_6$ to $C_{30}$ aryl or a substituted or unsubstituted $C_2$ to $C_{30}$ heteroaryl, a substituted or unsubstituted $C_1$ to $C_{16}$ alkoxy, a substituted or unsubstituted $C_3$ to $C_{16}$ branched alkyl, a substituted or unsubstituted $C_3$ to $C_{16}$ cyclic alkyl, a substituted or unsubstituted $C_3$ to $C_{16}$ branched alkoxy, a substituted or unsubstituted $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy, $-PX^a(R^a)_2$, F or CN;

the one or more substituents are independently selected from the group consisting of D, $C_6$ to $C_{18}$ aryl, $C_3$ to $C_{20}$ heteroaryl, $C_1$ to $C_{16}$ alkyl, $C_1$ to $C_{16}$ alkoxy, $C_3$ to $C_{16}$ branched alkyl, $C_3$ to $C_{16}$ cyclic alkyl, $C_3$ to $C_{16}$ branched alkoxy, $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to C16 alkyl, partially or perdeuterated $C_1$ to $C_{16}$ alkoxy, $-PX^a(R^a)_2$, F or CN;

wherein $\mathbf{X^a}$ may be selected from S or O; and

wherein $\mathbf{R^a}$ are independently selected from the group consisting of $C_6$ to $C_{12}$ aryl, $C_3$ to $C_{12}$ heteroaryl, $C_1$ to $C_{16}$ alkyl, $C_1$ to $C_{16}$ alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy.

According to a preferred embodiment, L in formula (I), (II), (III), (IVa), (IVb) is selected from **L1 to L6.**

According to a more preferred embodiment, L in formula (I), (II), (III), (IVa), (IVb) is selected from **L1 to L4.**

According to an embodiment, Ar in formula (I), (II), (III), (IVa), (IVb), may independently be selected from substituted or unsubstituted phenyl, biphenyl, fluorenyl, benzofluorenyl, naphthyl, phenanthryl, anthracenyl, triphenylenyl, pyrenyl, perylenyl, benzofuranyl, benzothiophenyl, dibenzofuranyl, dibenzothiophenyl, pyridyl, pyrimidinyl, triazinyl, pyrazinyl, imidazo[1,5-a]pyridinyl, quinolinyl, benzoquinolinyl, phenanthrolinyl, acridinyl, benzoacridinyl, dibenzoacridinyl, fluorene, benzofluorene, dibenzofluorene, 9,9'-spirobi[fluorene], 13H-indeno[1,2-1]phenanthrene, naphthalene, anthracene, phenanthrene, triphenylene, pyrene, perylene, triphenylene, rubrene, chrysene, fluoranthene, spiro[benzo[de]anthracene-7,9'-fluorene], acridine, benzoacridine, dibenzoacridine, imidazo[1,5-a]pyridine, benzoquinoline, quinoline, quinazoline, quinoxaline, benzoquinoline, phenanthroline, benzimidazole, aza-triphenylene, carbazole, dibenzofurane, dibenzothiophene, dibenzoselenophene, aza-dibenzofuran, aza-dibenzothiophene, azadibenzoselenophene, di-aza-dibenzothiophene, di-aza-dibenzoselenophene.

According to a preferred embodiment, Ar in formula (I), (II), (III), (IVa), (IVb) is selected from the substituted or unsubstituted group D1 to D10:

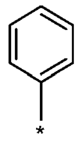

D1,

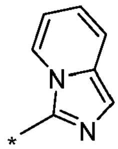

D2,

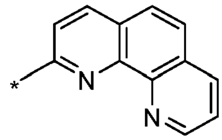

D3,

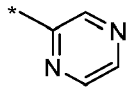

D4,

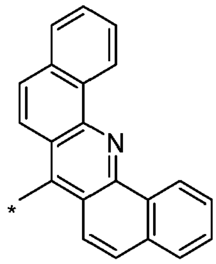

D5,

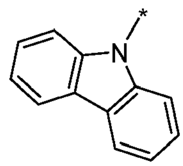

D6,

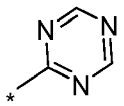

D7,

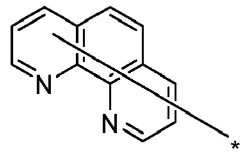

D8,

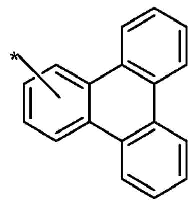

D9,

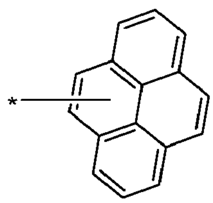

D10

wherein the asterisk "*" denotes the binding position,

wherein Ar can be substituted or unsubstituted, whereby if present the one or more substituents on Ar are independently selected from the group consisting of D, a substituted or unsubstituted $C_1$ to $C_{16}$ alkyl, a substituted or unsubstituted $C_6$ to $C_{30}$ aryl or a substituted or unsubstituted $C_2$ to $C_{30}$ heteroaryl, a substituted or unsubstituted $C_1$ to $C_{16}$ alkoxy, a substituted or unsubstituted $C_3$ to $C_{16}$ branched alkyl, a substituted or unsubstituted $C_3$ to $C_{16}$ cyclic alkyl, a substituted or unsubstituted $C_3$ to $C_{16}$ branched alkoxy, a substituted or unsubstituted $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy, - $PX^a(R^a)_2$, F or CN,

preferably the one or more substituents are independently selected from the group consisting of D, $C_6$ to $C_{18}$ aryl, $C_3$ to $C_{20}$ heteroaryl, $C_1$ to $C_{16}$ alkyl, $C_1$ to $C_{16}$ alkoxy, $C_3$ to $C_{16}$ branched alkyl, $C_3$ to $C_{16}$ cyclic alkyl, $C_3$ to $C_{16}$ branched alkoxy, $C_3$ to $C_{16}$ cyclic alkoxy, partially or perfluorinated $C_1$ to $C_{16}$ alkyl, partially or perfluorinated $C_1$ to

$C_{16}$ alkoxy, partially or perdeuterated $C_1$ to C16 alkyl, partially or perdeuterated $C_1$ to $C_{16}$ alkoxy, $-PX^a(R^a)_2$, F or CN;
wherein $X^a$ may be selected from S or O; and
wherein $R^a$ is independently selected from the group consisting of $C_6$ to $C_{12}$ aryl, $C_3$ to $C_{12}$ heteroaryl, $C_1$ to $C_{16}$ alkyl, $C_1$ to $C_{16}$ alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy.

According to a preferred embodiment, Ar in formula (I), (II), (III), (IVa), (IVb), if present, is selected from the substituted or unsubstituted group E1 to E9

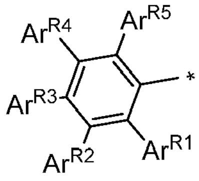
E1,

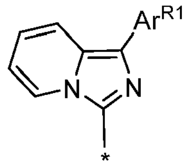
E2,

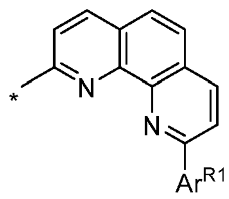
E3,

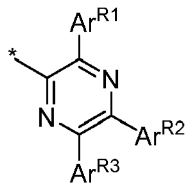
E4,

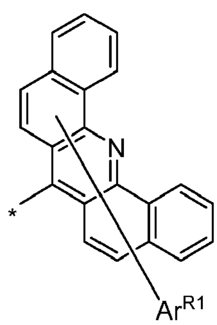
E5,

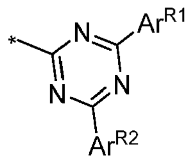
E6,

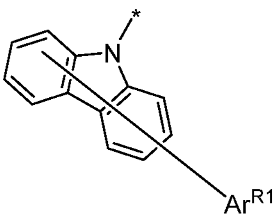
E7,

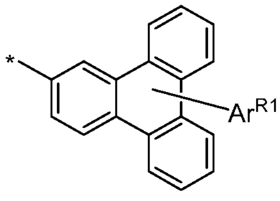
E8,

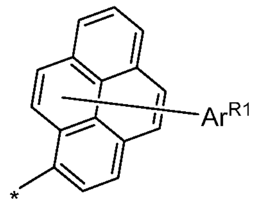
E9

wherein the asterisk "*" denotes the binding position to L,

wherein $Ar^{R1}$, $Ar^{R2}$, $Ar^{R3}$, $Ar^{R4}$, and $Ar^{R5}$, if present, are independently selected from the group
H, D, a substituted or unsubstituted $C_1$ to $C_{16}$ alkyl, a substituted or unsubstituted $C_6$ to $C_{30}$ aryl or a substituted or unsubstituted $C_2$ to $C_{30}$ heteroaryl, a substituted or unsubstituted $C_1$ to $C_{16}$ alkoxy, a substituted or unsubstituted $C_3$ to $C_{16}$ branched alkyl, a substituted or unsubstituted $C_3$ to $C_{16}$ cyclic alkyl, a substituted or unsubstituted $C_3$ to $C_{16}$ branched alkoxy, a substituted or unsubstituted $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy, $-PX^a(R^a)_2$, F or CN;
preferably the one or more substituents are independently selected from the group consisting of D, $C_6$ to $C_{18}$ aryl, $C_3$ to $C_{20}$ heteroaryl, $C_1$ to $C_{16}$ alkyl, $C_1$ to $C_{16}$ alkoxy, $C_3$ to $C_{16}$ branched alkyl, $C_3$ to $C_{16}$ cyclic alkyl, $C_3$ to $C_{16}$ branched alkoxy, $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to C16 alkyl, partially or perdeuterated $C_1$ to $C_{16}$ alkoxy, $-PX^a(R^a)_2$, F or CN;
wherein $X^a$ may be selected from S or O; and
wherein $R^a$ are independently selected from the group consisting of $C_6$ to $C_{12}$ aryl, $C_3$ to $C_{12}$ heteroaryl, $C_1$ to $C_{16}$

alkyl, $C_1$ to $C_{16}$ alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy.

According to an embodiment, the one or more substituents on Ar in formula (I), (II), (III), (IVa), (IVb), if present, are independently selected from the group consisting of D, substituted or unsubstituted $C_2$ to $C_{16}$ alkenyl, a substituted or unsubstituted $C_6$ to $C_{30}$ aryl or a substituted or unsubstituted $C_2$ to $C_{30}$ heteroaryl;
preferably the one or more substituents are independently selected from the group consisting of D, $C_6$ to $C_{18}$ aryl, $C_3$ to $C_{20}$ heteroaryl.

According to an embodiment, the one or more substituents on Ar in formula (I), (II), (III), (IVa), (IVb), if present, are independently selected from the group consisting of D, substituted or unsubstituted $C_2$ alkenyl, a substituted or unsubstituted $C_6$ to $C_{12}$ aryl or a substituted or unsubstituted $C_3$ to $C_{12}$ heteroaryl, preferably the one or more substituents are independently selected from the group consisting of D, $C_6$ to $C_{12}$ aryl, $C_3$ to $C_{12}$ heteroaryl.

According to a preferred embodiment, Ar in formula (I), (II), (III), (IVa), (IVb) is selected from the group F1 to F9:

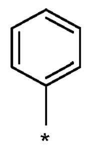
F1,

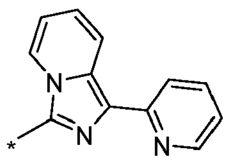
F2,

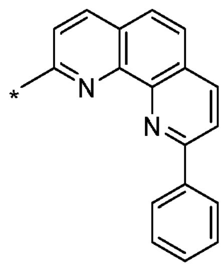
F3,

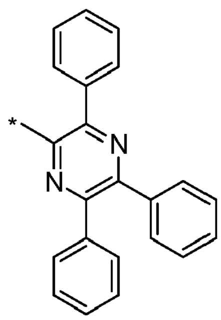
F4,

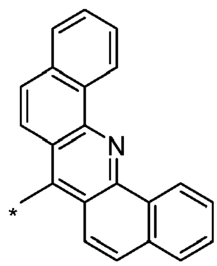
F5,

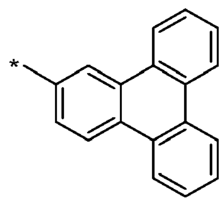
F6,

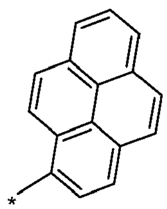
F7,

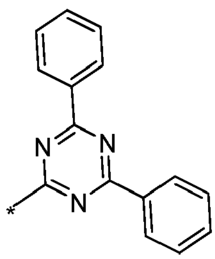
F8,

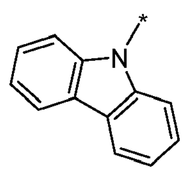
F9

wherein the asterisk "*" denotes the binding position.

According to an embodiment, the compound of formula (I) is selected from A1 to A23:

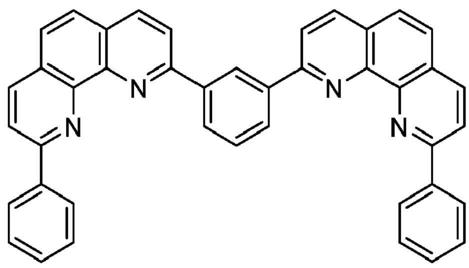

A1,

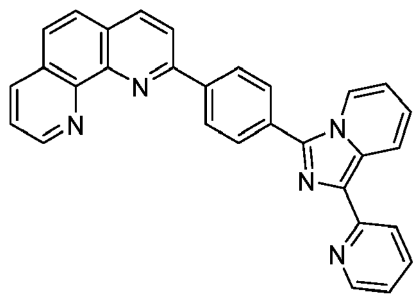

A2,

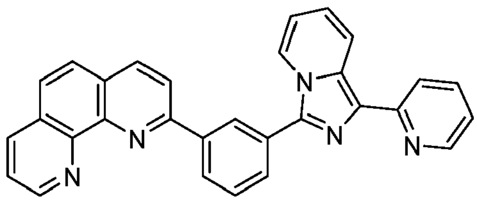

A3 ,

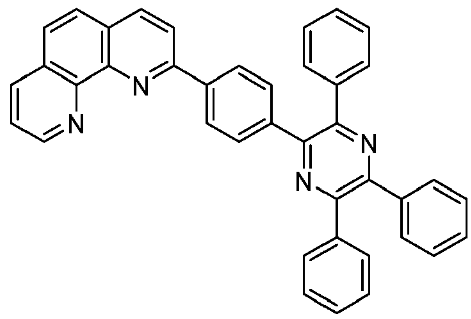

A4,

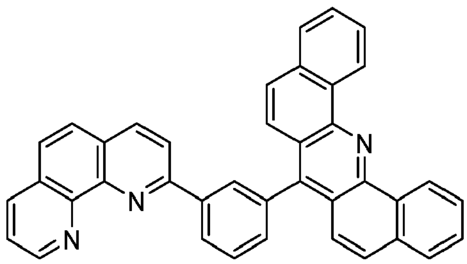

A5,

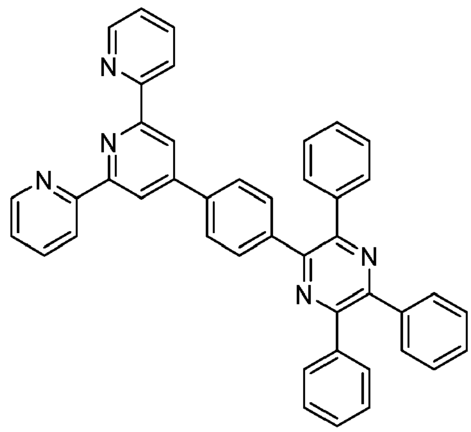

A6 ,

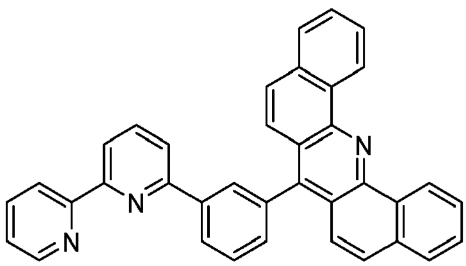

A7,

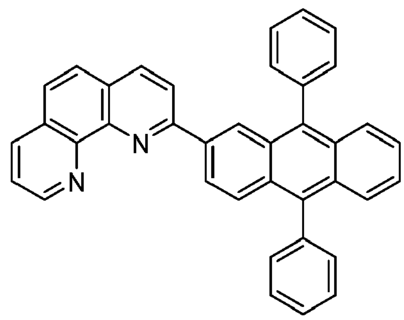

A8,

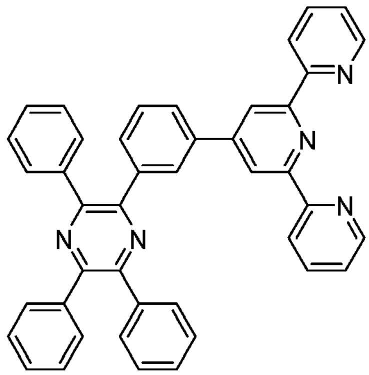

A9,

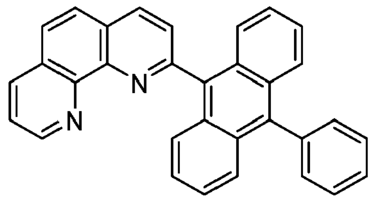

A10,

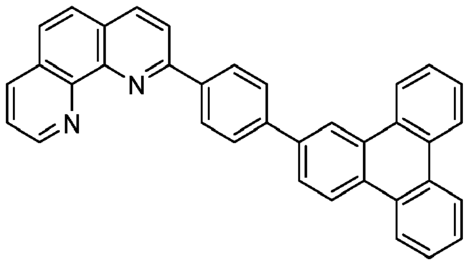

A11,

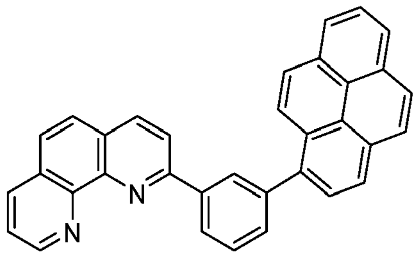

A12,

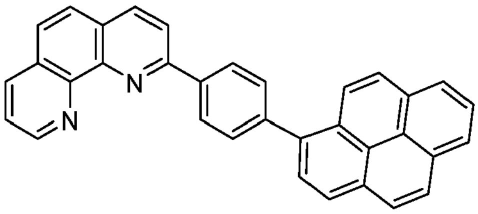

A13,

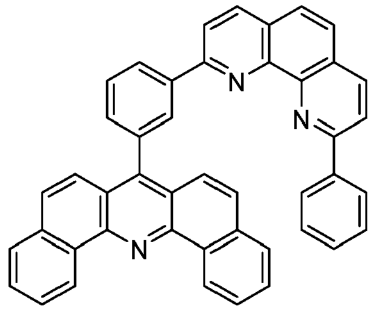

A14,

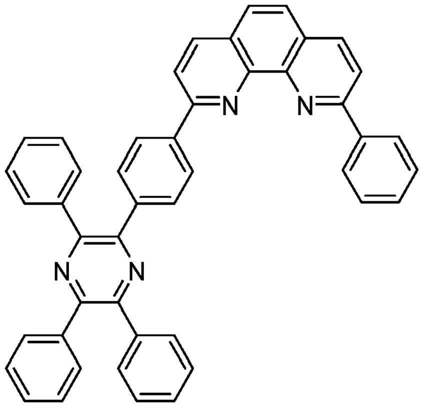

A15,

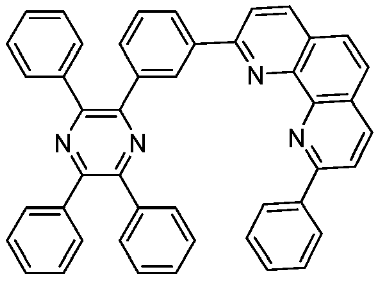

A16,

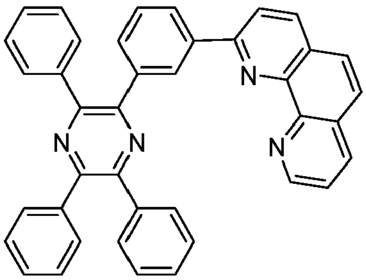

A17,

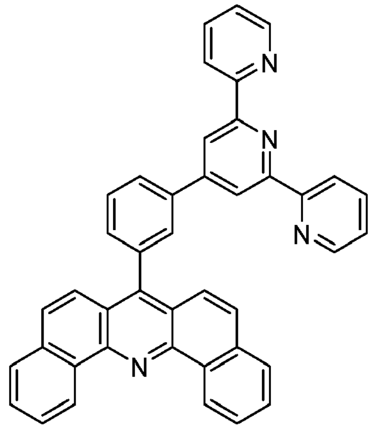

A18,

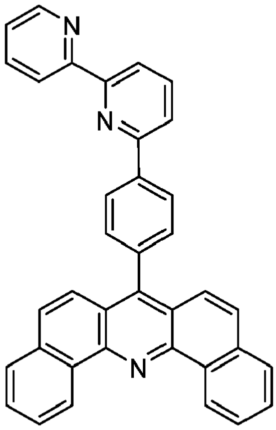

A19,

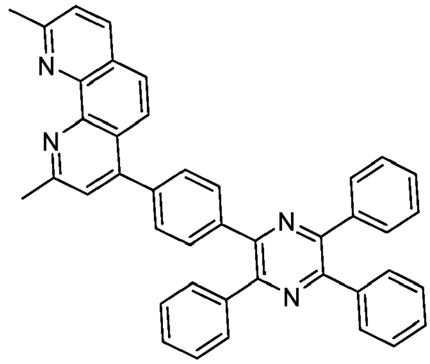

A20,

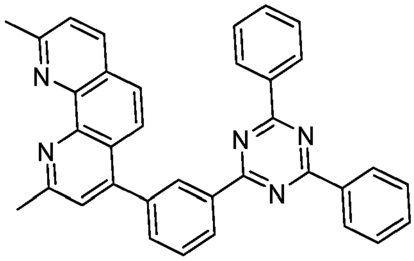

A21,

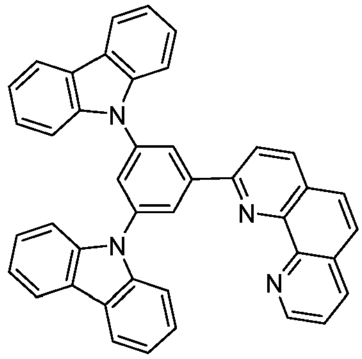

A22,

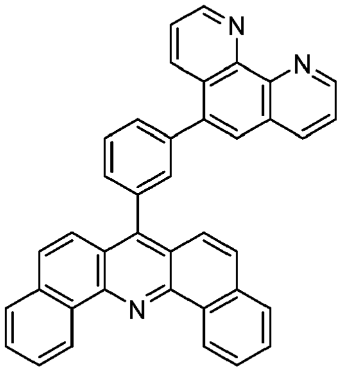

A23.

According to a most preferred embodiment, the compound of formula (I) is selected from A1 to A8.

## n-type charge generation layer

According to an embodiment, the metal dopant is selected from a metal with an electronegativity of ≤ 1.4 eV by Pauling scale or a metal alloy comprising a metal with an electronegativity of ≤ 1.4 eV by Pauling scale.
According to an embodiment, the metal dopant is selected from a metal with an electronegativity of ≤ 1.35 eV by Pauling scale or a metal alloy comprising a metal with an electronegativity of ≤ 1.35 eV by Pauling scale.
According to an embodiment, the metal dopant is a metal selected from the group consisting of an alkali metal, alkaline earth metal, and a rare earth metal or a metal alloy comprising an alkali metal, alkaline earth metal, and a rare earth metal.
According to an embodiment, the metal dopant is a metal selected from the group consisting of Li, Na, K, Rb, Cs, Mg, Ca, Sr, Ba, Sm, Eu and Yb or a metal alloy comprising a metal selected from the group consisting of Li, Na, K, Rb, Cs, Mg, Ca, Sr, Ba, Sm, Eu and Yb.
According to an embodiment, the metal dopant is a metal selected from the group consisting of Li, Na, K, Cs, Mg, Ca, Ba, Sm, Eu and Yb or a metal alloy comprising a metal selected from the group consisting of Li, Na, K, Cs, Mg, Ca, Ba, Sm, Eu and Yb.
According to an embodiment, the metal dopant is a metal selected from the group consisting of Li, Mg and Yb or a metal alloy comprising a metal selected from the group consisting of Li, Mg and Yb.
According to an embodiment, the metal dopant is a metal selected from the group consisting of Li and Yb or a metal alloy comprising a metal selected from the group consisting of Li, and Yb.
According to an embodiment, the metal dopant is Yb or a metal alloy comprising a metal selected from the group consisting of Li and Yb.
According to a preferred embodiment, the metal dopant is selected from Li, Mg or Yb.
According to a more preferred embodiment, the metal dopant is selected from Li or Yb.
According to a most preferred embodiment, the metal dopant is Yb.
According to an embodiment, the metal dopant is present in the n-type charge generation layer in an amount of ≤99.9 wt.-% based on the total weight of the hole injection layer, preferably ≤99 wt.-%, more preferably ≤95 wt.-%, more preferably ≤90 wt.-%, more preferably ≤80 wt.-%, more preferably ≤70 wt.-%, more preferably ≤60 wt.-%, more preferably ≤50 wt.-%, more preferably ≤40 wt.-%, more preferably ≤30 wt.-%, more preferably ≤20 wt.-%, more preferably ≤ 10 wt.-%, more preferably ≤ 5 wt.-%, more preferably ≤ 3.0 wt.-%, more preferably ≤ 2.75 wt.-%, more preferably ≤ 2.5 wt.-%, more preferably ≤ 2.25 wt.-%, and most preferably ≤ 2.0 wt.-%.
According to an embodiment, the organic matrix compound is present in the n-type charge generation layer in an amount of ≥0.1 wt.-% based on the total weight of the hole injection layer, preferably ≥1 wt.-%, more preferably ≥5 wt.-%, more preferably ≥10 wt.-%, more preferably ≥20 wt.-%, more preferably ≥30 wt.-%, more preferably ≥40 wt.-%, more preferably ≥50 wt.-%, more preferably ≥60 wt.-%, more preferably ≥70 wt.-%, more preferably ≥80 wt.-%, more preferably ≥90 wt.-%, more preferably ≥95 wt.-%, more preferably ≥97.0 wt.-%, more preferably ≥97.25 wt.-%, more preferably ≥97.5 wt.-%, more preferably ≥97.75 wt.-% and most preferably ≥98.0 wt.-%.
According to one embodiment, the n-type charge generation layer has a thickness of ≤20 nm; ≤15 nm, ≤10 nm.
According to one embodiment, the n-type charge generation layer has a thickness in the range of ≥1 nm to ≤20 nm, ≥2 nm to ≤15 nm, ≥3 nm to ≤15 nm, ≥5 nm to ≤15 nm

**p-type charge generation layer**

According to an embodiment, the p-type charge generation layer is in direct contact to the intermediate layer.
According to an embodiment, the p-dopant is a p-dopant comprising at least one carbon atom.
According to an embodiment, the p-dopant is an organic p-dopant.
According to an embodiment the p-dopant has LUMO energy level of ≤-4.40 eV; preferably ≤-4.50 eV; more preferably ≤-4.60 eV; more preferably ≤-4.70 eV, and most preferably ≤-4.80 eV.
According to an embodiment the p-dopant comprise at least one carbon atom and has LUMO energy level of ≤-4.40 eV; preferably ≤-4.50 eV; more preferably ≤-4.60 eV; more preferably ≤-4.70 eV, and most preferably ≤-4.80 eV.
According to an embodiment the organic p-dopant has LUMO energy level of ≤-4.40 eV; preferably ≤-4.50 eV; more preferably ≤-4.60 eV; more preferably ≤-4.70 eV, and most preferably ≤-4.80 eV.
According to an embodiment, the p-type charge generation layer comprises a p-dopant and a hole transport matrix compound.
According to an embodiment of the present invention, the compound of p-dopant is present in the p-type charge generation layer in an amount of ≤99.9 wt% based on the total weight of the p-type charge generation layer, preferably ≤99 wt%, more preferably ≤95 wt%, more preferably ≤90 wt%, more preferably ≤80 wt%, more preferably ≤70 wt%, more preferably ≤60 wt%, more preferably ≤50 wt%, more preferably ≤40 wt%, more preferably ≤30 wt%, more preferably ≤20 wt%, more preferably ≤ 10 wt.-%, more preferably ≤ 5 wt%.
According to an embodiment of the present invention, the organic hole transport matrix compound is present in the p-type charge generation layer in an amount of≥0.1 wt% based on the total weight of the p-type charge generation layer, preferably ≥1 wt%, more preferably ≥5 wt%, more preferably ≥10 wt%, more preferably ≥20 wt%, more preferably ≥30 wt%, more preferably ≥40 wt%, more preferably ≥50 wt%, more preferably ≥60 wt%, more preferably ≥70 wt%, more preferably ≥80 wt%, more preferably ≥90 wt%, more preferably ≥95 wt%.
According to an embodiment, the p-type charge generation layer has a thickness of ≤20 nm; ≤ 15 nm, ≤10 nm.
According to an embodiment, the p-type charge generation layer has a thickness in the range of ≥1 nm to ≤20 nm, ≥2 nm to ≤15 nm, ≥3 nm to ≤15 nm, ≥5 nm to ≤15 nm.
According to an embodiment, the p-type charge generation layer comprises a hole transport matrix compound and a radialene of formula (V),

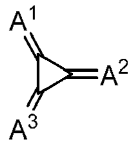
(V)

,

wherein in formula (V)

- $A^1$ is independently selected from a group of formula (Va)

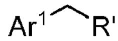
(Va)

  wherein $Ar^1$ is independently selected from substituted or unsubstituted aryl and substituted or unsubstituted heteroaryl
  wherein for the case that $Ar^1$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and;
  wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

- $A^2$ is independently selected from a group of formula (Vb)

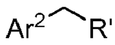

(Vb),

wherein $Ar^2$ is independently selected from substituted or unsubstituted aryl and substituted or unsubstituted heteroaryl

wherein for the case that $Ar^2$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and;

wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

- $A^3$ is independently selected from a group of formula (Vc)

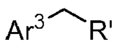

(Vc),

wherein $Ar^3$ is independently selected from substituted or unsubstituted aryl and substituted or unsubstituted heteroaryl

wherein for the case that $Ar^3$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and;

wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

- and wherein in $A^1$, $A^2$, $A^3$ each R' is independently selected from substituted or unsubstituted $C_6$ to $C_{18}$ aryl, $C_3$ to $C_{18}$ heteroaryl, electron-withdrawing group, substituted or unsubstituted $C_1$ to $C_8$ alkyl,partially fluorinated $C_1$ to $C_8$ alkyl, perfluorinated $C_1$ to $C_8$ alkyl, halogen, F and CN;

According to an embodiment, the radialene of formula (V) has a LUMO when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase of ≤ -4.70 eV, preferably ≤ -4.80 eV, more preferably ≤-4.90 eV, still more preferably ≤-5.00 eV, still more preferably ≤ -5.10 eV, still more preferably ≤ -5.15 eV, and most preferably ≤ -5.20 eV.

According to an embodiment, the radialene of formula (V) has a LUMO when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase in the range of ≥-7.00 eV to ≤ -4.70 eV, preferably ≥-6.50 eV to ≤ -4.80 eV, more preferably ≥-6.00 eV to ≤-4.85 eV, still more preferably ≥-5.80 eV to ≤-4.90 eV, still more preferably ≥-5.60 eV to ≤ -5.00 eV, still more preferably ≥-5.50 eV to ≤ -5.10 eV, and still more preferably ≥-5.45 eV to ≤ -5.20 eV.

According to an embodiment, the radialene of formula (V) comprises at least one $CF_3$ group.

According to an embodiment, the radialene of formula (V) comprises one to three $CF_3$ group.

According to an embodiment, the radialene of formula (V) comprises less than nine cyano moieties.

According to an embodiment, the radialene of formula (V) comprises less than eight cyano moieties.

According to an embodiment, the radialene of formula (V) comprises at least one cyano moiety.

According to an embodiment, the radialene of formula (V) comprises at least two cyano moieties.

According to an embodiment, the radialene of formula (V) comprises at least three cyano moieties.

According to an embodiment, the radialene of formula (V) comprises at least four cyano moieties.

According to an embodiment, the radialene of formula (V) comprises from 3 to 8 cyano moieties.

According to an embodiment, the radialene of formula (V) comprises from 3 to 7 cyano moieties.

According to an embodiment, the radialene of formula (V) comprises from 4 to 7 cyano moieties.

According to an embodiment, formula (V) comprises at least 10 fluorine atoms, at least 12 fluorine atoms, at least 13 fluorine atoms, 14 at least fluorine atoms, at least 15 fluorine atoms, at least 16 fluorine atoms, at least 17 fluorine atoms, or at least 18 fluorine atoms.

According to an embodiment, formula (V) comprises 10 to 20 fluorine atoms, or 10 to 18 fluorine atoms or 12 to 18 fluorine atoms.

According to an embodiment, formula (V) comprises 4 to 7 cyano moieties and 12 to 18 fluorine atoms.

According to an embodiment, in formula (V), at least two of $A^1$, $A^2$, and $A^3$ are selected the same.

According to an embodiment, in formula (V), $A^2$ and $A^3$ are identical.

According to an embodiment, in formula (V), $A^1$, $A^2$ and $A^3$ are identical.

According to an embodiment, in formula (V) $A^1$ is different from $A^2$ and/or $A^3$.

According to an embodiment, in formula (V) $A^1$ is different from $A^2$ and/or $A^3$, and $A^2$ and $A^3$ are selected the same.

According an embodiment, in formula (V) $Ar^1$ is selected from is selected from substituted or unsubstituted $C_6$ to $C_{36}$ aryl, and substituted or unsubstituted $C_3$ to $C_{36}$ heteroaryl.

According to an embodiment, $Ar^1$, $Ar^2$, and $Ar^3$ are independently selected from substituted or unsubstituted $C_6$ to $C_{36}$ aryl, and substituted or unsubstituted $C_3$ to $C_{36}$ heteroaryl.

According an embodiment, in formula (II) $Ar^1$ is selected from is selected from substituted or unsubstituted $C_6$ to $C_{24}$ aryl, and substituted or unsubstituted $C_3$ to $C_{24}$ heteroaryl.

According to an embodiment, $Ar^1$, $Ar^2$, and $Ar^3$ are independently selected from substituted or unsubstituted $C_6$ to $C_{24}$ aryl, and substituted or unsubstituted $C_3$ to $C_{24}$ heteroaryl.

According an embodiment, in formula (II) $Ar^1$ is selected from is selected from substituted or unsubstituted $C_6$ to $C_{18}$ aryl, and substituted or unsubstituted $C_3$ to $C_{18}$ heteroaryl.

According to an embodiment, $Ar^1$, $Ar^2$, and $Ar^3$ are independently selected from substituted or unsubstituted $C_6$ to $C_{189}$ aryl, and substituted or unsubstituted $C_3$ to $C_{18}$ heteroaryl.

According to an embodiment, in formula (V) $Ar^1$ is independently selected from substituted or unsubstituted $C_6$ to $C_{12}$ aryl and substituted or unsubstituted $C_3$ to $C_{12}$ heteroaryl.

According to an embodiment, in formula (V) $Ar^1$, $Ar^2$, and $Ar^3$ are independently selected from substituted or unsubstituted $C_6$ to $C_{12}$ aryl and substituted or unsubstituted $C_3$ to $C_{12}$ heteroaryl.

According to an embodiment, in formula (V) $Ar^1$ is independently selected from substituted or unsubstituted $C_6$ aryl and substituted or unsubstituted $C_3$ to $C_5$ heteroaryl.

According to an embodiment, in formula (V) $Ar^1$, $Ar^2$, and $Ar^3$ are independently selected from substituted or unsubstituted $C_6$ aryl and substituted or unsubstituted $C_3$ to $C_5$ heteroaryl.

According to an embodiment, in formula (V) the substituents on $Ar^1$ is independently selected from the group consisting of an electron-withdrawing group, halogen, Cl, F, CN, $NO_2$, partially fluorinated alkyl, and perfluorinated alkyl.

According to an embodiment, in formula (V) the substituents on $Ar^1$, $Ar^2$, and $Ar^3$ are independently selected from the group consisting of an electron-withdrawing group, halogen, Cl, F, CN, $NO_2$, partially fluorinated alkyl, and perfluorinated alkyl.

According to an embodiment, in formula (V) the substituents on $Ar^1$ is independently selected from the group consisting of an electron-withdrawing group, halogen, Cl, F, CN, partially fluorinated alkyl, and perfluorinated alkyl.

According to an embodiment, in formula (V) the substituents on $Ar^1$, $Ar^2$, and $Ar^3$ are independently selected from the group consisting of an electron-withdrawing group, halogen, Cl, F, CN, partially fluorinated alkyl, and perfluorinated alkyl.

According to an embodiment, in formula (V) the substituents on $Ar^1$ is independently selected from the group consisting of Cl, F, CN, $NO_2$ and perfluorinated alkyl.

According to an embodiment, in formula (V) the substituents on $Ar^1$, $Ar^2$, and $Ar^3$ are independently selected from the group consisting of Cl, F, CN, $NO_2$ and perfluorinated alkyl.

According to an embodiment, in formula (V) the substituents on $Ar^1$ is independently selected from the group consisting of Cl, F, CN, and perfluorinated alkyl.

According to an embodiment, in formula (V) the substituents on $Ar^1$, $Ar^2$, and $Ar^3$ are independently selected from the group consisting of Cl, F, CN, and perfluorinated alkyl.

According to an embodiment, in formula (V) the substituents on $Ar^1$ is independently selected from the group consisting of F, CN, $NO_2$ and perfluorinated alkyl.

According to an embodiment, in formula (V) the substituents on $Ar^1$, $Ar^2$, and $Ar^3$ are independently selected from the group consisting of F, CN, $NO_2$ and perfluorinated alkyl.

According to an embodiment, in formula (V) the substituents on $Ar^1$ is independently selected from the group consisting of F, CN, and perfluorinated alkyl.

According to an embodiment, in formula (V) the substituents on $Ar^1$, $Ar^2$, and $Ar^3$ are independently selected from the group consisting of F, CN, and perfluorinated alkyl.

According to an embodiment, in formula (V) the substituents on $Ar^1$ is independently selected from the group consisting of F, CN, $NO_2$ and $CF_3$.

According to an embodiment, in formula (V) the substituents on $Ar^1$, $Ar^2$, and $Ar^3$ are independently selected from the group consisting of F, CN, $NO_2$ and $CF_3$.

According to an embodiment, in formula (V) the substituents on $Ar^1$ is independently selected from the group consisting of F, CN, and $CF_3$.

According to an embodiment, in formula (V) the substituents on $Ar^1$, $Ar^2$, and $Ar^3$ are independently selected from the group consisting of F, CN, and $CF_3$.

According to an embodiment, in formula (V) $Ar^1$ is independently each comprise more than one and less than five substituents, preferably more than two and less than four, for example 4.

According to an embodiment, in formula (V) $Ar^1$, $Ar^2$, and $Ar^3$ independently each comprise more than one and less than five substituents, preferably more than two and less than four, for example 4.

According to an embodiment, in formula (V) each R' is independently selected from electron-withdrawing group, partially fluorinated $C_1$ to $C_8$ alkyl, perfluorinated $C_1$ to $C_8$ alkyl, halogen, F and CN.

According to an embodiment, in formula (V) each R' is independently selected from partially fluorinated $C_1$ to $C_8$ alkyl, perfluorinated $C_1$ to $C_8$ alkyl, halogen, F and CN.

According to an embodiment, in formula (V) each R'is independently selected from $CF_3$, F and CN.

According to an embodiment, in formula (V) each R' is CN.

According to an embodiment, in formula (V) $Ar^1$, $Ar^2$ and $Ar^3$ are independently selected from a group according to the following formula (VI) and preferably each R' is selected from CN:

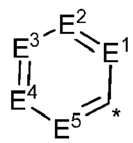

(VI)

wherein

- $E^1$ is selected from $CW^1$ or N;
- $E^2$ is selected from $CW^2$ or N;
- $E^3$ is selected from $CW^3$ or N;
- $E^4$ is selected from $CW^4$ or N;
- $E^5$ is selected from $CW^5$ or N;
- $W^1$, $W^2$, $W^3$, $W^4$ and $W^5$ (if present) are independently selected from electron-withdrawing group, CN, halogen, Cl, F, $NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_6$ alkoxy, $OCF_3$, substituted or unsubstituted $C_6$ to $C_{30}$ aryl, substituted or unsubstituted $C_3$ to $C_{30}$ heteroaryl, D or H, wherein the one or more substituents is independently selected from D, halogen, Cl, F, CN, $NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy, wherein the asterisk "*" denotes the binding position.

According to an embodiment, in formula (VI)
$W^1$, $W^2$, $W^3$, $W^4$ and $W^5$ (if present) are independently selected from electron-withdrawing group, CN, halogen, Cl, F, $NO_2$, partially fluorinated or perfluorinated $C_1$ to $C_8$ alkyl, partially fluorinated or perfluorinated $C_1$ to $C_6$ alkoxy, D or H, and wherein preferably each R' is selected from CN.

According to an embodiment, in formula (V), $Ar^1$, $Ar^2$ and/or $Ar^3$ are independently selected from one of the following groups and preferably each R' is selected from CN:

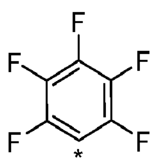
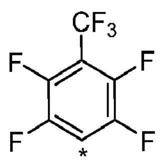
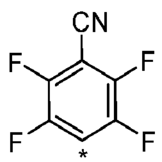
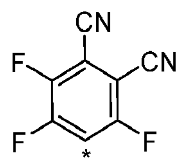
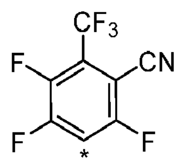

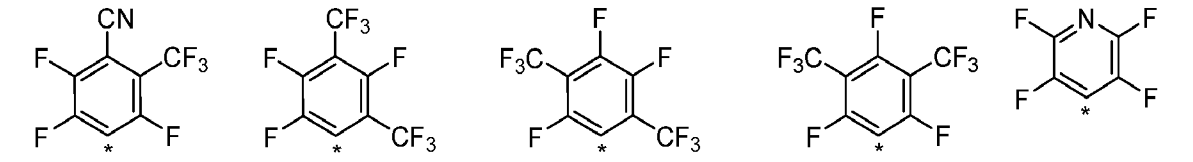

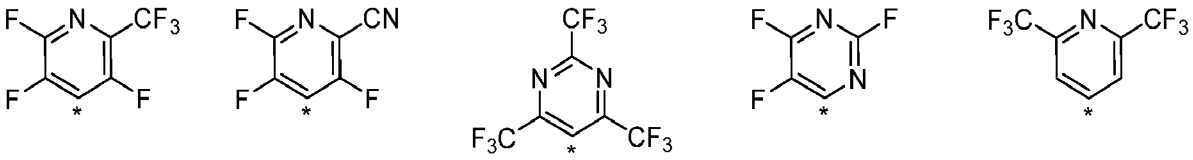

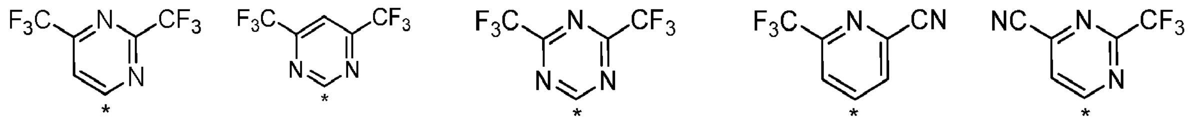

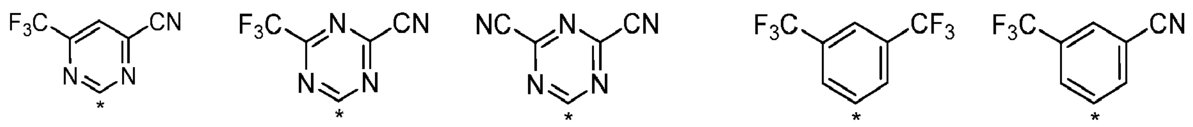

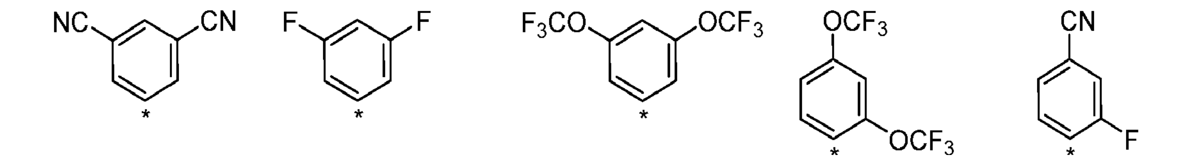

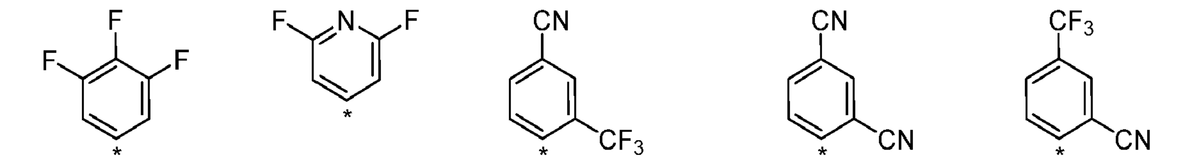

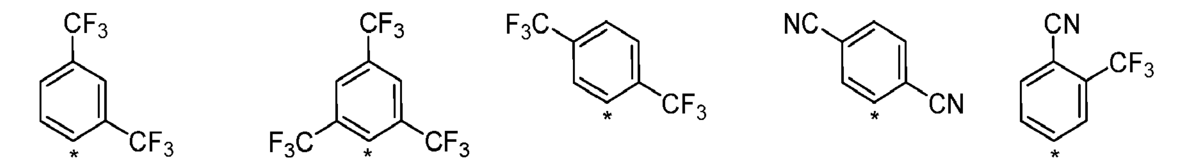

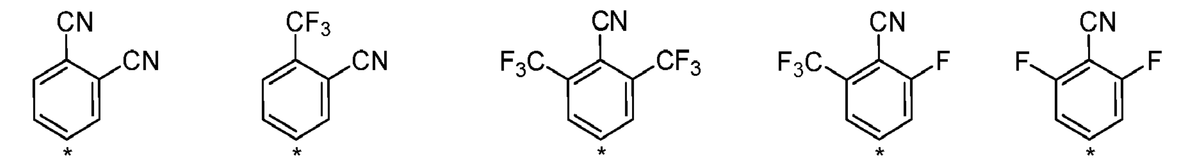

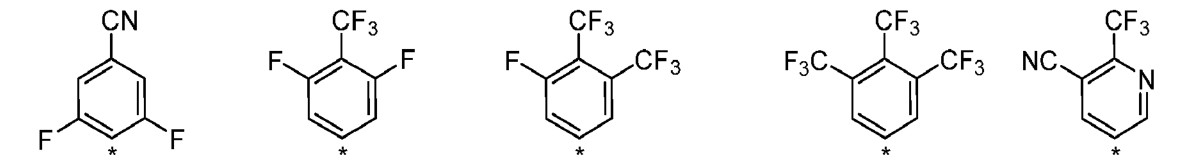

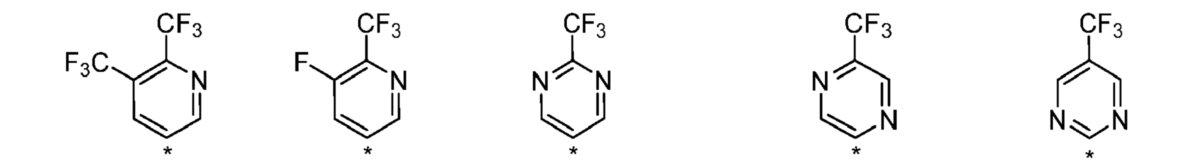

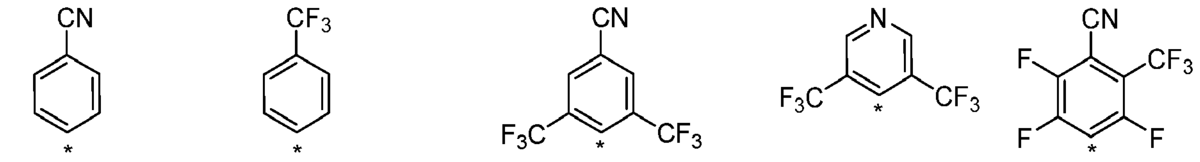

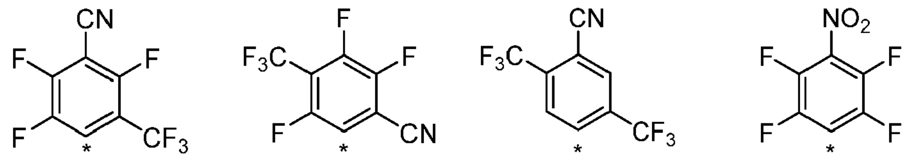

wherein the asterisk "*" denotes the binding position.

According to an embodiment, in formula (V), $Ar^1$ is selected from one of the following groups and preferably each R' is selected from CN:

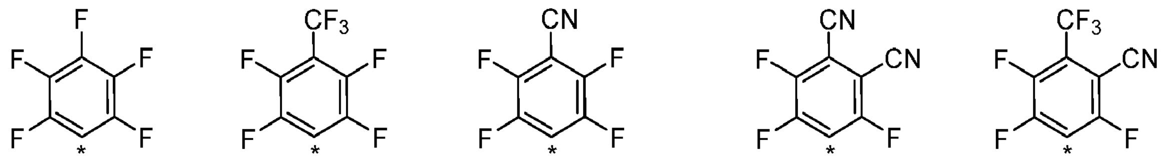

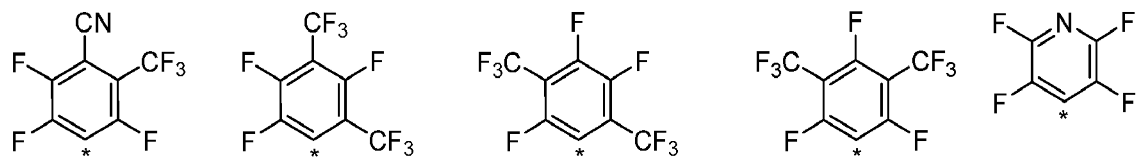

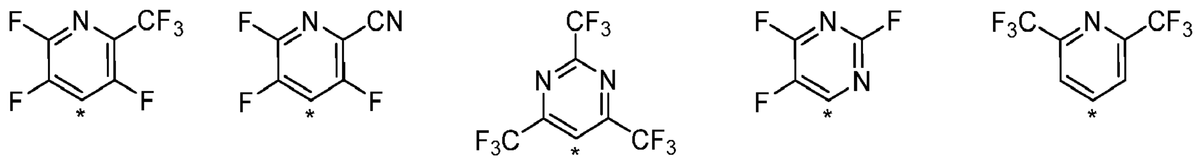

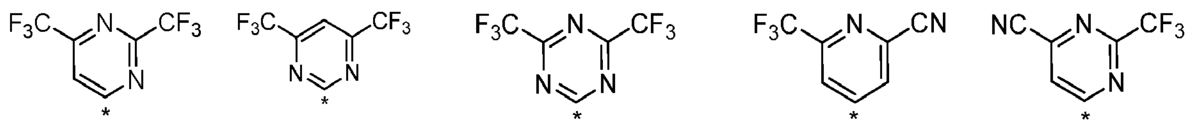

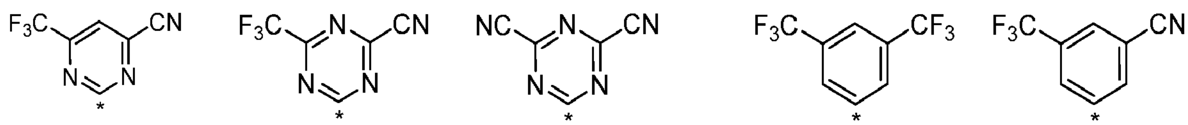

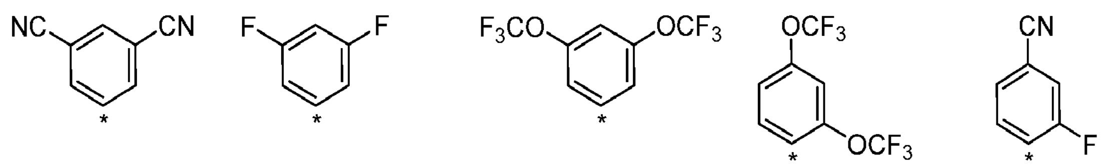

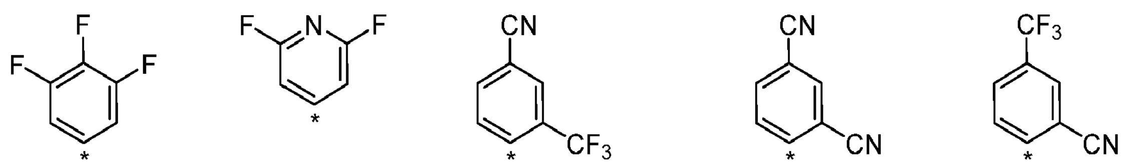

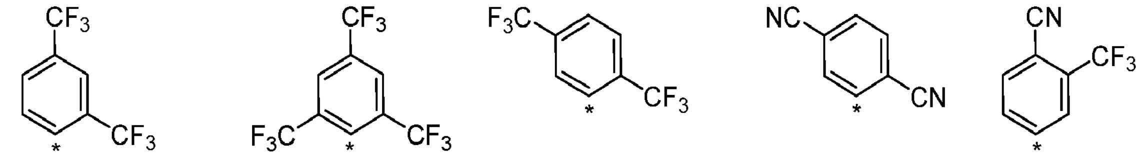

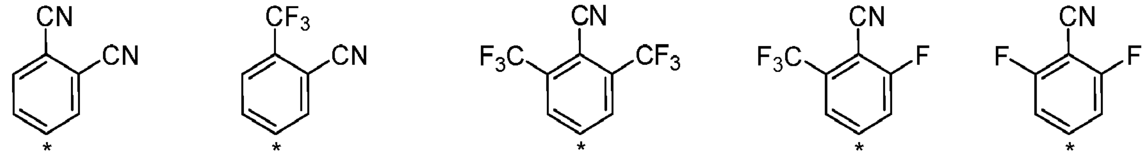

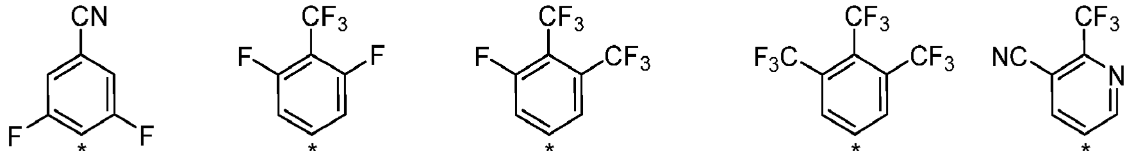

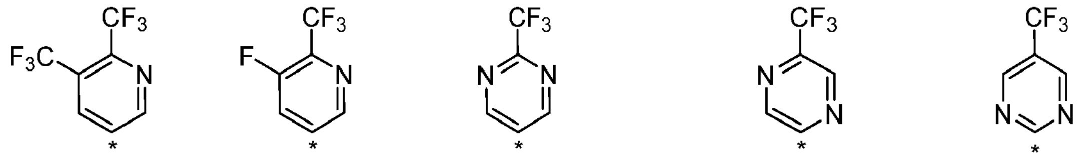

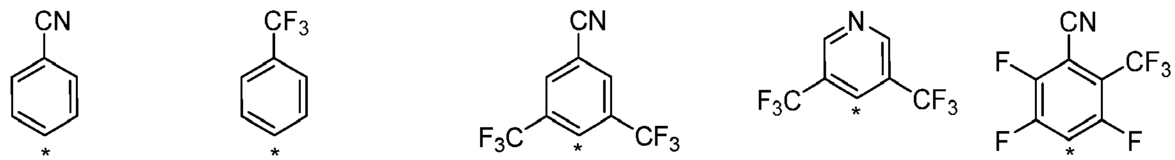

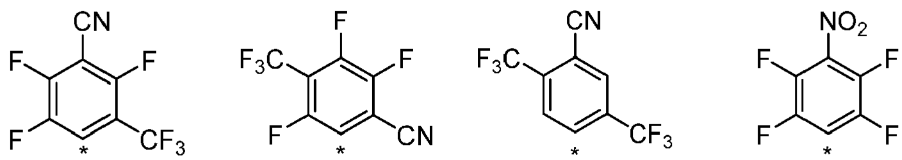

wherein the asterisk "*" denotes the binding position.

According to an embodiment, in formula (V), $Ar^1$, $Ar^2$ and/or $Ar^3$ are independently selected from one of the following groups and preferably each R' is selected from CN:

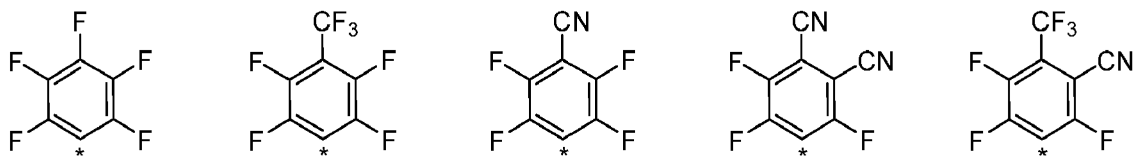

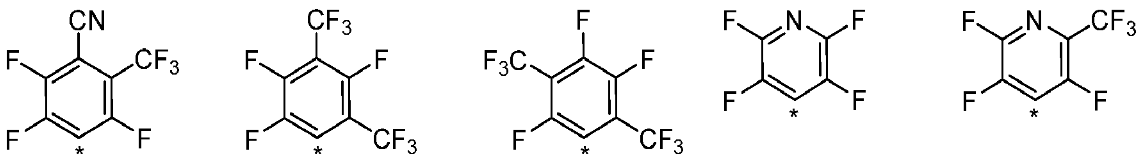

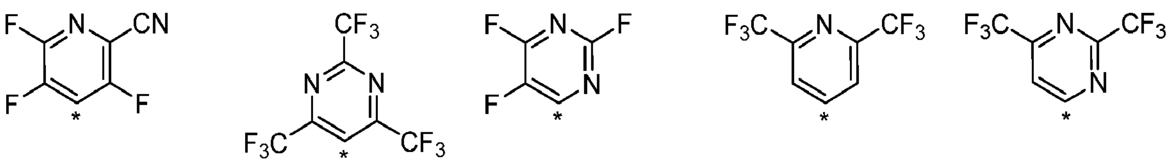

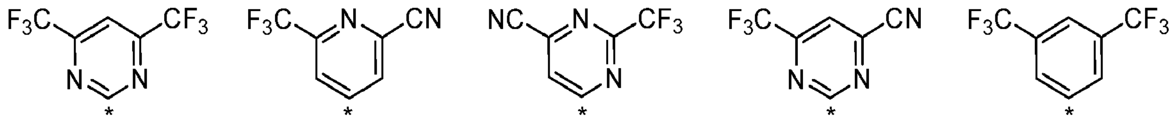

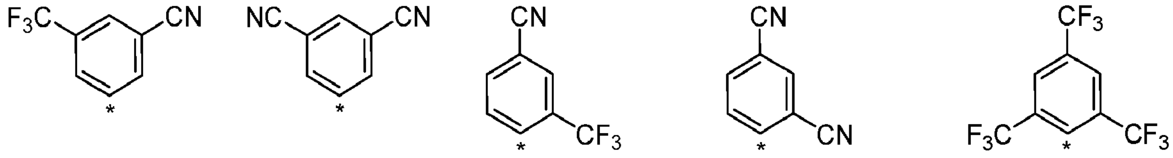

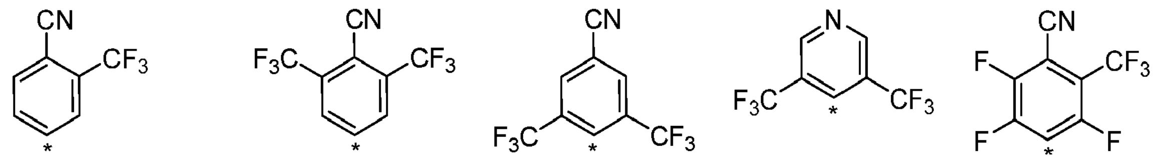

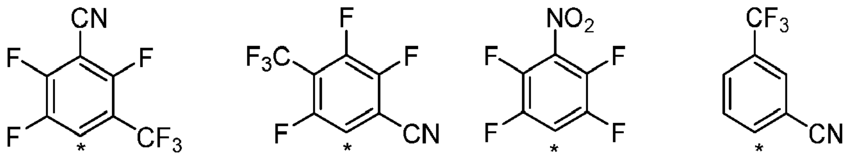

wherein the asterisk "*" denotes the binding position.

According to an embodiment, in formula (V), $Ar^1$ is independently selected from one of the following groups and preferably each R' is selected from CN:

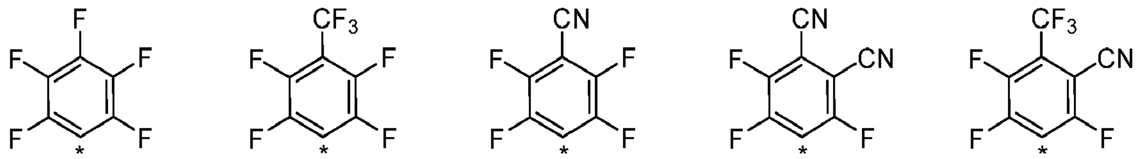

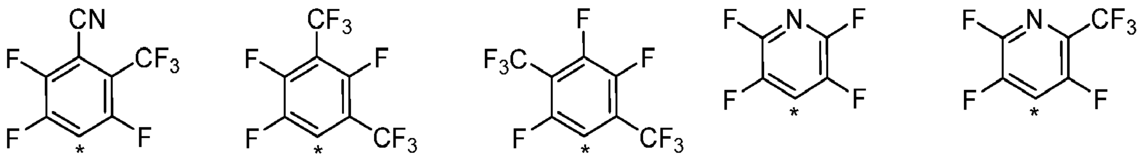

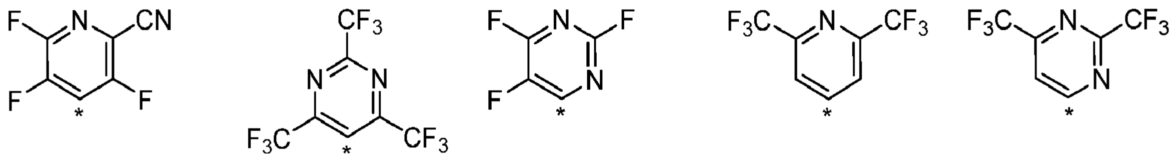

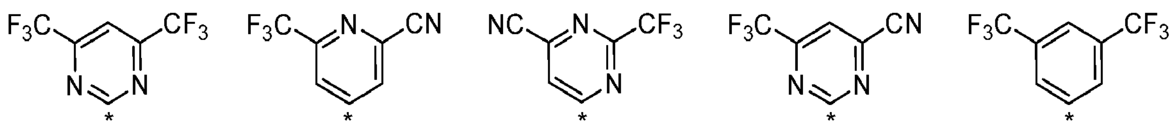

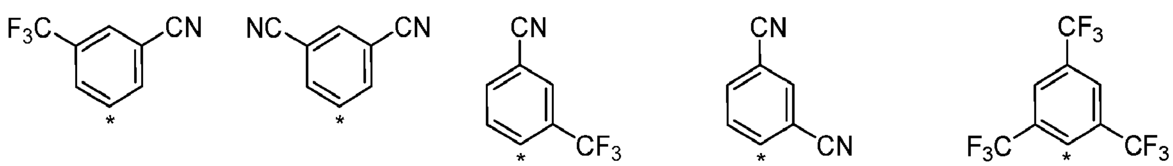

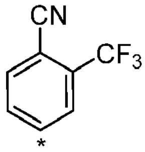 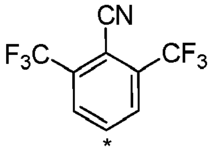 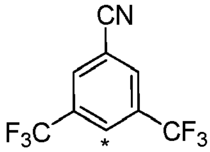 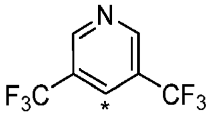 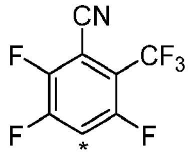

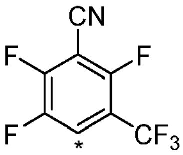 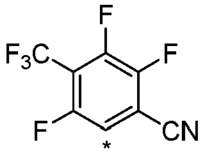 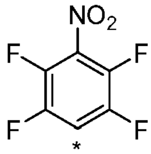 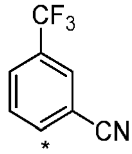

wherein the asterisk "*" denotes the binding position.

According to an embodiment, in formula (V), $Ar^1$, $Ar^2$ and/or $Ar^3$ are independently selected from one of the following groups and preferably each R' is selected from CN:

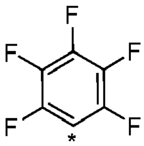 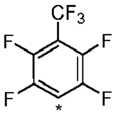 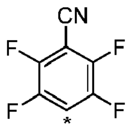 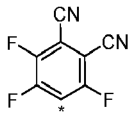 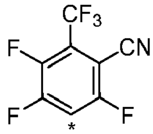

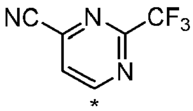 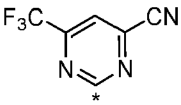 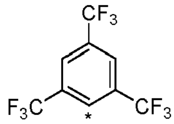 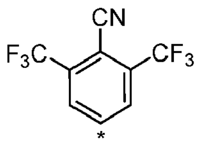 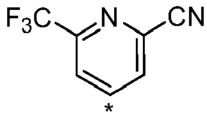

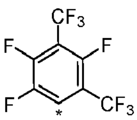 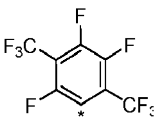 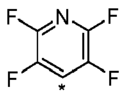 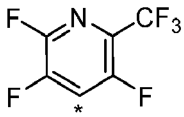 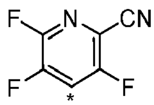

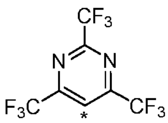 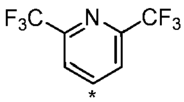 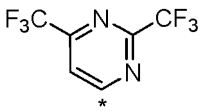 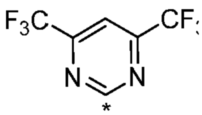 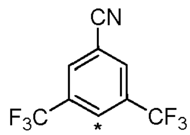

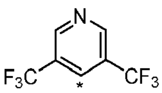 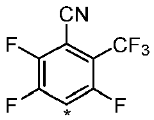 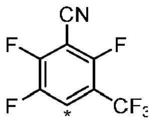 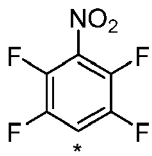 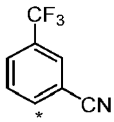

wherein the asterisk "*" denotes the binding position.

According to an embodiment, in formula (V), $Ar^1$ is selected from one of the following groups and preferably each R' is selected from CN:

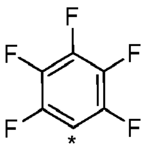 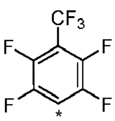 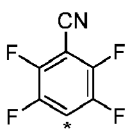 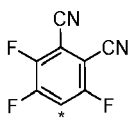 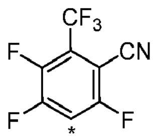

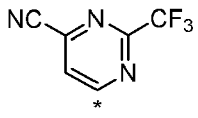 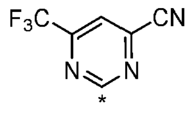 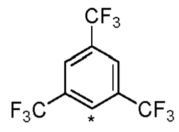 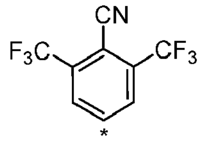 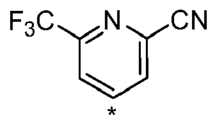

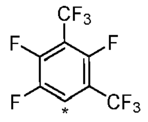 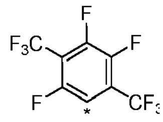 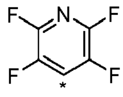 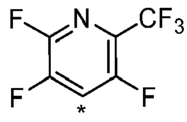 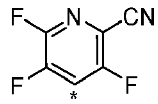

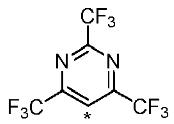 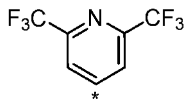 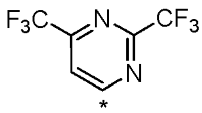 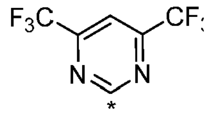 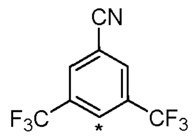

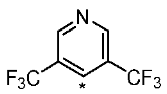 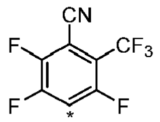 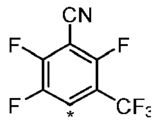 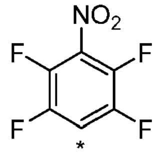 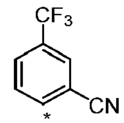

wherein the asterisk "*" denotes the binding position.

According to an embodiment, the radialene of formula (V) is represented by one of the following formulae (VIa) to (VIh):

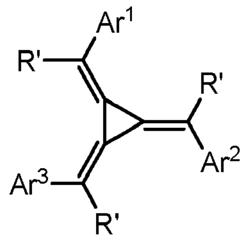 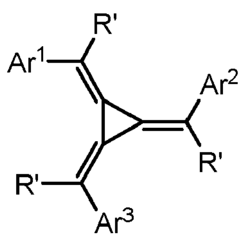

(VIa) (VIe)

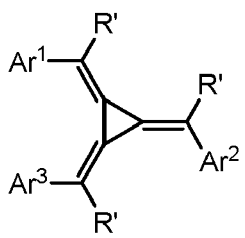 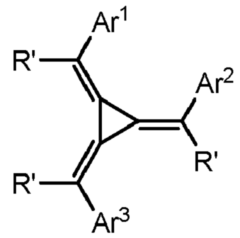

(VIb) (VIf)

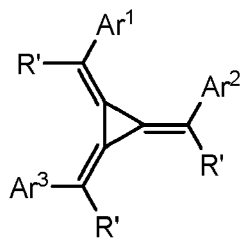 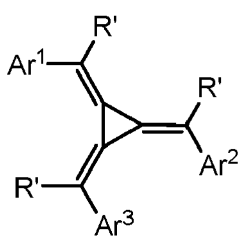

(VIc) (VIg)

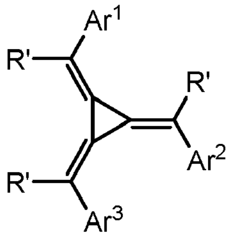
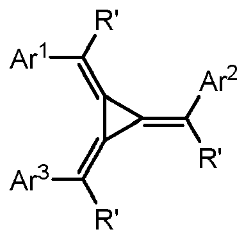

(VId) (VIh)

wherein $Ar^1$, $Ar^2$, $Ar^3$, and R' are independently selected as above.

According to an embodiment, the p-type generation layer comprises as radialene of formula (V) a mixture of at least two compounds selected from formulae (VIa) to (VIh) as defined above.

According to an embodiment, the p-type charge generation layer comprises a hole transport matrix compound selected from an arylamine compound, diarylamine compound, triarylamine compound, a compound of formula (VIIa) or a compound of formula (VIIb):

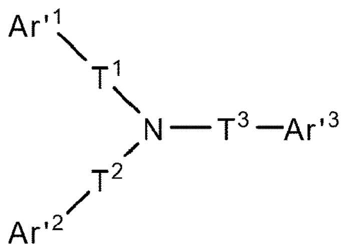
(VIIa),
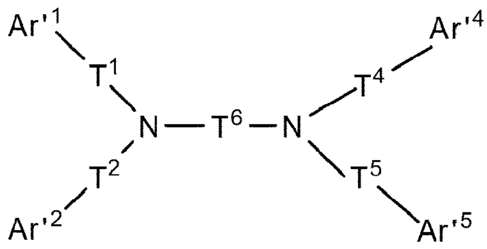
(VIIb),

wherein:

$T^1$, $T^2$, $T^3$, $T^4$ and $T^5$ are independently selected from a single bond, phenylene, biphenylene, terphenylene or naphthenylene, preferably a single bond or phenylene;

$T^6$ is phenylene, biphenylene, terphenylene or naphthenylene;

$Ar'^1$, $Ar'^2$, $Ar'^3$, $Ar'^4$ and $Ar'^5$ are independently selected from substituted or unsubstituted $C_6$ to $C_{20}$ aryl, or substituted or unsubstituted $C_3$ to $C_{20}$ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;

wherein

the substituents of $Ar'^1$, $Ar'^2$, $Ar'^3$, $Ar'^4$ and $Ar'^5$ are selected the same or different from the group comprising H, D, F, $C(=O)R'^2$, CN, $Si(R'^2)_3$, $P(=O)(R'^2)_2$, $OR'^2$, $S(=O)R'^2$, $S(=O)_2R'^2$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted

or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle, wherein $R'^2$ may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl.

According to an embodiment, the hole transport matrix compound has a HOMO level smaller than the HOMO level of N2,N2,N2',N2',N7,N7,N7',N7'-octakis(4-methoxyphenyl)-9,9'-spirobi[fluorene]-2,2',7,7'-tetraamine, preferably smaller than N4,N4,N4',N4'-tetrakis(4-methoxyphenyl)biphenyl-4,4'-diamine, more preferred smaller than N4,N4'-bis(9,9-dimethyl-9H-fluoren-2-yl)-N4,N4'-diphenyl-[1,1'-biphenyl]-4,4'-diamine, when determined by the same method. The HOMO level of N2,N2,N2',N2',N7,N7,N7',N7'-octakis(4-methoxyphenyl)-9,9'-spirobi[fluorene]-2,2',7,7'-tetraamine is -4.27 eV, the HOMO level of N4,N4,N4',N4'-tetrakis(4-methoxyphenyl)biphenyl-4,4'-diamine is -4.34 eV, and the HOMO level of N4,N4'-bis(9,9-dimethyl-9H-fluoren-2-yl)-N4,N4'-diphenyl-[1,1'-biphenyl]-4,4'-diamine is -4.64 eV, when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to an embodiment, the hole transport matrix compound has a HOMO energy level of $\leq$ -4.27 eV, preferably $\leq$-4.34 eV, more preferably $\leq$-4.40 eV, even more preferably $\leq$-4.45 eV, even more preferably $\leq$-4.50 eV, even more preferably $\leq$-4.55 eV, even more preferably $\leq$-4.60 eV, even more preferably $\leq$-4.65 eV when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to an embodiment, the hole transport matrix compound has a HOMO energy level in the range of $\geq$-6.50 eV to $\leq$ -4.27 eV, preferably $\geq$-6.00 eV $\leq$-4.34 eV, more preferably $\geq$-5.50 eV to $\leq$-4.40 eV, even more preferably $\geq$-5.40 eV $\leq$-4.45 eV, even more preferably $\geq$-5.30 eV to $\leq$-4.50 eV, even more preferably $\geq$-5.20 eV to $\leq$-4.55 eV, even more preferably $\geq$-5.10 eV to $\leq$-4.60 eV, even more preferably $\geq$-5.00 eV to $\leq$-4.65 eV when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

The term "having a HOMO level smaller than" in the context of the present invention means that the absolute value of the HOMO level is greater than the absolute value of the HOMO level to which it is compared to. Particularly, the term "having a HOMO level smaller than" in the context of the present invention means that the HOMO level is further away from vacuum level than the value of the HOMO level to which it is compared to.

According to an embodiment, the hole transport matrix compound has have a molecular weight Mw of $\geq$ 400 and $\leq$ 2000 g/mol, preferably a molecular weight Mw of $\geq$ 450 and $\leq$ 1500 g/mol, further preferred a molecular weight Mw of $\geq$ 500 and $\leq$ 1000 g/mol, in addition preferred a molecular weight Mw of $\geq$ 550 and $\leq$ 900 g/mol, also preferred a molecular weight Mw of $\geq$ 600 and $\leq$ 800 g/mol.

The hole transport matrix compound may be free of HTM014, HTM081, HTM163, HTM222, EL-301, HTM226, HTM355, HTM133, HTM334, HTM604 and EL-22T. The abbreviations denote the manufacturers' names, for example, of Merck or Lumtec.

The intermediate layer may be free of HTM014, HTM081, HTM163, HTM222, EL-301, HTM226, HTM355, HTM133, HTM334, HTM604 and EL-22T. The abbreviations denote the manufacturers' names, for example, of Merck or Lumtec.

According to an embodiment, the hole transport matrix compound (s) are selected of at least one compound selected from formula (VIIa) and formula (VIIb).

According to an embodiment, the hole transport is a compound of formula (VIIa).

According to an embodiment, the compound according to formula (VIIa) or (VIIb) comprises at least one naphthyl group, carbazole group, dibenzofuran group, dibenzothiophene group and/or substituted fluorenyl group, wherein the substituents are independently selected from methyl, phenyl or fluorenyl.

According to an embodiment wherein $T^1$, $T^2$, $T^3$, $T^4$ and $T^5$ may be independently selected from a single bond, phenylene, biphenylene or terphenylene. According to an embodiment wherein $T^1$, $T^2$, $T^3$, $T^4$ and $T^5$may be independently selected from phenylene, biphenylene or terphenylene and one of $T^1$, $T^2$, $T^3$, $T^4$ and $T^5$ are a single bond. According to an embodiment wherein $T^1$, $T^2$, $T^3$, $T^4$ and $T^5$may be independently selected from phenylene or biphenylene and one of $T^1$, $T^2$, $T^3$, $T^4$ and $T^5$ are a single bond. According to an embodiment wherein $T^1$, $T^2$, $T^3$, $T^4$ and $T^5$may be independently selected from phenylene or biphenylene and two of $T^1$, $T^2$, $T^3$, $T^4$ and $T^5$ are a single bond.

According to an embodiment wherein $T^1$, $T^2$ and $T^3$ may be independently selected from phenylene and one of $T^1$, $T^2$ and $T^3$ are a single bond. According to an embodiment wherein $T^1$, $T^2$ and $T^3$ may be independently selected from phenylene and two of $T^1$, $T^2$ and $T^3$ are a single bond.

According to an embodiment wherein $T^6$ may be phenylene, biphenylene, terphenylene. According to an embodiment wherein $T^6$ may be phenylene. According to an embodiment wherein $T^6$ may be biphenylene. According to an embodiment wherein $T^6$ may be terphenylene.

According to another aspect of the present invention, in formulae (VIIa) and/or (VIIb) - wherever applicable -) T1, T2, T3, T4 and T5 may be independently selected from a single bond, phenylene, biphenylene or terphenylene.

According to an embodiment in formulae (VIIa) and/or (VIIb) - wherever applicable - $T^1$, $T^2$, $T^3$, $T^4$ and $T^5$ may be independently selected from phenylene, biphenylene or terphenylene and one of $T^1$, $T^2$, $T^3$, $T^4$ and $T^5$ are a single bond.

According to an embodiment in formulae (VIIa) and/or (VIIb) - wherever applicable - $T^1$, $T^2$, $T^3$, $T^4$ and $T^5$may be independently selected from phenylene or biphenylene and one of $T^1$, $T^2$, $T^3$, $T^4$ and $T^5$ are a single bond.

According to an embodiment in formulae (VIIa) and/or (VIIb) - wherever applicable - $T^1$, $T^2$, $T^3$, $T^4$ and $T^5$may be independently selected from phenylene or biphenylene and two of $T^1$, $T^2$, $T^3$, $T^4$ and $T^5$ are a single bond;

According to an embodiment in formulae (VIIa) and/or (VIIb) - wherever applicable - $T^1$, $T^2$ and $T^3$ may be independently selected from phenylene and one of $T^1$, $T^2$ and $T^3$ are a single bond.

According to an embodiment in formulae (VIIa) and/or (VIIb) - wherever applicable - $T^1$, $T^2$ and $T^3$ may be independently selected from phenylene and two of $T^1$, $T^2$ and $T^3$are a single bond.

According to an embodiment in formula (VIIb) $T^6$ may be phenylene, biphenylene, terphenylene.

According to an embodiment in formula (VIIb) $T^6$ is phenylene.

According to an embodiment in formula (VIIb) $T^6$ is biphenylene.

According to an embodiment in formula (VIIb) $T^6$ is terphenylene.

According to an embodiment in formulae (VIIa) and/or (VIIb) - wherever applicable - Ar'[1], Ar'[2], Ar'[3], Ar'[4] and/or Ar'[5] are independently selected from G1 to G16:

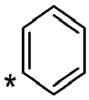 (G1), 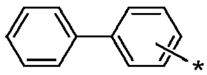 (G2), 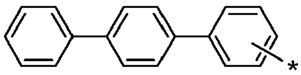 (G3), 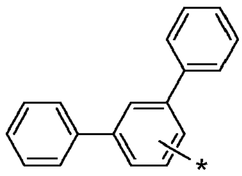 (G4),

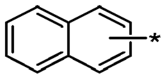 (G5), 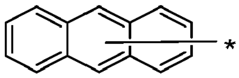 (G6), 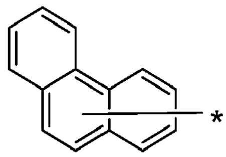 (G7), 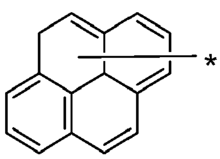 (G8),

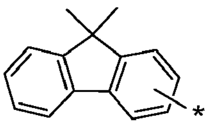 (G9), 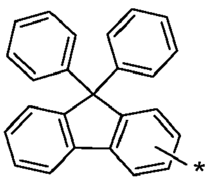 (G10), 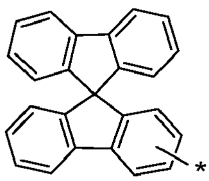 (G11),

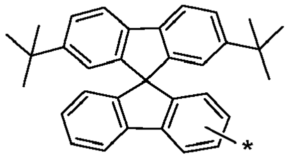 (G12), 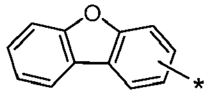 (G13), 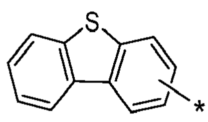 (G14),

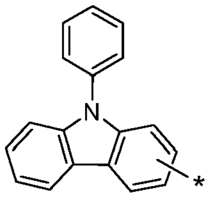 (G15), 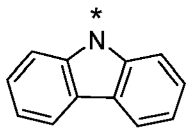 (G16),

wherein the asterix "*" denotes the binding position.

According to an embodiment in formulae (VIIa) and/or (VIIb) - wherever applicable - Ar'[1], Ar'[2], Ar'[3], Ar'[4] and/or Ar'[5] are independently selected from G1 to G15; alternatively selected from G1 to G10 and G13 to G15.

According to an embodiment, in formulae (VIIa) and/or (VIIb) - wherever applicable - Ar'[1], Ar'[2], Ar'[3], Ar'[4] and/or Ar'[5] may be independently selected from the group consisting of G1, G2, G5, G7, G9, G10, G13 to G16.

The rate onset temperature may be in a range particularly suited to mass production, when Ar'[1], Ar'[2], Ar'[3], Ar'[4] and Ar'[5] are selected in this range.

According to an embodiment, the formula (VIIa) and/ or formula (VIIb) - wherever applicable are selected from compound (VIIc)

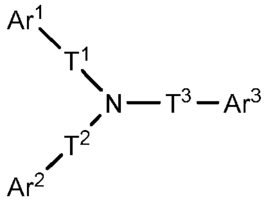

(VIIc);

Whereby

$T^1$, $T^2$, $T^3$ are independently selected from a single bond, phenylene, biphenylene, terphenylene or naphthenylene, preferably a single bond or phenylene;

$Ar^1$, $Ar^2$, $Ar^3$ are independently selected from substituted or unsubstituted $C_6$ to $C_{20}$ aryl, or substituted or unsubstituted $C_3$ to $C_{20}$ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;

wherein

the substituents of $Ar^1$, $Ar^2$, $Ar^3$ are selected the same or different from the group comprising H, D, F, CN, $Si(R^2)_3$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5-to 6-member of an aromatic heterocycle, unsaturated 5- to 7-member ring of a non-heterocycle, and 6-member ring of an aromatic non-heterocycle,

wherein $R^2$ may be selected from H, D, straight-chain alkyl having 1 to 6 carbon atoms, branched alkyl having 1 to

6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl;

According to an embodiment of the electronic device, the hole transport matrix compound (s) and/or formulae (VIIa) and/or (VIIb) - wherever applicable - are selected from H1 to H21:

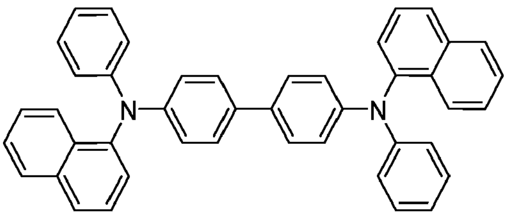

(H1),

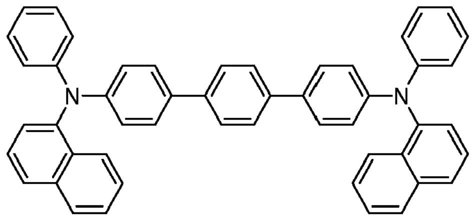

(H2),

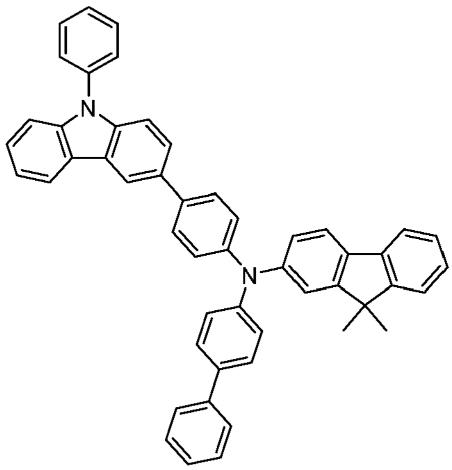

(H3),

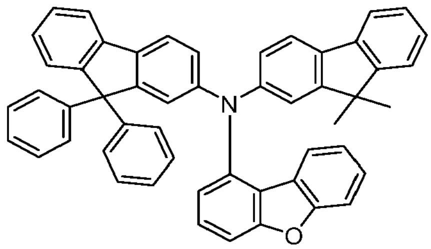

(H4),

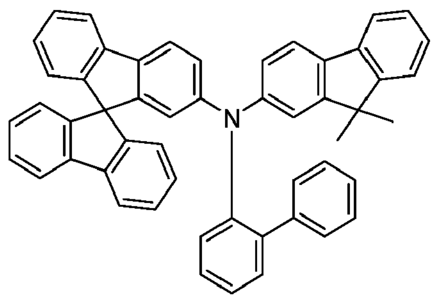

(H5),

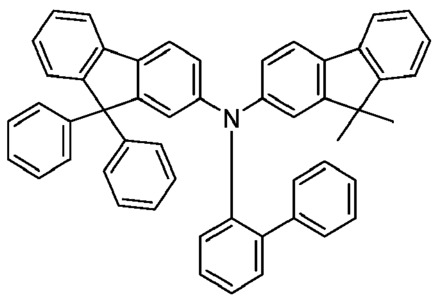

(H6),

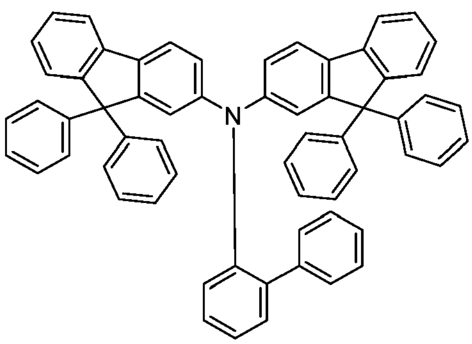

(H7),

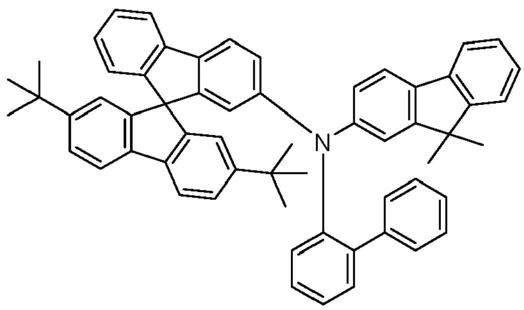

(H8),

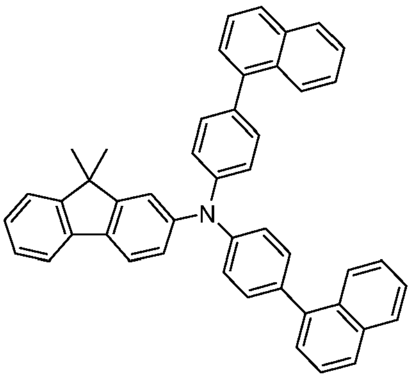 (H9), 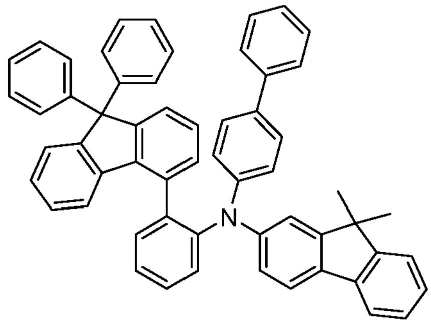 (H10),

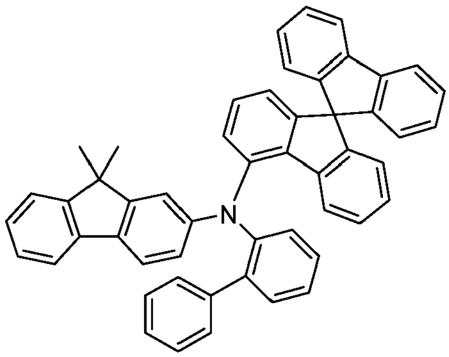 (H11), 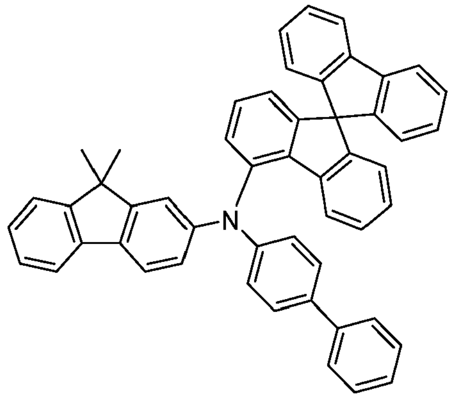 (H12),

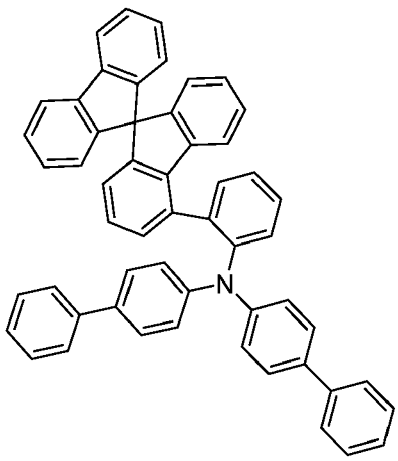 (H13), 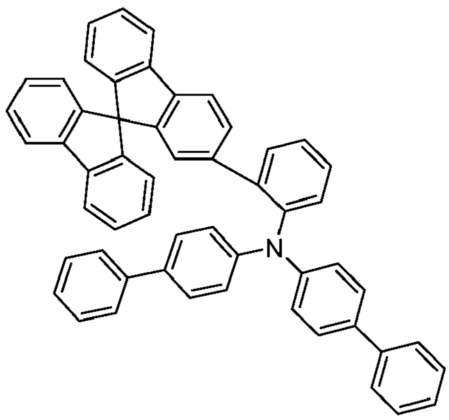 (H14),

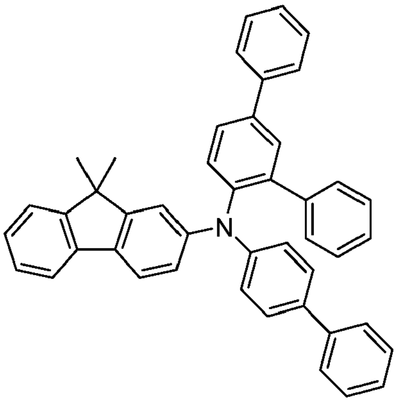 (H15),

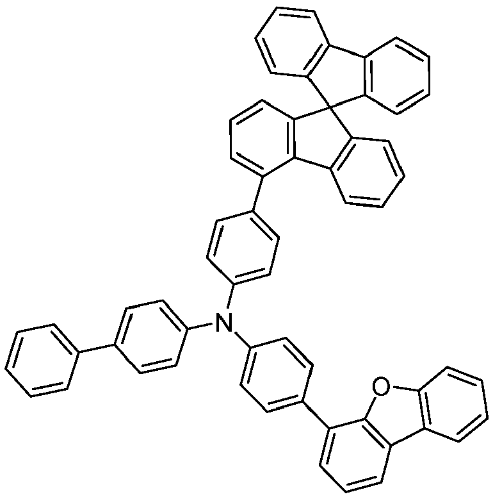 (H16),

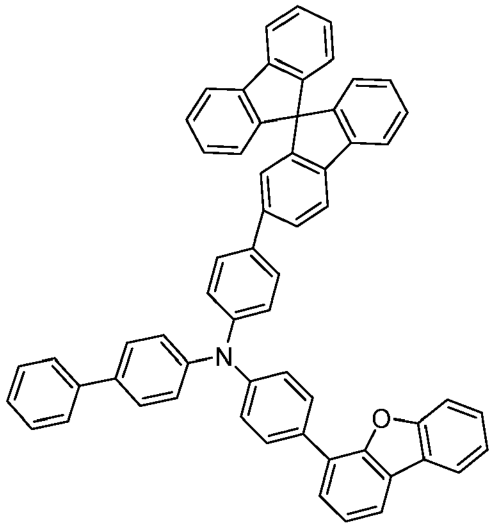 (H17)

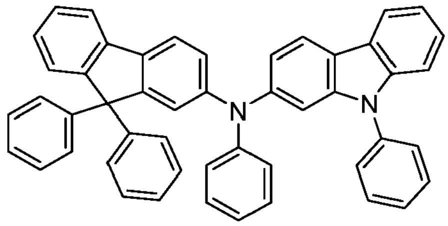 (H18).

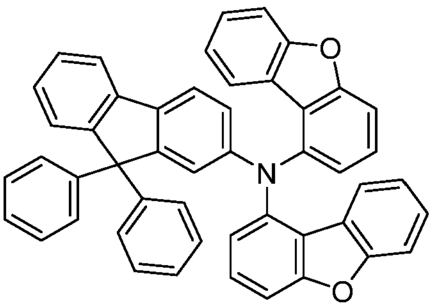 (H19),

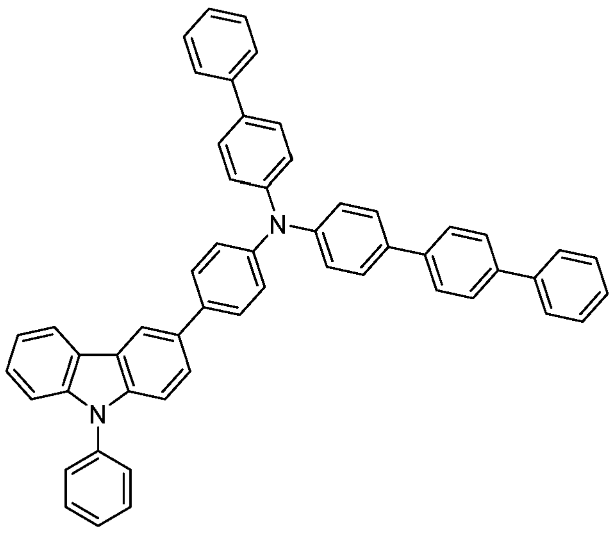 (H20),

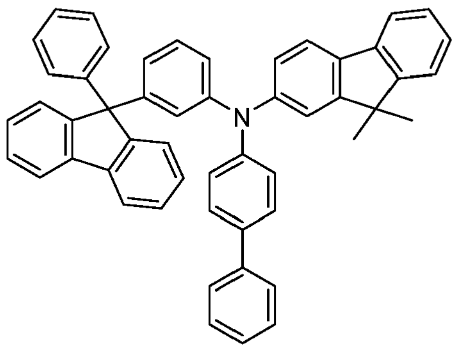

(H21);

According to an embodiment of the electronic device, Formulae (VIIa) and/or (VIIb) - wherever applicable - are selected from H3 to H21.

According to an embodiment, the organic electroluminescent device further comprises a first electron transport layer, wherein the first electron transport layer is arranged between the first light-emitting unit and the second light-emitting unit, and wherein the first electron transport layer is in direct contact to the n-type charge generation layer of the at least one intermediate connecting region.

According to an embodiment, the organic electroluminescent device further comprise a first hole transport layer, wherein the first hole transport layer is arranged between the first light-emitting unit and the second light-emitting unit, and wherein the first hole transport layer is in direct contact to the p-type charge generation layer of the at least one intermediate connecting region.

According to an embodiment, the organic electroluminescent device further comprises a first electron transport layer and first hole transport layer,

wherein the first electron transport layer is arranged between the first light-emitting unit and the second light-emitting unit, and wherein the first electron transport layer is in direct contact to the n-type charge generation layer of the at least one intermediate connecting region,
wherein the first hole transport layer is arranged between the first light-emitting unit and the second light-emitting unit, and wherein the first hole transport layer is in direct contact to the p-type charge generation layer of the at least one intermediate connecting region.

According to an embodiment, the first light-emitting unit comprises a first electron transport layer, wherein the first electron transport layer is arranged between the first light-emitting unit and the second light-emitting unit, and wherein the first electron transport layer is in direct contact to the n-type charge generation layer of the at least one intermediate connecting region.

According to an embodiment, the second light-emitting unit comprises a first hole transport layer, wherein the first hole transport layer is arranged between the first light-emitting unit and the second light-emitting unit, and wherein the first hole transport layer is in direct contact to the p-type charge generation layer of the at least one intermediate connecting region.

According to an embodiment, the first light-emitting unit comprises a first electron transport layer and the second light-emitting unit comprises first hole transport layer, wherein the first electron transport layer is in direct contact to the n-type charge generation layer of the at least one intermediate connecting region,
wherein the first hole transport layer is in direct contact to the p-type charge generation layer of the at least one intermediate connecting region.

According to an embodiment, the first light-emitting unit comprises a first electron transport layer and the second light-emitting unit comprises first hole transport layer,

wherein the first light-emitting unit is arranged between the at least one intermediate connecting region and the anode layer, and wherein the first electron transport layer is in direct contact to the n-type charge generation layer of the at least one intermediate connecting region,
wherein the second light-emitting unit is arranged between the at least one intermediate connecting region and cathode layer, and wherein the first hole transport layer is in direct contact to the p-type charge generation layer of the at least one intermediate connecting region.

According to a preferred embodiment of the present invention, the first hole transport layer comprises a hole transport matrix selected from an arylamine compound, diarylamine compound, triarylamine compound, a compound

of formula (VIIa) or a compound of formula (VIIb) as described above.

Methods:

The present invention furthermore relates to a method for preparation of an an organic electroluminescent device, preferably an organic light emitting device as described above, comprising the steps of

- forming an n-type charge generation layer comprising an organic matrix compound and a metal dopant by depositing an organic matrix compound and a metal dopant, wherein the organic matrix compound is a compound of formula (I);
- forming an intermediate layer comprising or consisting of or consisting essentially of at least one or more organic electron transport compounds by depositing one or more organic electron transport compound directly on the n-type charge generation layer, wherein at least one of the one or more organic electron transport material is a compound of formula (I);
- forming a p-type charge generation layer by depositing a hole transport matrix compound and a p-dopant directly on the intermediate layer,

wherein the organic matrix compound of formula (I) and the organic electron transport compound of formula (I) can be selected the same or different,
wherein the organic electron transport compound of formula (I) has a LUMO energy level and the organic matrix compound of formula (I) has a LUMO energy level,
wherein the LUMO energy level of the organic matrix compound of formula (I) and the LUMO energy level of the organic electron transport compound of formula (I) in the intermediate layer have a difference of $\pm$0.5 eV when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

The methods for deposition that can be suitable comprise:

- deposition via vacuum thermal evaporation;
- deposition via solution processing, preferably the processing is selected from spin-coating, printing, casting; and/or
- slot-die coating.

Preferably the method for deposition is a vacuum thermal evaporation.
According to an embodiment of the invention, the organic matrix compound of formula (I) and the organic electron transportcompound of formula (I) are selected the same.
According to one embodiment, the method may further include forming on the anode layer, at least one layer selected from the group consisting of forming a hole injection layer, forming a hole transport layer, forming an electron blocking layer, forming an emission layer, forming a hole blocking layer, forming an electron transport layer, forming an electron injection layer.
According to an embodiment, the method is related to the preparation of an organic electroluminescent device as described above, comprising the steps of

- forming an anode layer;
- forming an n-type charge generation layer comprising an organic matrix compound and a metal dopant by depositing an organic matrix compound and a metal dopant, wherein the organic matrix compound is a compound of formula (I);
- forming an intermediate layer comprising or consisting of or consisting essentially of at least one or more organic electron transport compounds by depositing one or more organic electron transport compound directly on the n-type charge generation layer, wherein at least one of the one or more organic electron transport material is a compound of formula (I);
- forming a p-type charge generation layer by depositing a hole transport matrix compound and a p-dopant directly on the intermediate layer,
- forming a cathode layer,

wherein the organic matrix compound of formula (I) and the organic electron transport compound of formula (I) can be selected the same or different preferably the same,
wherein the organic electron transport compound of formula (I) has a LUMO energy level and the organic matrix compound of formula (I) has a LUMO energy level,
wherein the LUMO energy level of the organic matrix compound of formula (I) and the LUMO energy level of the organic electron transport compound of formula (I) in the intermediate layer have a difference of $\pm$0.5 eV when

calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to an embodiment, the method is related to the preparation of an organic electroluminescent device as described above, comprising the steps of

- forming an anode layer;
- forming a first light-emitting unit;
- forming an n-type charge generation layer comprising an organic matrix compound and a metal dopant by depositing an organic matrix compound and a metal dopant, wherein the organic matrix compound is a compound of formula (I);
- forming an intermediate layer comprising or consisting of or consisting essentially of at least one or more organic electron transport compounds by depositing one or more organic electron transport compound directly on the n-type charge generation layer, wherein at least one of the one or more organic electron transport material is a compound of formula (I);
- forming a p-type charge generation layer by depositing a hole transport matrix compound and a p-dopant directly on the intermediate layer,
- forming a second light-emitting unit;
- forming a cathode layer,

wherein the organic matrix compound of formula (I) and the organic electron transport compound of formula (I) can be selected the same or different preferably the same, wherein the first organic light-emitting unit comprises a first emission layer, wherein the second light-emitting unit comprises a second emission layer,
wherein the organic electron transport compound of formula (I) has a LUMO energy level and the organic matrix compound of formula (I) has a LUMO energy level,
wherein the LUMO energy level of the organic matrix compound of formula (I) and the LUMO energy level of the organic electron transport compound of formula (I) in the intermediate layer have a difference of $\pm 0.5$ eV when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

## Setup of the organic electroluminescent device

According to an embodiment the organic electroluminescent device is an organic light emitting diode.
According to a preferred embodiment, the organic electroluminescent device is an organic light emitting diode, wherein light is emitted through the cathode layer.
The present invention furthermore relates to a display device comprising an organic electroluminescent device according to the present invention.
According to a preferred embodiment of the invention, the display device comprising an organic electroluminescent device according to the present invention, wherein the cathode layer is transparent.

## Further embodiments

According to an embodiment, the organic electroluminescent device comprises a hole injection layer.
According to an embodiment, the organic electroluminescent device comprises a hole injection layer, and wherein the hole injection layer is in direct contact to the anode layer.
According to an embodiment, the organic electroluminescent device comprises a hole injection layer, wherein the hole injection layer is in direct contact to the anode layer, and wherein the hole injection layer comprises an organic p-dopant.
According to an embodiment, the organic electroluminescent device comprises a hole injection layer, wherein the hole injection layer is in direct contact to the anode layer, and wherein the hole injection layer comprises an organic p-dopant and a hole transport compound.
According to an embodiment, the organic electroluminescent device comprises an electron injection layer.
According to an embodiment, the organic electroluminescent device comprises an electron injection layer, and wherein the electron injection layer is in direct contact to the cathode layer.
According to an embodiment, the organic electroluminescent device comprises an electron transport layer.
According to an embodiment, wherein the organic electroluminescent device comprises a hole transport layer.
According to an embodiment, wherein the organic electroluminescent device comprises an electron transport layer and a hole transport layer.
According to an embodiment, wherein the organic electroluminescent device comprises an electron transport

layer and a hole transport layer wherein the hole transport layer is arranged closer to the anode than the at least one electron transport layer.

According to an embodiment, the orqanic electroluminescent device comprises at least one electron transport layer and at least one hole transport layer, wherein the first emission layer is arranged between the at least one hole transport layer and the at least one electron transport layer, wherein preferably, the at least one hole transport layer is arranged closer to the anode than the at least one electron transport layer.

According to an embodiment, the organic electroluminescent device comprises an electron blocking layer and a hole blocking layer, wherein the electron blocking layer is preferably arranged between the hole transport layer and the first emission layer and the hole blocking layer is arranged between the electron transport layer and the first emission layer.

According to an embodiment, the electroluminescent device further comprises at least one electron transport layer.

According to an embodiment, the at least one electron transport layer is comprised in one of the first or second light-emitting unit.

According to an embodiment, the organic electroluminescent device comprises a first electron transport layer, and a second electron transport layer.

According to an embodiment, the electron transport layer is free of metal dopant, particularly free of metal dopant in the oxidation state (0).

According to an embodiment, the n-type charge generation layer is adjacent to the first electron transport layer.

According to an embodiment, the n-type charge generation layer is adjacent to the first electron transport layer and adjacent to the intermediate layer.

According to an embodiment, the n-type charge generation layer is in direct contact to the first electron transport layer.

According to an embodiment, the n-type charge generation layer is in direct contact to the first electron transport layer and adjacent to the intermediate layer.

According to an embodiment, the n-type charge generation layer is in direct contact to the first electron transport layer and in direct contact to the intermediate layer.

According to an embodiment, the n-type charge generation layer of each of the at least one charge generation layer is in direct contact to the at least one electron transport layer and adjacent to the p-type charge generation layer of said at least one charge generation layer.

According to an embodiment, the organic electroluminescent device comprises a first hole transport layer, and second hole transport layer.

According to an embodiment, the p-type charge generation layer is adjacent to the at least one hole transport layer.

According to an embodiment, the p-type charge generation layer is in direct contact to the hole transport layer.

According to an embodiment, the p-type charge generation layer is adjacent to the intermediate layer and adjacent to the at least one hole transport layer.

According to an embodiment, the p-type charge generation layer is in direct contact to the intermediate layer and in direct contact to the at least one hole transport layer.

According to an embodiment, the p-type charge generation layer of each of the at least one intermediate connecting region is adjacent to the at least one hole transport layer.

According to an embodiment, the p-type charge generation layer of each of the at least one intermediate connecting region is in direct contact to the at least one hole transport layer.

According to an embodiment, the p-type charge generation layer of each of the at least one intermediate connecting region is adjacent to the n-type charge generation layer of said at least one intermediate connecting region and adjacent to the at least one hole transport layer.

According to an embodiment, the p-type charge generation layer of each of the at least one intermediate connecting region is in direct contact to the n-type charge generation layer of said at least one intermediate interconnecting region and in direct contact to the at least one hole transport layer.

According to an embodiment, the organic electroluminescent device further comprises a third light-emitting unit, and wherein the third light-emitting unit comprises a third emission layer

According to an embodiment, the organic electroluminescent device further comprises a third light-emitting unit and a fourth light-emitting unit, wherein the third light-emitting unit comprises a third emission layer, and wherein the fourth light-emitting unit comprises a fourth emission layer.

According to an embodiment, the organic electroluminescent device comprises at least two intermediate connecting regions and further comprises a third light-emitting unit, and wherein the third light-emitting unit comprises a third emission layer.

According to an embodiment, the organic electroluminescent device comprises at least three intermediate

connecting regions and further comprises a third light-emitting unit and a fourth light-emitting unit, wherein the third light-emitting unit comprises a third emission layer, and wherein the fourth light-emitting unit comprises a fourth emission layer.

According to an embodiment, there is provided an organic electroluminescent device comprising: a substrate, an anode layer, a first hole injection layer, a first hole transport layer, a first electron blocking layer, a first emission layer, a first optional hole blocking layer, a first electron transport layer, an intermediate connecting region comprising an n-type charge generation layer, an intermediate layer, and a p-type charge generation layer, a second hole transport layer, a second electron blocking layer, a second emission layer, a second optional hole blocking layer, a second electron transport layer, and an electron injection layer and a cathode layer.

According to an embodiment, there is provided an organic electroluminescent device comprising: a substrate, an anode layer, a first hole injection layer, a first hole transport layer, a first electron blocking layer, a first emission layer, a first electron transport layer, an intermediate connecting region comprising an n-type charge generation layer, an intermediate layer, and a p-type charge generation layer, a second hole transport layer, a second electron blocking layer, a second emission layer, a hole blocking layer, a second electron transport layer, and an electron injection layer and a cathode layer.

According to an embodiment, there is provided an organic electroluminescent device comprising: a substrate, an anode layer, a hole injection layer, a first hole transport layer, a first electron blocking layer, a first emission layer, a first optional hole blocking layer, a first electron transport layer, a first intermediate connecting region comprising first n-type charge generation layer, a first intermediate layer, and a first p-type charge generation layer, a second hole transport layer, a second electron blocking layer, a second emission layer, a second optional hole blocking layer, a second electron transport layer, a second intermediate connecting region comprising a second n-type charge generation layer, a second intermediate layer, and a second p-type charge generation layer, a third hole transport layer, a third electron blocking layer, a third emission layer, a third optional hole blocking layer, a third electron transport layer and an electron injection layer and a cathode layer.

According to an embodiment, there is provided an organic electroluminescent device comprising: a substrate, an anode layer, a hole injection layer, a first hole transport layer, a first electron blocking layer, a first emission layer, electron transport layer, a first intermediate connecting region comprising first n-type charge generation layer, a first intermediate layer, and a first p-type charge generation layer, a second hole transport layer, a second electron blocking layer, a second emission layer, a first optional hole blocking layer, a second electron transport layer, a second intermediate connecting region comprising a second n-type charge generation layer, a second intermediate layer, and a second p-type charge generation layer, a third hole transport layer, a third electron blocking layer, a third emission layer, a second optional hole blocking layer, a third electron transport layer and an electron injection layer and a cathode layer.

According to an embodiment, there is provided an organic electroluminescent device comprising: a substrate, an anode layer, a hole injection layer, a first hole transport layer, a first electron blocking layer, a first emission layer, electron transport layer, a first intermediate connecting region comprising first n-type charge generation layer, a first intermediate layer, and a first p-type charge generation layer, a second hole transport layer, a second electron blocking layer, a second emission layer, a second electron transport layer, a second intermediate connecting region comprising a second n-type charge generation layer, a second intermediate layer, and a second p-type charge generation layer, a third hole transport layer, a third electron blocking layer, a third emission layer, an optional hole blocking layer, a third electron transport layer and an electron injection layer and a cathode layer.

According to an embodiment, there is provided an organic electroluminescent device comprising: a substrate, an anode layer, a hole injection layer, a first hole transport layer, a first electron blocking layer, a first emission layer, a first optional hole blocking layer, a first electron transport layer, a first intermediate connecting region comprising first n-type charge generation layer, a first intermediate layer, and a first p-type charge generation layer, a second hole transport layer, a second electron blocking layer, a second emission layer, a second optional hole blocking layer, a second electron transport layer, a second intermediate connecting region comprising a second n-type charge generation layer, a second intermediate layer, and a second p-type charge generation layer, a third hole transport layer, a third electron blocking layer, a third emission layer, a third optional hole blocking layer, a third electron transport layer, a third intermediate connecting region comprising a third n-type charge generation layer, a third intermediate layer, and a third p-type charge generation layer, a fourth hole transport layer, a fourth electron blocking layer, a fourth emission layer, a fourth optional hole blocking layer, a fourth electron transport layer, and an electron injection layer and a cathode layer.

According to an embodiment, there is provided an organic electroluminescent device comprising: a substrate, an anode layer, a hole injection layer, a first hole transport layer, a first electron blocking layer, a first emission layer, a first electron transport layer, a first intermediate connecting region comprising first n-type charge generation layer, a first intermediate layer, and a first p-type charge generation layer, a second hole transport layer, a second electron blocking layer, a second emission layer, a first optional hole blocking layer, a second electron transport layer, a second intermediate connecting region comprising a second n-type charge generation layer, a second intermediate layer, and a second p-type charge generation layer, a third hole transport layer, a third electron blocking layer, a third emission layer, a second optional hole blocking layer, a third electron transport layer, a third intermediate connecting region comprising a third n-type charge generation layer, a third intermediate layer, and a third p-type charge generation layer, a fourth hole transport layer, a fourth electron blocking layer, a fourth emission layer, a third optional hole blocking layer, a fourth electron transport layer, and an electron injection layer and a cathode layer.

According to an embodiment, there is provided an organic electroluminescent device comprising: a substrate, an anode layer, a hole injection layer, a first hole transport layer, a first electron blocking layer, a first emission layer, a first electron transport layer, a first intermediate connecting region comprising first n-type charge generation layer, a first intermediate layer, and a first p-type charge generation layer, a second hole transport layer, a second electron blocking layer, a second emission layer, a second electron transport layer, a second intermediate connecting region comprising a second n-type charge generation layer, a second intermediate layer, and a second p-type charge generation layer, a third hole transport layer, a third electron blocking layer, a third emission layer, a first optional hole blocking layer, a third electron transport layer, a third intermediate connecting region comprising a third n-type charge generation layer, a third intermediate layer, and a third p-type charge generation layer, a fourth hole transport layer, a fourth electron blocking layer, a fourth emission layer, a second optional hole blocking layer, a fourth electron transport layer, and an electron injection layer and a cathode layer.

According to an embodiment, there is provided an organic electroluminescent device comprising: a substrate, an anode layer, a hole injection layer, a first hole transport layer, a first electron blocking layer, a first emission layer, a first electron transport layer, a first intermediate connecting region comprising first n-type charge generation layer, a first intermediate layer, and a first p-type charge generation layer, a second hole transport layer, a second electron blocking layer, a second emission layer, a second electron transport layer, a second intermediate connecting region comprising a second n-type charge generation layer, a second intermediate layer, and a second p-type charge generation layer, a third hole transport layer, a third electron blocking layer, a third emission layer, a third electron transport layer, a third intermediate connecting region comprising a third n-type charge generation layer, a third intermediate layer, and a third p-type charge generation layer, a fourth hole transport layer, a fourth electron blocking layer, a fourth emission layer, an optional hole blocking layer, a fourth electron transport layer, and an electron injection layer and a cathode layer.

## Substantially covalent matrix compound

According to an embodiment, the substantially covalent matrix compound may be selected from at least one organic compound. The substantially covalent matrix may consists substantially from covalently bound C, H, O, N, S, which optionally comprise in addition covalently bound B, P, As and/or Se.

According to an embodiment, the substantially covalent matrix compound may be selected from organic compounds consisting substantially from covalently bound C, H, O, N, S, which optionally comprise in addition covalently bound B, P, As and/or Se.

Organometallic compounds comprising covalent bonds carbon-metal, metal complexes comprising organic ligands and metal salts of organic acids are further examples of organic compounds that may serve as substantially covalent matrix compounds of the hole injection layer.

In an embodiment, the substantially covalent matrix compound lacks metal atoms and majority of its skeletal atoms may be selected from C, O, S, N. Alternatively, the substantially covalent matrix compound lacks metal atoms and majority of its skeletal atoms may be selected from C and N.

According to an embodiment, the substantially covalent matrix compound may have a molecular weight Mw of $\geq$ 400 and $\leq$ 2000 g/mol, preferably a molecular weight Mw of $\geq$ 450 and $\leq$ 1500 g/mol, further preferred a molecular weight Mw of $\geq$ 500 and $\leq$ 1000 g/mol, in addition preferred a molecular weight Mw of $\geq$ 550 and $\leq$ 900 g/mol, also preferred a molecular weight Mw of $\geq$ 600 and $\leq$ 800 g/mol.

Preferably, the substantially covalent matrix compound comprises at least one arylamine moiety, alternatively a diarylamine moiety, alternatively a triarylamine moiety.

Preferably, the substantially covalent matrix compound is free of metals and/or ionic bonds.

## Compound of formula (VIII) or a compound of formula (IX)

According to another aspect of the present invention, the substantially covalent matrix compound may comprises at least one arylamine compound, diarylamine compound, triarylamine compound, a compound of formula (VIII) or a compound of formula (IX):

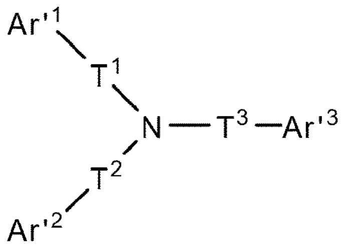 (VIII), 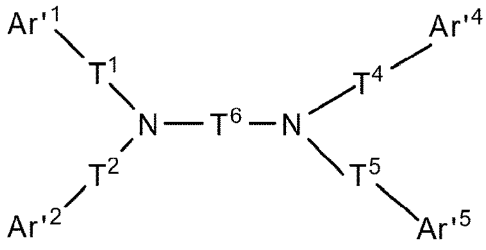 (IX),

wherein:

$T^1$, $T^2$, $T^3$, $T^4$ and $T^5$ are independently selected from a single bond, phenylene, biphenylene, terphenylene or naphthenylene, preferably a single bond or phenylene;

$T^6$ is phenylene, biphenylene, terphenylene or naphthenylene;

Ar'[1], Ar'[2], Ar'[3], Ar'[4] and Ar'[5]are independently selected from substituted or unsubstituted $C_6$ to $C_{20}$ aryl, or substituted or unsubstituted $C_3$ to $C_{20}$ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;

wherein

the substituents of Ar'[1], Ar'[2], Ar'[3], Ar'[4] and Ar'[5] are selected the same or different from the group comprising H, D, F, C(=O)R'[2], CN, $Si(R'^2)_3$, $P(=O)(R'^2)_2$, OR'[2], S(=O)R'[2], $S(=O)_2R'^2$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle, wherein R'[2] may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl.

According to an embodiment wherein $T^1$, $T^2$, $T^3$, $T^4$ and $T^5$ may be independently selected from a single bond, phenylene, biphenylene or terphenylene. According to an embodiment wherein $T^1$, $T^2$, $T^3$, $T^4$ and $T^5$ may be independently selected from phenylene, biphenylene or terphenylene and one of $T^1$, $T^2$, $T^3$, $T^4$ and $T^5$ are a single bond. According to an embodiment wherein $T^1$, $T^2$, $T^3$, $T^4$ and $T^5$ may be independently selected from phenylene or biphenylene and one of $T^1$, $T^2$, $T^3$, $T^4$ and $T^5$ are a single bond. According to an embodiment wherein $T^1$, $T^2$, $T^3$, $T^4$ and $T^5$ may be independently selected from phenylene or biphenylene and two of $T^1$, $T^2$, $T^3$, $T^4$ and $T^5$ are a single bond.

According to an embodiment wherein $T^1$, $T^2$ and $T^3$ may be independently selected from phenylene and one of $T^1$, $T^2$ and $T^3$ are a single bond. According to an embodiment wherein $T^1$, $T^2$ and $T^3$ may be independently selected from phenylene and two of $T^1$, $T^2$ and $T^3$ are a single bond.

According to an embodiment wherein $T^6$ may be phenylene, biphenylene, terphenylene. According to an embodiment wherein $T^6$ may be phenylene. According to an embodiment wherein $T^6$ may be biphenylene. According to an embodiment wherein $T^6$ may be terphenylene.

According to an embodiment the organic electroluminescent device is an organic light emitting diode.

According to a preferred embodiment of the invention, the organic electroluminescent device is an organic light emitting diode, wherein light is emitted through the cathode layer.

The present invention furthermore relates to a display device comprising an organic electroluminescent device according to the present invention.

According to a preferred embodiment of the invention, the display device comprising an organic electroluminescent device according to the present invention, wherein the cathode layer is transparent.

Hole injection layer

A hole injection layer (HIL) may be formed on the anode layer by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of $10^{-8}$ to $10^{-3}$ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

According to a preferred embodiment of the present invention, the hole injection layer may comprise a substantially covalent matrix compound.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

Preferably, the HIL is in direct contact to the anode layer.

The hole injection layer can comprise an organic p-dopant.

The organic p-dopant can be a radialene of formula (I).

The hole injection layer can comprise a hole transport compound.

The hole injection layer can comprise an organic p-dopant and a hole transport compound.

Further layers

In accordance with the invention, the organic electroluminescent device may comprise, besides the layers already mentioned above, further layers. Exemplary embodiments of respective layers are described in the following:

*Substrate*

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate, a silicon substrate or a backplane.

*Anode layer*

The anode layer may be formed by depositing or sputtering a material that is used to form the anode layer. The material used to form the anode layer may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode electrode. The anode layer may also be formed using metals, typically silver (Ag), gold (Au), or metal alloys.

*Hole transport layer*

The organic electroluminescent device according to the present invention may further comprise at least one hole transport layer (HTL). According to an embodiment, the at least one hole transport layer is comprised in one of the at least two light-emitting units, wherein preferably at least one hole transport layer is comprised in each light-emitting unit.

A hole transport layer (HTL) may be formed on the HIL or CGL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL or CGL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

According to an embodiment, the hole transport layer may comprise a substantially covalent matrix compound as described above.

According to a preferred embodiment of the present invention, the hole injection layer and the hole transport layer may comprise an identical substantially covalent matrix compound as described above.

According to an embodiment, the hole transport layer may comprise a compound of formula (VII) or (VIII) as described above.

According to a preferred embodiment of the present invention, the hole injection layer and the hole transport layer may comprise an identical compound of formula (VII) or (VIII) as described above.

According to a preferred embodiment of the present invention, the p-type charge generation layer, the hole injection layer and the hole transport layer may comprise an identical substantially covalent matrix compound.

According to a preferred embodiment of the present invention, the p-type charge generation layer, the hole injection layer and the hole transport layer may comprise an identical an identical compound of formula (VII) or (VIII) as described above.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

*Electron blocking layer*

The function of an electron blocking layer (EBL) is to prevent electrons from being transferred from an emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

*Photoactive layer (PAL)*

According to an embodiment of the present invention, the organic electroluminescent device may further comprise a photoactive layer, wherein the photoactive layer is arranged between the anode layer and the cathode layer.

The photoactive layer converts an electrical current into photons or photons into an electrical current.

The PAL may be formed on the HTL by vacuum deposition, spin coating, slot-die coating, printing, casting, LB deposition, or the like. When the PAL is formed using vacuum deposition or spin coating, the conditions for deposition and coating may be similar to those for the formation of the HIL. However, the conditions for deposition and coating may vary, according to the compound that is used to form the PAL.

The photoactive layer may be a light-emitting layer or a light-absorbing layer, in particular a light-emitting layer.

*Emission layer (EML)*

According to an embodiment of the present invention, the organic electroluminescent device may further comprise an emission layer, wherein the emission layer is arranged between the anode layer and the cathode layer.

The EML may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

The emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters, however, fluorescent red emitter dopants could also be used.

Examples of phosphorescent green emitter dopants are Ir(ppy)3 (ppy = phenylpyridine), Ir(ppy)2(acac), Ir(mpyp)3.

Examples of phosphorescent blue emitter dopants are F2Irpic, (F2ppy)2Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the emission layer may consist of a light-emitting polymer. The EMI, may have a thickness of about 10 nm to about 100 nm, for example, from about 20 nm to about 60 nm. When the thickness of the EMI, is within this range, the EML may have excellent light emission, without a substantial penalty in driving voltage.

According to a preferred embodiment of the present invention, the emission layer comprises a light-emitting compound of formula (X):

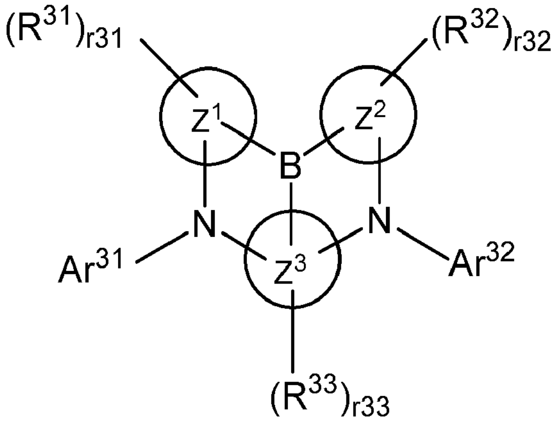

(X),

wherein

$Z^1$, $Z^2$ and $Z^3$ are the same as or different from each other, and are each independently selected from the group comprising a monocyclic to polycyclic aromatic hydrocarbon ring or monocyclic to polycyclic aromatic hetero ring;

$Ar^{31}$ and $Ar^{32}$ are the same as or selected different from each other, and are each independently a substituted or unsubstituted alkyl group, a substituted or unsubstituted aryl group, or a substituted or unsubstituted heteroaryl group, or are bonded to an adjacent substituent to form a substituted or unsubstituted aromatic ring or a substituted or unsubstituted aliphatic ring;

$R^{31}$, $R^{32}$ and $R^{33}$ are the same as or different from each other, and are each independently selected from the group comprising hydrogen, deuterium, a substituted or unsubstituted alkyl group, a substituted or unsubstituted silyl group, a substituted or unsubstituted amine group, a substituted or unsubstituted aryl group, or a substituted or unsubstituted heteroaryl group, or adjacent substituents are bonded to each other to form a substituted or unsubstituted aromatic ring or a substituted or unsubstituted aliphatic ring,

wherein one or more substituents selected from the group consisting of deuterium, an alkyl group having 1 to 6 carbon atoms, an alkyl silyl group having 1 to 30 carbon atoms, an aryl silyl group having 6 to 50 carbon atoms, an alkylamine group having 1 to 30 carbon atoms, an alkylarylamine group having 1 to 50 carbon atoms, an arylamine group having 6 to 50 carbon atoms, an aryl group having 6 to 30 carbon atoms, and a heteroaryl group having 2 to 30 carbon atoms, or a substituent to which two or more substituents selected from the group are linked, or adjacent substituents are bonded to each other to form an aliphatic hydrocarbon ring having 3 to 60 carbon atoms, which is unsubstituted or substituted with the substituent;

$r^{31}$, $r^{32}$ and $r^{33}$ are each an integer from 0, 1, 2, 3 or 4, and when $r^{31}$ to $r^{33}$ are 2 or higher, substituents in the parenthesis are the same as or different from each other.

According to an embodiment, for formula (X):

$Z^1$, $Z^2$ and $Z^3$ are the same as or selected different from each other, and are each independently selected from the group comprising a monocyclic to bicyclic aromatic hydrocarbon ring, or a monocyclic to bicyclic aromatic hetero ring containing O, N or S;

$Ar^{31}$ and $Ar^{32}$ are the same as or selected different from, and are each independently selected from the group comprising an alkyl group having 1 to 10 carbon atoms, which is unsubstituted or substituted with an aryl group, an aryl group having 6 to 30 carbon atoms, which is unsubstituted or substituted with an aryl group, or a heteroaryl group having 2 to 30 carbon atoms;

$R^{31}$, $R^{32}$ and $R^{33}$ are the same as or selected different from each other, and are each independently selected from the group comprising hydrogen, deuterium, a substituted or unsubstituted alkyl group, a substituted or unsubstituted cycloalkyl group, a substituted or unsubstituted silyl group, a substituted or unsubstituted aryl group,

or a substituted or unsubstituted heteroaryl group.

According to an embodiment, wherein for formula (X):

$Z^1$, $Z^2$ and $Z^3$ are the same as or selected different from each other, and are each independently selected from the group comprising a benzene ring or a thiophene ring;

$Ar^{31}$ and $Ar^{32}$ are the same as or selected different from each other, and are each independently selected from the group comprising phenyl group, a biphenyl group, a naphthyl group, a dimethyl fluorenyl group, a diphenyl fluorenyl group, a dibenzofuran group, or a dibenzothiophene group;

$R^{31}$, $R^{32}$ and $R^{33}$ are the same as or selected different from each other, and are each independently selected from the group comprising hydrogen, deuterium, a substituted or unsubstituted alkyl group having 1 to 10 carbon atoms, a substituted or unsubstituted cycloalkyl group having 5 to 30 carbon atoms, a substituted or unsubstituted silyl group having 1 to 10 carbon atoms, a substituted or unsubstituted aryl group having 6 to 30 carbon atoms, or a substituted or unsubstituted heteroaryl group having 2 to 30 carbon atoms.

According to a preferred embodiment of the present invention, the emission layer comprises a light-emitting compound of formula (X) is selected from the compounds BD1 to BD9:

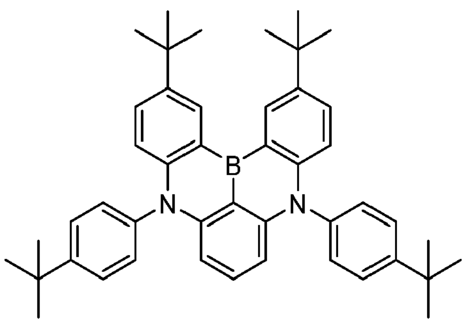
(BD1),

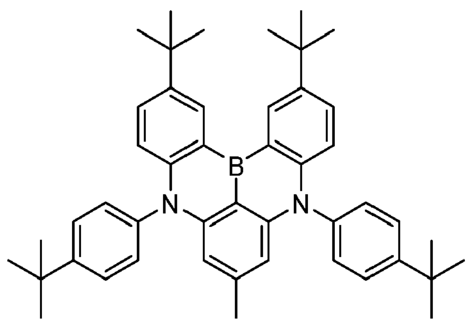
(BD2),

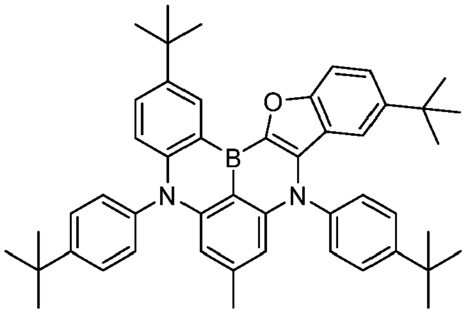 (BD3), 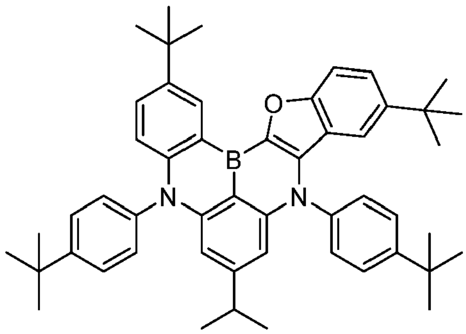 (BD4),

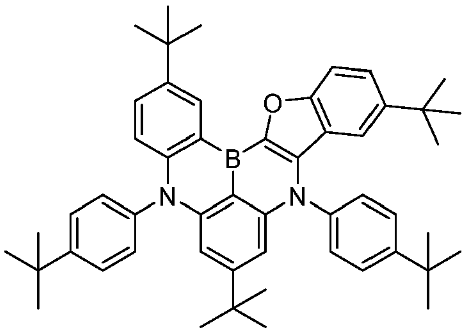 (BD5), 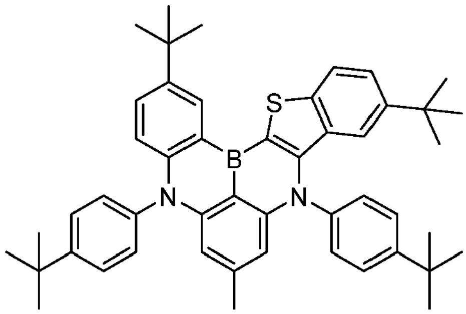 (BD6),

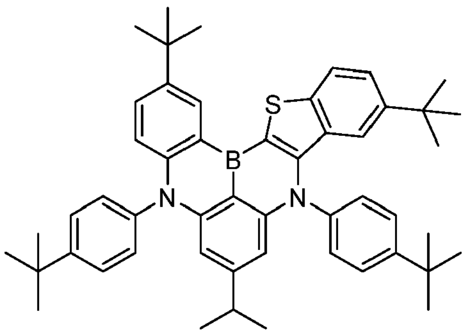 (BD7), 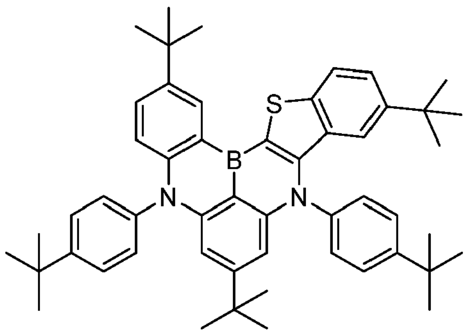 (BD8),

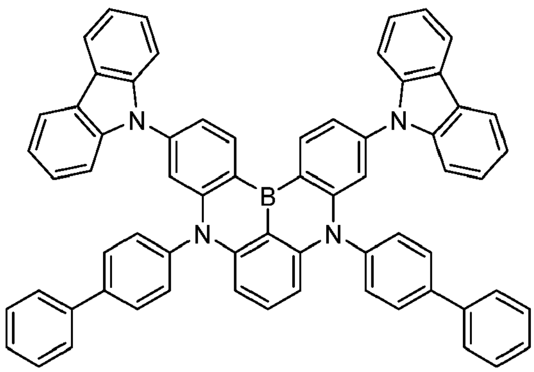 (BD9).

According to a preferred embodiment of the present invention, the emission layer comprises an organic emitter host compound, wherein the organic emitter host compound comprises

- at least one condensed aromatic ring system consisting of 3 to 5 rings, and
- 3 to 7 aromatic or heteroaromatic rings, wherein one or more sub-groups of the aromatic and/or heteroaromatic

rings may be condensed to form fused aromatic or heteroaromatic ring systems;

wherein the molecular weight Mw of the organic emitter host compound is in the range of ≥ 400 and ≤ 2000 g/mol.

According to a preferred embodiment of the present invention, the organic emitter host compound has the formula (XI)

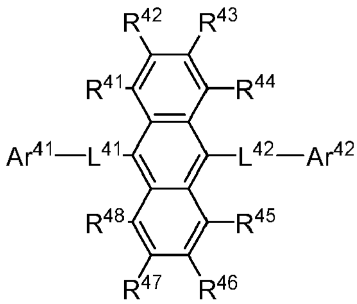

(XI), wherein

$Ar^{41}$ and $Ar^{42}$ are independently selected from substituted or unsubstituted $C_6$ to $C_{24}$ aryl, substituted or unsubstituted $C_3$ to $C_{24}$ heteroaryl;
$L^{41}$ and $L^{42}$ are independently selected from a direct bond or substituted or unsubstituted $C_6$ to $C_{24}$ arylene, substituted or unsubstituted $C_3$ to $C_{24}$ heteroarylene;
$R^{41}$ to $R^{41}$ are independently selected from H, D, substituted or unsubstituted $C_1$ to $C_{12}$ alkyl, substituted or unsubstituted $C_6$ to $C_{19}$ aryl, substituted or unsubstituted $C_3$ to $C_{12}$ heteroaryl;
wherein
the substituents on $Ar^{41}$, $Ar^{42}$, $L^{41}$, $L^{42}$, $R^{41}$ to $R^{48}$ are independently selected from D, $C_6$ to $C_{10}$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy, halogen, F or CN.

According to a preferred embodiment of the present invention, the organic emitter host and/or compound of formula (XI) is selected from the compounds BH1 to BH13:

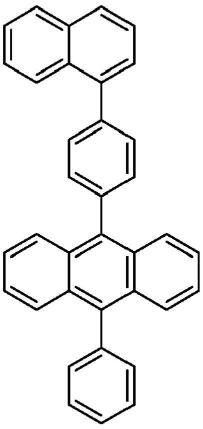
(BH1),
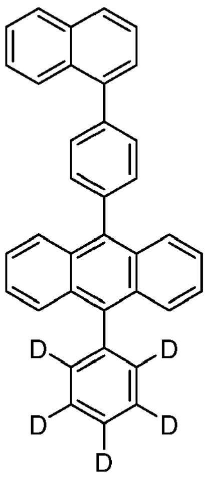
(BH2),
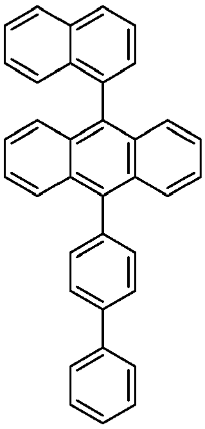
(BH3),
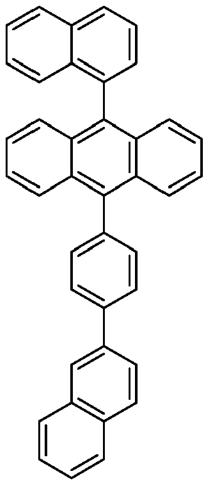
(BH4),

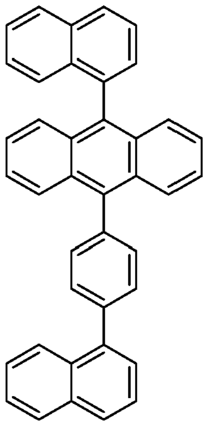 (BH5), 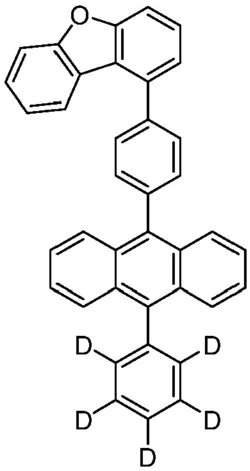 (BH6), 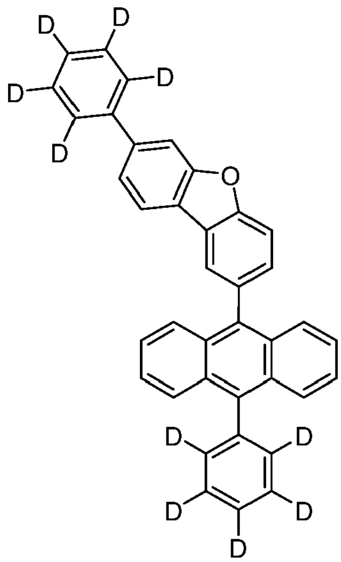 (BH7),

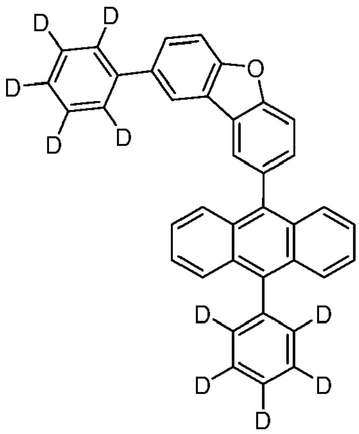 (BH8), 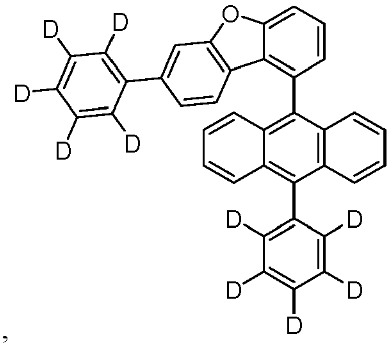 (BH9),

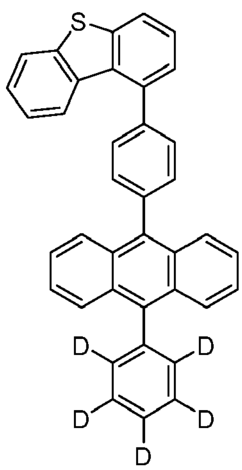 (BH10), 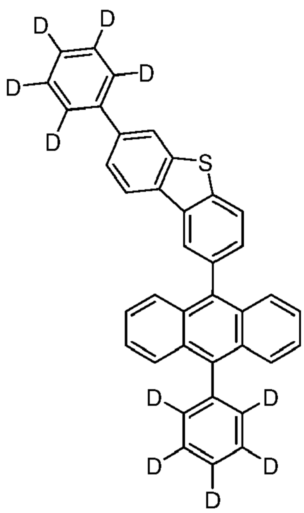 (BH11),

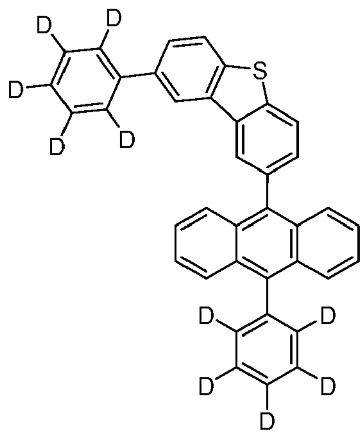 (BH12), 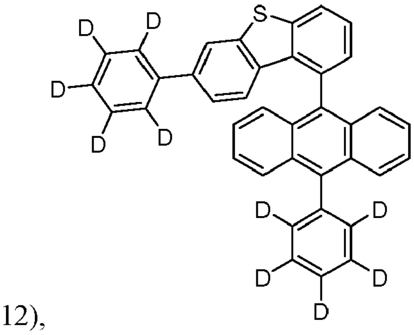 (BH13).

According to a preferred embodiment of the present invention, the emission layer comprises a light-emitting dopant of formula (X) and an organic emitter host of formula (XI).

*Hole blocking layer (HBL)*

A hole blocking layer (HBL) may be formed on the EML, by using vacuum deposition, spin coating, slot-die coating, printing, casting, LB deposition, or the like, in order to prevent the diffusion of holes into the ETL. When the EMI, comprises a phosphorescent dopant, the HBL may have also a triplet exciton blocking function.
The HBL may also be named auxiliary ETL or a-ETL.
When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and azine derivatives, preferably triazine or pyrimidine derivatives.
The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

*Electron transport layer (ETL)*

The organic electroluminescent device according to the present invention may further comprise at least one electron transport layer (ETL). According to an embodiment, the at least one electron transport layer is comprised in one of the at least two light-emitting units, wherein preferably at least one electron transport layer is comprised in each light-emitting unit.
According to another embodiment of the present invention, the electron transport layer may further comprise an azine compound, preferably a pyridine, pyrimidine or triazine compound, and most preferably a triazine compound or a pyrimidine compound.
According to another embodiment of the present invention, the electron transport layer may further comprise 2-([1,1'-biphenyl]-4-yl)-4-(9,9-diphenyl-9H-fluoren-4-yl)-6-phenyl-1,3,5-triazine, 2-(3-(2,6-dimethylpyridin-3-yl)-5-(phenanthren-9-yl)phenyl)-4,6-diphenyl-1,3,5-triazine, 3'-(4-phenyl-6-(spiro[fluorene-9,9'-xanthen]-2'-yl)-1,3,5-triazin-2-yl)-[1,1'-biphenyl]-4-carbonitrile, and 4'-(4-(4-(4,6-diphenyl-1,3,5-triazin-2-yl)phenyl)naphthalen-1-yl)-[1,1'-biphenyl]-4-carbonitrile.
In an embodiment, the electron transport layer may further comprise a dopant selected from an alkali organic complex, preferably LiQ.
The thickness of the ETL may be in the range from about 15 nm to about 50 nm, for example, in the range from about 20 nm to about 40 nm. When the thickness of the ETL is within this range, the ETL may have satisfactory electron-injecting properties, without a substantial penalty in driving voltage.
According to another embodiment of the present invention, the organic electroluminescent device may further comprise a hole blocking layer and an electron transport layer, wherein the hole blocking layer and the electron transport layer comprise an azine compound. Preferably, the azine compound is a pyridine, pyrimidine or triazine compound, and most preferably a triazine compound.

*Electron injection layer (EIL)*

An optional EIL, which may facilitates injection of electrons from the cathode, may be formed on the ETL preferably closest to the cathode, and more preferably directly on the electron transport layer. Examples of materials for forming the EII, include lithium 8-hydroxyquinolinolate (LiQ), LiF, NaCl, CsF, Li2O, BaO, Ca, Ba, Yb, Mg which are known in the art. Deposition and coating conditions for forming the EII, are similar to those for formation of the HIL, although the deposition and coating conditions may vary, according to the material that is used to form the EIL.
The thickness of the EIL may be in the range from about 0.1 nm to about 10 nm, for example, in the range from about 0.5 nm to about 9 nm. When the thickness of the EII, is within this range, the EII, may have satisfactory electron-injecting properties, without a substantial penalty in driving voltage.

*Cathode layer*

The cathode layer is formed on the ETL or optional EIL. The cathode layer may be formed of a metal, an alloy, an electrically conductive compound, or a mixture thereof. The cathode electrode may have a low work function. For example, the cathode layer may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, such as ITO or IZO.
The thickness of the cathode layer may be in the range from about 5 nm to about 1000 nm, for example, in the range from about 10 nm to about 100 nm. When the thickness of the cathode layer is in the range from about 5 nm to about 50 nm, the cathode layer may be transparent or semitransparent even if formed from a metal or metal alloy.
In a preferred embodiment, the cathode layer comprises a metal or metal alloy and is transparent.
It is to be understood that the cathode layer is not part of an electron injection layer or the electron transport layer.

## Description of the Drawings

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.
Additional details, characteristics and advantages of the object of the invention are disclosed in the dependent claims and the following description of the respective figures which in an exemplary fashion show preferred embodiments according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.

FIG. 1 is a schematic sectional view of an organic electroluminescent device according to an exemplary embodiment of the present invention.
FIG. 2 is a schematic sectional view of a stacked organic electroluminescent device according to another exemplary embodiment of the present invention.
FIG. 3 is a schematic sectional view of a stacked organic electroluminescent device according to another exemplary embodiment of the present invention.
FIG. 4 is a schematic sectional view of a stacked organic electroluminescent device according to another exemplary embodiment of the present invention.
FIG. 5 is a schematic sectional view of a stacked organic electroluminescent device according to another exemplary embodiment of the present invention.
FIG. 6 is a schematic sectional view of a stacked organic electroluminescent device according to another exemplary embodiment of the present invention.
FIG. 7 is a schematic sectional view of a stacked organic electroluminescent device according to another exemplary embodiment of the present invention.
FIG. 8 is a schematic sectional view of a stacked organic electroluminescent device according to another exemplary embodiment of the present invention.
FIG. 9 is a schematic sectional view of a stacked organic electroluminescent device according to another exemplary embodiment of the present invention.
FIG. 10 is a schematic sectional view of a stacked organic electroluminescent device according to another exemplary embodiment of the present invention.
FIG. 11 is a schematic sectional view of a stacked organic electroluminescent device according to another exemplary

embodiment of the present invention.

FIG. 12 is a schematic sectional view of an anode layer 120 on a substrate 110.

Hereinafter, the figures are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

Fig. 1 is a schematic sectional view of an organic electroluminescent device 100, according to one exemplary embodiment of the present invention.

Referring to Fig. 1 the organic electroluminescent device 100 includes an anode layer 120, a first light-emitting unit 140, a first intermediate connecting region (ICR1) 150 comprising a first n-type charge generation layer (n-CGL1) 151, a first intermediate layer (IL1) 153, and a first p-type charge generation layer (p-CGL1) 152, wherein the n-type charge generation layer (n-CGL1) comprises an organic matrix compound and metal dopant, wherein the first intermediate layer (IL1) 153 comprises an organic electron transport compound, and the first n-type charge generation layer (n-CGL1) 151 comprises an organic matrix compound of formula (I).

wherein the first p-type charge generation layer (p-CGL1) 152 comprises a p-dopant or p-dopant and a hole transport matrix compound. The organic electroluminescent device 100 further comprises a second light-emitting unit 240, and a cathode layer (CAT) 190.

Referring to Fig. 2 the organic electroluminescent device 100 includes a substrate 110, an anode layer 120, a hole injection layer (HIL) 130 and a first light-emitting unit 140, comprising a first hole transport layer (HTL1) 141, a first electron blocking layer (EBL1) 142, a first emission layer (EML1) 143, a first hole blocking layer (HBL1) 144, and a first electron transport layer (ETL1) 145. The organic electroluminescent device 100 further comprising a first intermediate connecting region (ICR1) 150 comprising a first n-type charge generation layer (n-CGL1) 151, a first intermediate layer (IL1) 153, and a first p-type charge generation layer (p-GCL1) 152, wherein the n-type charge generation layer (n-CGL1) comprises a organic matrix compound and metal dopant, wherein the first intermediate layer (IL1) 153 comprises an organic electron transport compound, and wherein the first p-type charge generation layer (p-CGL1) 152 comprises a p-dopant or p-dopant and a hole transport matrix compound. The organic electronic device 100 further comprising, a second light-emitting unit 240, comprising a second hole transport layer (HTL2) 241, a second electron blocking layer (EBL2) 242, a second emission layer (EML2) 243, a second hole blocking layer (HBL2) 244, and a second electron transport layer (ETL2) 245. The organic electroluminescent device 100 further comprising and electron injection layer (EIL) 180, a cathode layer (CAT) 190.

Fig. 3 is a schematic sectional view of a stacked organic electroluminescent device 100, according to another exemplary embodiment of the present invention. Fig. 3 differs from Fig. 2 in that the organic electroluminescent device 100 of Fig. 3 further comprises a second intermediate connecting region (ICR2) 250 disposed on the second light-emitting unit 240, comprising a second n-type charge generation layer (n-CGL2) 251, a second intermediate layer (IL2) 253 and a second p-type charge generation layer (p-GCL2) 252, wherein the second n-type charge generation layer (n-CGL2) 251 may optionally comprise an organic matrix and a metal dopant compound, wherein the second intermediate layer (IL2) 253 may optionally also comprise an organic electron transport compound, and wherein the second p-type charge generation layer (p-CGL2) 252 may optionally also comprise a p-dopant and a hole transport matrix compound,. Wherein the organic electroluminescent device 100 of Fig. 3 further differs from Fig. 2 in that it further comprises a third light-emitting unit 340 disposed on the second intermediate connecting region (ICR2) 250, comprising a third hole transport layer (HTL3) 341, a third electron blocking layer (EBL3) 342, a third emission layer (EML3) 343, a third hole blocking layer (HBL3) 344, and a third electron transport layer (ETL3) 345.

Fig. 4 is a schematic sectional view of a stacked organic electroluminescent device 100, according to another exemplary embodiment of the present invention. Fig. 4 differs from Fig. 3 in that the organic electroluminescent device 100 of Fig. 4 further comprises a third intermediate connecting region (ICR3) 350 disposed on the third light-emitting unit 340, comprising a third n-type charge generation layer (n-CGL3) 351, a third intermediate layer (IL3) 353, and a third p-type charge generation layer (p-GCL3) 352, wherein the third n-type charge generation layer (n-CGL3) 351 may optionally also comprise an organic matrix compound and a metal dopant, wherein the third intermediate layer (IL3) 353 may optionally also comprise an organic electron transport compound, and wherein the third p-type charge generation layer (p-CGL3) 352 may optionally also comprise a p-dopant or p-dopant and a hole transport matrix compound . Wherein the organic electroluminescent device 100 of Fig. 4 further differs from Fig. 3 in that it further comprises a fourth light-emitting unit 440 disposed on the third intermediate connecting region (ICR3) 350, comprising a fourth hole transport layer (HTL4) 441, a fourth electron blocking layer (EBL4) 442, a fourth emission layer (EML4) 443, a fourth hole blocking layer (HBL4) 444, and a fourth electron transport layer (ETL4) 445.

Fig. 5 is a schematic sectional view of an organic electroluminescent device 100, according to one exemplary

embodiment of the present invention.

Referring to Fig. 5 the organic electroluminescent device 100 includes a substrate 110, an anode layer 120, a hole injection layer (HIL) 130 and a first light-emitting unit 140, comprising a first hole transport layer (HTL1) 141, a first electron blocking layer (EBL1) 142, a first emission layer (EML1) 143, a first hole blocking layer (HBL1) 144, and a first electron transport layer (ETL1) 145. The organic electroluminescent device 100 further comprising an n-type charge generation layer 161, and a p-type charge generation layer 162. The organic electroluminescent device 100 further comprising, a second light-emitting unit 240, comprising a second hole transport layer (HTL2) 241, a second electron blocking layer (EBL2) 242, a second emission layer (EML2) 243, a second hole blocking layer (HBL2) 244, and a second electron transport layer (ETL2) 245.

The organic electroluminescent device 100 further comprises a first intermediate connecting region (ICR1) disposed on the second light-emitting unit 240, comprising a n-type first charge generation layer (n-CGL1) 151 of the first intermediate connecting region, a first intermediate layer (IL1) 153 and a first p-type charge generation layer (p-CGL1) 152 of the first intermediate connecting region, wherein the first n-type charge generation layer (n-CGL1) 151 of the first intermediate connecting region comprises an organic matrix compound and metal dopant, wherein the first intermediate layer (IL1) 153 comprises an organic electron transport compound, and wherein the first p-type charge generation layer (p-CGL1) 152 of the first intermediate connecting region comprises a p-dopant or p-dopant and a hole transport matrix compound.

The organic electroluminescent device 100 further comprises a third light-emitting unit 340 disposed on the first intermediate connecting region (ICR1) 150, comprising a third hole transport layer (HTL3) 341, a third electron blocking layer (EBL3) 342, a third emission layer (EML3) 343, a third hole blocking layer (HBL3) 344, and a third electron transport layer (ETL3) 345.

The organic electroluminescent device 100 further comprising and electron injection layer (EIL) 180, a cathode layer (CAT) 190.

Fig. 6 is a schematic sectional view of an organic electroluminescent device 100, according to one exemplary embodiment of the present invention.

Referring to Fig. 6 the organic electroluminescent device 100 includes a substrate 110, an anode layer 120, a hole injection layer (HIL) 130 and a first light-emitting unit 140, comprising a first hole transport layer (HTL1) 141, a first electron blocking layer (EBL1) 142, a first emission layer (EML1) 143, a first hole blocking layer (HBL1) 144, and a first electron transport layer (ETL1) 145. The organic electroluminescent device 100 further comprising a first intermediate connecting region (ICR1), disposed on the first light-emitting unit 140, comprising a first n-type charge generation layer (n-CGL1) 151 of the first intermediate connecting region, a first intermediate layer (IL1) 153, and a first p-type charge generation layer (p-GCL1) 152 of the first intermediate connecting region, wherein the first n-type charge generation layer (n-CGL1) 151 of the first intermediate connecting region comprises an organic matrix compound and metal dopant, wherein the first intermediate layer (IL1) 153 comprises an organic electron transport compound, and wherein the first p-type charge generation layer (p-CGL1) 152 of the first intermediate connecting region comprises a p-dopant or p-dopant and a hole transport matrix compound.

The organic electroluminescent device 100 further comprising, a second light-emitting unit 240 disposed on the first intermediate connecting region (ICR1) 150, comprising a second hole transport layer (HTL2) 241, a second electron blocking layer (EBL2) 242, a second emission layer (EML2) 243, a second hole blocking layer (HBL2) 244, and a second electron transport layer (ETL2) 245.

The organic electroluminescent device 100 further comprises an n-type charge generation layer 161 disposed on the second light-emitting unit 240. A p-type charge generation layer 162 disposed on the n-type charge generation layer 161

The organic electroluminescent device 100 further comprises a third light-emitting unit 340 disposed on the p-type charge generation layer 162, comprising a third hole transport layer (HTL3) 341, a third electron blocking layer (EBL3) 342, a third emission layer (EML3) 343, a third hole blocking layer (HBL3) 344, and a third electron transport layer (ETL3) 345.

The organic electroluminescent device 100 further comprising and electron injection layer (EIL) 180, a cathode layer (CAT) 190.

Fig. 7 is a schematic sectional view of an organic electroluminescent device 100, according to one exemplary embodiment of the present invention.

Referring to Fig. 7 the organic electroluminescent device 100 includes a substrate 110, an anode layer 120, a hole injection layer (HIL) 130, and a first light-emitting unit 140, comprising a first hole transport layer (HTL1) 141, a first electron blocking layer (EBL1) 142, a first emission layer (EML1) 143, a first hole blocking layer (HBL1) 144, and a first electron transport layer (ETL1) 145. The organic electroluminescent device 100 further comprising an n-type charge generation layer 161, and a p-type charge generation layer 162. The organic electroluminescent device 100 further comprising, a second light-emitting unit 240, comprising a second hole transport layer (HTL2) 241, a second electron blocking layer (EBL2) 242, a second emission layer (EML2) 243, a second hole blocking layer (HBL2) 244, and a second

electron transport layer (ETL2) 245.

The organic electroluminescent device 100 further comprises a first intermediate connecting region (ICR1) 150 disposed on the second light-emitting unit 240, comprising a n-type first charge generation layer (n-CGL1) 151 of the first intermediate connecting region, a first intermediate layer (IL1) 153 and a first p-type charge generation layer (p-CGL1) 152 of the first intermediate connecting region, wherein the first n-type charge generation layer (n-CGL1) 151 of the first intermediate connecting region comprises an organic matrix compound and metal dopant, wherein the first intermediate layer (IL1) 153 comprises an organic electron transport compound, and wherein the first p-type charge generation layer (p-CGL1) 152 of the first intermediate connecting region comprises a p-dopant or p-dopant and a hole transport matrix compound.

The organic electroluminescent device 100 further comprises a third light-emitting unit 340 disposed on the first intermediate connecting region (ICR1) 150, comprising a third hole transport layer (HTL3) 341, a third electron blocking layer (EBL3) 342, a third emission layer (EML3) 343, a third hole blocking layer (HBL3) 344, and a third electron transport layer (ETL3) 345.

The organic electroluminescent device 100 further comprises a second intermediate connecting region (ICR2) 250 disposed on the third light-emitting unit 340, comprising a n-type second charge generation layer (n-CGL2) 251 of the second intermediate connecting region, a second intermediate layer (IL2) 253 and a second p-type charge generation layer (p-CGL2) 252 of the second intermediate connecting region, wherein the second n-type charge generation layer (n-CGL2) 251 of the second intermediate connecting region may optionally also comprises an organic matrix compound and metal dopant, wherein the second intermediate layer (IL2) 253 may optionally also comprises an organic electron transport material, and wherein the second p-type charge generation layer (p-CGL2) 252 of the second intermediate connecting region may optionally also comprises a p-dopant or p-dopant and a hole transport matrix compound.

The organic electroluminescent device 100 further comprises a fourth light-emitting unit 440 disposed on the second intermediate connecting region (ICR2) 250, comprising a fourth hole transport layer (HTL4) 441, a fourth electron blocking layer (EBL4) 442, a fourth emission layer (EML4) 443, a fourth hole blocking layer (HBL4) 444, and a fourth electron transport layer (ETL4) 445.

The organic electroluminescent device 100 further comprising and electron injection layer (EIL) 180, a cathode layer (CAT) 190.

Fig. 8 is a schematic sectional view of an organic electroluminescent device 100, according to one exemplary embodiment of the present invention.

Referring to Fig. 8 the organic electroluminescent device 100 includes a substrate 110, an anode layer 120, a hole injection layer (HIL) 130 and a first light-emitting unit 140, comprising a first hole transport layer (HTL1) 141, a first electron blocking layer (EBL1) 142, a first emission layer (EML1) 143, a first hole blocking layer (HBL1) 144, and a first electron transport layer (ETL1) 145.

The organic electroluminescent device 100 further comprising a first intermediate connecting region (ICR1) 150 disposed on the first light-emitting unit 140, comprising a n-type first charge generation layer (n-CGL1) 151 of the first intermediate connecting region, a first intermediate layer (IL1) 153 and a first p-type charge generation layer (p-CGL1) 152 of the first intermediate connecting region, wherein the first n-type charge generation layer (n-CGL1) 151 of the first intermediate connecting region comprises an organic matrix compound and metal dopant, wherein the first intermediate layer (IL1) 153 comprises an organic electron transport compound, and wherein the first p-type charge generation layer (p-CGL1) 152 of the first intermediate connecting region comprises a p-dopant or p-dopant and a hole transport matrix compound.

The organic electroluminescent device 100 further comprising, a second light-emitting unit 240, disposed on the first intermediate connecting region (ICR1) 150, comprising a second hole transport layer (HTL2) 241, a second electron blocking layer (EBL2) 242, a second emission layer (EML2) 243, a second hole blocking layer (HBL2) 244, and a second electron transport layer (ETL2) 245.

The organic electroluminescent device 100 further comprises an n-type charge generation layer 161, and a p-type charge generation layer 162.

The organic electroluminescent device 100 further comprises a third light-emitting unit 340 disposed on the p-type charge generation layer 162, comprising a third hole transport layer (HTL3) 341, a third electron blocking layer (EBL3) 342, a third emission layer (EML3) 343, a third hole blocking layer (HBL3) 344, and a third electron transport layer (ETL3) 345.

The organic electroluminescent device 100 further comprises a second intermediate connecting region (ICR2) 250 disposed on the third light-emitting unit 340, comprising a n-type second charge generation layer (n-CGL2) 251 of the second intermediate connecting region, a second intermediate layer (IL2) 253 and a second p-type charge generation layer (p-CGL2) 252 of the second intermediate connecting region, wherein the second n-type charge generation layer (n-CGL2) 251 of the second intermediate connecting region may optionally also comprises an organic matrix compound and metal dopant, wherein the second intermediate layer (IL2) 253 may optionally also comprises an organic electron transport compound, and wherein the second p-type charge generation layer (p-CGL3) 252 of the second intermediate

connecting region may optionally also comprises a p-dopant or p-dopant and a hole transport matrix compound.

The organic electroluminescent device 100 further comprises a fourth light-emitting unit 440 disposed on the second intermediate connecting region (ICR2) 250, comprising a fourth hole transport layer (HTL4) 441, a fourth electron blocking layer (EBL4) 442, a fourth emission layer (EML4) 443, a fourth hole blocking layer (HBL4) 444, and a fourth electron transport layer (ETL4) 445.

The organic electroluminescent device 100 further comprising and electron injection layer (EIL) 180, a cathode layer (CAT) 190.

Fig. 9 is a schematic sectional view of an organic electroluminescent device 100, according to one exemplary embodiment of the present invention.

Referring to Fig. 9 the organic electroluminescent device 100 includes a substrate 110, an anode layer 120, a hole injection layer (HIL) 130, and a first light-emitting unit 140, comprising a first hole transport layer (HTL1) 141, a first electron blocking layer (EBL1) 142, a first emission layer (EML1) 143, a first hole blocking layer (HBL1) 144, and a first electron transport layer (ETL1) 145.

The organic electroluminescent device 100 further comprising a first intermediate connecting region (ICR1) 150 disposed on the first light-emitting unit 140, comprising a n-type first charge generation layer (n-CGL1) 151 of the first intermediate connecting region, a first intermediate layer (II,1) 153 and a first p-type charge generation layer (p-CGL1) 152 of the first intermediate connecting region, wherein the first n-type charge generation layer (n-CGL1) 151 of the first intermediate connecting region comprises an organic matrix compound and metal dopant, wherein the first intermediate layer (IL1) 153 comprises an organic electron transport compound, and wherein the first p-type charge generation layer (p-CGL1) 152 of the first intermediate connecting region comprises a p-dopant or p-dopant and a hole transport matrix compound.

The organic electroluminescent device 100 further comprising, a second light-emitting unit 240, disposed on the first intermediate connecting region (ICR1) 150, comprising a second hole transport layer (HTL2) 241, a second electron blocking layer (EBL2) 242, a second emission layer (EML2) 243, a second hole blocking layer (HBL2) 244, and a second electron transport layer (ETL2) 245.

The organic electroluminescent device 100 further comprises a second intermediate connecting region (ICR2) 250 disposed on the second light-emitting unit 240, comprising a n-type second charge generation layer (n-CGL2) 251 of the second intermediate connecting region, a second intermediate layer (IL2) 253 and a second p-type charge generation layer (p-CGL2) 252 of the second intermediate connecting region, wherein the second n-type charge generation layer (n-CGL2) 251 of the second intermediate connecting region may optionally also comprises an organic matrix compound and metal dopant, wherein the second intermediate layer (IL2) 253 may optionally also comprises an organic electron transport compound, and wherein the second p-type charge generation layer (p-CGL3) 252 of the second intermediate connecting region may optionally also comprises a p-dopant or p-dopant and a hole transport matrix compound.

The organic electroluminescent device 100 further comprises a third light-emitting unit 340 disposed on the second intermediate connecting region (ICR2) 250, comprising a third hole transport layer (HTL3) 341, a third electron blocking layer (EBL3) 342, a third emission layer (EML3) 343, a third hole blocking layer (HBL3) 344, and a third electron transport layer (ETL3) 345.

The organic electroluminescent device 100 further comprises an n-type charge generation layer 161, and a p-type charge generation layer 162.

The organic electroluminescent device 100 further comprises a fourth light-emitting unit 440 disposed on p-type charge generation layer 162, comprising a fourth hole transport layer (HTL4) 441, a fourth electron blocking layer (EBL4) 442, a fourth emission layer (EML4) 443, a fourth hole blocking layer (HBL4) 444, and a fourth electron transport layer (ETL4) 445.

The organic electroluminescent device 100 further comprising and electron injection layer (EIL) 180, a cathode layer (CAT) 190.

Fig. 10 is a schematic sectional view of an organic electroluminescent device 100, according to one exemplary embodiment of the present invention.

Referring to Fig. 10 the organic electroluminescent device 100 includes a substrate 110, an anode layer 120, a hole injection layer (HIL) 130, and a first light-emitting unit 140, comprising a first hole transport layer (HTL1) 141, a first electron blocking layer (EBL1) 142, a first emission layer (EML1) 143, a first hole blocking layer (HBL1) 144, and a first electron transport layer (ETL1) 145.

The organic electroluminescent device 100 further comprising an n-type charge generation layer 161, and a p-type charge generation layer 162.

The organic electroluminescent device 100 further comprising, a second light-emitting unit 240, disposed on the p-type charge generation layer 162, comprising a second hole transport layer (HTL2) 241, a second electron blocking layer (EBL2) 242, a second emission layer (EML2) 243, a second hole blocking layer (HBL2) 244, and a second electron transport layer (ETL2) 245.

The organic electroluminescent device 100 further an n-type charge generation layer 261, and a p-type charge generation layer 262.

The organic electroluminescent device 100 further comprises a third light-emitting unit 340 disposed on the p-type charge generation layer 262, comprising a third hole transport layer (HTL3) 341, a third electron blocking layer (EBL3) 342, a third emission layer (EML3) 343, a third hole blocking layer (HBL3) 344, and a third electron transport layer (ETL3) 345.

The organic electroluminescent device 100 further comprises a first intermediate connecting region (ICR1) 150 disposed on the third light-emitting unit 340, comprising a n-type first charge generation layer (n-CGL1) 151 of the first intermediate connecting region, a first intermediate layer (IL1) 153 and a first p-type charge generation layer (p-CGL1) 152 of the first intermediate connecting region, wherein the first n-type charge generation layer (n-CGL1) 151 of the first intermediate connecting region comprises an organic matrix compound and metal dopant, wherein the first intermediate layer (IL1) 153 comprises an organic electron transport material, and wherein the first p-type charge generation layer (p-CGL1) 152 of the first intermediate connecting region comprises a p-dopant or p-dopant and a hole transport matrix compound.

The organic electroluminescent device 100 further comprises a fourth light-emitting unit 440 disposed on the first intermediate connecting region (ICR1) 150, comprising a fourth hole transport layer (HTL4) 441, a fourth electron blocking layer (EBL4) 442, a fourth emission layer (EML4) 443, a fourth hole blocking layer (HBL4) 444, and a fourth electron transport layer (ETL4) 445.

The organic electroluminescent device 100 further comprising and electron injection layer (EIL) 180, a cathode layer (CAT) 190.

Fig. 11 is a schematic sectional view of an organic electroluminescent device 100, according to one exemplary embodiment of the present invention.

Referring to Fig. 11 the organic electroluminescent device 100 includes a substrate 110, an anode layer 120, a hole injection layer (HIL) 130, and a first light-emitting unit 140, comprising a first hole transport layer (HTL1) 141, a first electron blocking layer (EBL1) 142, a first emission layer (EML1) 143, a first hole blocking layer (HBL1) 144, and a first electron transport layer (ETL1) 145.

The organic electroluminescent device 100 further comprising a first intermediate connecting region (ICR1) 150 disposed on the first light-emitting unit 140, comprising a n-type first charge generation layer (n-CGL1) 151 of the first intermediate connecting region, a first intermediate layer (IL1) 153 and a first p-type charge generation layer (p-CGL1) 152 of the first intermediate connecting region, wherein the first n-type charge generation layer (n-CGL1) 151 of the first intermediate connecting region comprises an organic matrix compound and metal dopant, wherein the first intermediate layer (IL1) 153 comprises an organic electron transport compound, and wherein the first p-type charge generation layer (p-CGL1) 152 of the first intermediate connecting region comprises a p-dopant or p-dopant and a hole transport matrix compound.

The organic electroluminescent device 100 further comprising, a second light-emitting unit 240, disposed on the first intermediate connecting region (ICR1) 150, comprising a second hole transport layer (HTL2) 241, a second electron blocking layer (EBL2) 242, a second emission layer (EML2) 243, a second hole blocking layer (HBL2) 244, and a second electron transport layer (ETL2) 245.

The organic electroluminescent device 100 further comprises an n-type charge generation layer 161, and a p-type charge generation layer 162.

The organic electroluminescent device 100 further comprises a third light-emitting unit 340 disposed on the p-type charge generation layer 162, comprising a third hole transport layer (HTL3) 341, a third electron blocking layer (EBL3) 342, a third emission layer (EML3) 343, a third hole blocking layer (HBL3) 344, and a third electron transport layer (ETL3) 345.

The organic electroluminescent device 100 further comprises an n-type charge generation layer 261, and a p-type charge generation layer 262.

The organic electroluminescent device 100 further comprises a fourth light-emitting unit 440 disposed on the p-type charge generation layer 262, comprising a fourth hole transport layer (HTL4) 441, a fourth electron blocking layer (EBL4) 442, a fourth emission layer (EML4) 443, a fourth hole blocking layer (HBL4) 444, and a fourth electron transport layer (ETL4) 445.

The organic electroluminescent device 100 further comprising and electron injection layer (EIL) 180, a cathode layer (CAT) 190.

Fig. 12 is a schematic sectional view of an organic electroluminescent device 100, according to one exemplary embodiment of the present invention.

Referring to Fig. 12 the organic electroluminescent device 100 includes a substrate 110, an anode layer 120, a hole injection layer (HIL) 130, and a first light-emitting unit 140, comprising a first hole transport layer (HTL1) 141, a first electron blocking layer (EBL1) 142, a first emission layer (EML1) 143, a first hole blocking layer (HBL1) 144, and a first electron transport layer (ETL1) 145.

The organic electroluminescent device 100 further comprising an n-type charge generation layer 161, and a p-type charge generation layer 162.

The organic electroluminescent device 100 further comprising, a second light-emitting unit 240, disposed on the p-type charge generation layer 162, comprising a second hole transport layer (HTL2) 241, a second electron blocking layer (EBL2) 242, a second emission layer (EML2) 243, a second hole blocking layer (HBL2) 244, and a second electron transport layer (ETL2) 245.

The organic electroluminescent device 100 further comprises a first intermediate connecting region (ICR1) 150 disposed on the second light-emitting unit 240, comprising a n-type first charge generation layer (n-CGL1) 151 of the first intermediate connecting region, a first intermediate layer (IL1) 153 and a first p-type charge generation layer (p-CGL1) 152 of the first intermediate connecting region, wherein the first n-type charge generation layer (n-CGL1) 151 of the first intermediate connecting region comprises an organic matrix compound and metal dopant, wherein the first intermediate layer (IL1) 153 comprises an organic electron transport compound, and wherein the first p-type charge generation layer (p-CGL1) 152 of the first intermediate connecting region comprises a p-dopant or p-dopant and a hole transport matrix compound.

The organic electroluminescent device 100 further comprises a third light-emitting unit 340 disposed on the intermediate connecting region(ICR1) 150, comprising a third hole transport layer (HTL3) 341, a third electron blocking layer (EBL3) 342, a third emission layer (EML3) 343, a third hole blocking layer (HBL3) 344, and a third electron transport layer (ETL3) 345.

The organic electroluminescent device 100 further comprises an n-type charge generation layer 261, and a p-type charge generation layer 262.

The organic electroluminescent device 100 further comprises a fourth light-emitting unit 440 disposed on p-type charge generation layer 262, comprising a fourth hole transport layer (HTL4) 441, a fourth electron blocking layer (EBL4) 442, a fourth emission layer (EML4) 443, a fourth hole blocking layer (HBL4) 444, and a fourth electron transport layer (ETL4) 445.

The organic electroluminescent device 100 further comprising and electron injection layer (EIL) 180, a cathode layer (CAT) 190.

Hereinafter, one or more exemplary embodiments of the present invention will be described in detail with, reference to the following examples. However, these examples are not intended to limit the purpose and scope of the one or more exemplary embodiments of the present invention.

**Detailed description**

The invention is furthermore illustrated by the following examples which are illustrative only and non-binding.

Calculated HOMO and LUMO

The HOMO and LUMO are calculated with the program package TURBOMOLE V6.5 (TURBOMOLE GmbH, Litzenhardtstrasse 19, 76135 Karlsruhe, Germany). The optimized geometries and the HOMO and LUMO energy levels of the molecular structures are determined by applying the hybrid functional B3LYP with a 6-31G* basis set in the gas phase. If more than one conformation is viable, the conformation with the lowest total energy is selected.

Table 1 shows the LUMO, HOMO and T1-levels for selected compounds of formula (I) as well as one comparative compound (Bphen = Bathophenanthroline, 4,7-Diphenyl-1,10-phenanthroline).

Table 1: LUMO, HOMO and T1-levels for selected compounds

| Compound | LUMO | HOMO | T1 |
|---|---|---|---|
| Bphen (comparative) | -1.46 | -5.97 | 2.72 |
| A1 | -1.75 | -5.62 | 2.46 |
| A2 | -1.73 | -4.87 | 2.25 |
| A3 | -1.54 | -4.92 | 2.29 |
| A4 | -1.84 | -5.48 | 2.38 |
| A5 | -1.72 | -5.49 | 2.29 |
| A6 | -1.71 | -5.79 | 2.71 |
| A7 | -1.59 | -5.48 | 2.3 |

(continued)

| Compound | LUMO | HOMO | T1 |
|---|---|---|---|
| A8 | -1.82 | -4.94 | --- |
| A9 | -1.64 | -5.64 | 2.56 |
| A10 | -1.68 | -5.00 | --- |
| A11 | -1.72 | -5.50 | 2.62 |
| A12 | -1.64 | -5.12 | 2.05 |
| A13 | -1-75 | -5.16 | 2.03 |
| A14 | -1.75 | -5.57 | 2.30 |
| A15 | -1.87 | -5.47 | 2.37 |
| A16 | -1.67 | -5.54 | 2.51 |
| A17 | -1.61 | -5.59 | 2.55 |
| A18 | -1.79 | -5.70 | 2.30 |
| A19 | -1.67 | -5.58 | 2.30 |
| A20 | -1.75 | -5.66 | --- |
| A21 | -1.93 | -5.89 | 2.76 |
| A22 | -1.89 | -5.26 | 2.60 |
| A23 | -1.83 | -5.71 | 2.29 |

General procedure for fabrication of OLEDs

For the examples according to the invention and comparative examples in Table 2, a glass substrate with an anode layer comprising a first anode sub-layer of 10 nm ITO, a second anode sub-layer of 120 nm Ag and a third anode sub-layer of 8 nm ITO was cut to a size of 100 mm x 100 mm x 0.7 mm, ultrasonically washed with water for 60 minutes and then with isopropanol for 20 minutes. The liquid film was removed in a nitrogen stream, followed by plasma treatment, see Table 2, to prepare the anode layer. The plasma treatment was performed in an atmosphere comprising 97.6 vol.-% nitrogen and 2.4 vol.-% oxygen.

Then N-([1,1'-biphenyl]-4-yl)-9,9-dimethyl-N-(4-(9-phenyl-9H-carbazol-3-yl)phenyl)-9H-fluoren-2-amine (compound H3) was vacuum deposited with 2 wt.-% 2,2',2"-(cyclopropane-1,2,3-triylidene)tris(2-(p-cyanotetrafluorophenyl)acetonitrile)to form a hole injection layer having a thickness 10 nm.

Then N-([1,1'-biphenyl]-4-yl)-9,9-dimethyl-N-(4-(9-phenyl-9H-carbazol-3-yl)phenyl)-9H-fluoren-2-amine (compound H3) was vacuum deposited, to form a first hole transport layer having a thickness of 28 nm

Then N-([1,1'-biphenyl]-4-yl)-9,9-diphenyl-N-(4-(triphenylsilyl)phenyl)-9H-fluoren-2-amine was vacuum deposited on the HTL, to form an electron blocking layer (EBL) having a thickness of 5 nm.

Then 97 wt.-% H09 (Sun Fine Chemicals, Korea) as EML host and 3 wt.-% BD200 (Sun Fine Chemicals, Korea) as fluorescent blue dopant were deposited on the EBL, to form a first blue-emitting emission layer (EML) with a thickness of 19 nm.

Then, the first electron transporting layer (ETL1) having a thickness of 15 nm is formed on first emission layer by depositing (3-(10-(3-(2,6-diphenylpyrimidin-4-yl)phenyl)anthracen-9-yl)phenyl)dimethylphosphine oxide. The first electron transporting layer is free of 8-Hydroxyquinolinolato-lithium.

Then an n-type CGL (n-type charge generation layer) having a thickness of 10 nm is formed on the ETL1 by co-depositing 90.1 wt.-% of an organic matrix compound according to Table 2 and 9.87 wt.-%Yb.

Then an intermediate layer having a thickness of 1 to 2 nm is formed on the n-type CGL by depositing of an organic electron transport compound according to Table 2.

Then a p-type CGL having a thickness of 10 nm is formed on the n-type CGL by co-depositing N-([1,1'-biphenyl]-4-yl)-9,9-dimethyl-N-(4-(9-phenyl-9H-carbazol-3-yl)phenyl)-9H-fluoren-2-amine with 10 wt% 2,2',2"-(cyclopropane-1,2,3-triylidene)tris(2-(p-cyanotetrafluorophenyl)acetonitrile) as organic p-dopant.

Then a second hole transport layer having a thickness of 40 nm is formed on the first p-type CGL by depositing N-([1,1'-biphenyl]-4-yl)-9,9-dimethyl-N-(4-(9-phenyl-9H-carbazol-3-yl)phenyl)-9H-fluoren-2-amine (compound H3).

Then a second electron blocking layer having a thickness of 5 nm is formed on the second hole transport layer by depositing N-([1,1'-biphenyl]-4-yl)-9,9-diphenyl-N-(4-(triphenylsilyl)phenyl)-9H-fluoren-2-amine.

Then 97 wt.-% H09 (Sun Fine Chemicals, Korea) as EML host and 3 wt.-% BD200 (Sun Fine Chemicals, Korea) as fluorescent blue dopant were deposited on the second EBL, to form a second blue-emitting EML with a thickness of 19 nm.

Then 2-(3'-(9,9-dimethyl-9H-fluoren-2-yl)-[1,1'-biphenyl]-3-yl)-4,6-diphenyl-1,3,5-triazine was vacuum deposited to form a first hole blocking layer having a thickness of 5 nm is formed on the second blue-emitting EML.

Then, 50 wt.-% 4'-(4-(4-(4,6-diphenyl-1,3,5-triazin-2-yl)phenyl)naphthalen-1-yl)-[1,1'-biphenyl]-4-carbonitrile and 50 wt.-% LiQ were vacuum deposited on the first hole blocking layer to form a second electron transport layer having a thickness of 31 nm.

Then Yb was evaporated at a rate of 0.01 to 1 Å/s at $10^{-7}$ mbar to form an electron injection layer with a thickness of 2 nm on the electron transporting layer.

Ag/Mg (10wt% of Mg) is evaporated at a rate of 0.01 to 1 Å/s at $10^{-7}$ mbar to form a cathode with a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} (compound H3) was vacuum deposited on the cathode layer to form a capping layer with a thickness of 75 nm.

To assess the performance of the inventive examples compared to the prior art, the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0. 1V in the range between 0V and 10V. Likewise, the luminance-voltage characteristics and CIE coordinates are determined by measuring the luminance in cd/m$^2$ using an Instrument Systems CAS-140CT array spectrometer (calibrated by Deutsche Akkreditierungsstelle (DAkkS)) for each of the voltage values. The cd/A efficiency at 15 mA/cm2 is determined by interpolating the luminance-voltage and current-voltage characteristics, respectively.

In bottom emission devices, the emission is predominately Lambertian and quantified in percent external quantum efficiency (EQE). To determine the efficiency EQE in % the light output of the device is measured using a calibrated photodiode at 15 mA/cm2.

In top emission devices, the emission is forward directed, non-Lambertian and also highly dependent on the mirco-cavity. Therefore, the efficiency EQE will be higher compared to bottom emission devices. To determine the efficiency EQE in % the light output of the device is measured using a calibrated photodiode at 15 mA/cm$^2$.

Lifetime LT of the device is measured at 85°C and 30 mA/cm$^2$, using a Keithley 2400 sourcemeter, and recorded in hours.

The brightness of the device is measured using a calibrated photo diode. The lifetime LT is defined as the time till the brightness of the device is reduced to 97 % of its initial value.

The increase in operating voltage ΔU is used as a measure of the operational voltage stability of the device. This increase is determined during the LT measurement and by subtracting the operating voltage after 1 hour after the start of operation of the device from the operating voltage after 100 hours.

$$\Delta U=[U100\ h)-\ U(1h)].$$

The smaller the value of ΔU the better is the operating voltage stability.

**Technical Effect of the invention**

Table 2 shows the setup and several properties of comparative and inventive devices:

Table 2: Setup and several properties of comparative and inventive devices

| | **n-type charge generation layer** | **Intermediate layer** | **CIE-y** | **Operational Voltage [V]** | **LT97 85 °C at 30mA/cm$^2$** | **Vrise(ΔU) [V at 30mA/cm$^2$] 85°C (100-1h)** |
|---|---|---|---|---|---|---|
| Comparative example 1 | BPhen | BPhen | 0.052 | 7.24 | 2.2 | >10 |
| Comparative example 2 | A1 | BPhen | 0.053 | 7.19 | 17 | 1.817 |

(continued)

| | n-type charge generation layer | Intermediate layer | CIE-y | Operational Voltage [V] | LT97 85 °C at 30mA/cm$^2$ | Vrise(△U) [V at 30mA/cm$^2$] 85°C (100-1h) |
|---|---|---|---|---|---|---|
| Inventive Example 1 | A1 | A1 | 0.051 | 7.07 | 19 | 0.122 |
| Inventive Example 2 | A4 | A4 | 0.05 | 6.98 | 19 | 0.124 |
| Inventive Example 3 | A8 | A8 | 0.051 | 6.97 | 18 | 0.146 |
| Inventive Example 4 | A5 | A5 | 0.05 | 7.02 | 19 | 0.138 |
| Inventive Example 5 | A2 | A2 | 0.051 | 6.98 | 18 | 0.145 |
| Inventive Example 6 | A7 | A7 | 0.051 | 7.07 | 20 | 0.128 |
| Inventive Example 7 | A6 | A6 | 0.051 | 6.96 | 18 | 0.114 |
| Inventive Example 8 | A3 | A3 | 0.051 | 6.98 | 18 | 0.160 |

Comparative example 1 is an OLED device comprising among others Bathophenanthroline (Bphen) as organic matrix compound and Ytterbium as metal dopant in the n-type charge generation layer and Bathophenanthroline (Bphen) as intermediate layer.

Comparative example 2 is an OLED device comprising A1 as organic matrix compound and Ytterbium as metal dopant in the n-type charge generation layer and Bathophenanthroline (Bphen) as intermediate layer. Comparative example 2 differs from comparative example 1 in that A1 is used as organic matrix compound in the n-type charge generation layer.

In inventive example 1, instead of Bathophenanthroline (Bphen) as organic matrix compound, and Bathophenanthroline (Bphen) as intermediate layer in comparative example 1, A1 is used as organic matrix compound and A1 as intermediate layer.

In inventive example 2, instead of Bathophenanthroline (Bphen) as organic matrix compound, and Bathophenanthroline (Bphen) as intermediate layer in comparative example 1, A4 is used as organic matrix compound and A4 as intermediate layer.

In inventive example 3, instead of Bathophenanthroline (Bphen) as organic matrix compound, and Bathophenanthroline (Bphen) as intermediate layer in comparative example 1, A8 is used as organic matrix compound and A8 as intermediate layer.

In inventive example 4, instead of Bathophenanthroline (Bphen) as organic matrix compound, and Bathophenanthroline (Bphen) as intermediate layer in comparative example 1, A5 is used as organic matrix compound and A5as intermediate layer.

In inventive example 5, instead of Bathophenanthroline (Bphen) as organic matrix compound, and Bathophenanthroline (Bphen) as intermediate layer in comparative example 1, A2 is used as organic matrix compound and A2 as intermediate layer.

In inventive example 6, instead of Bathophenanthroline (Bphen) as organic matrix compound, and Bathophenanthroline (Bphen) as intermediate layer in comparative example 1, A7 is used as organic matrix compound and A7 as intermediate layer.

In inventive example 7, instead of Bathophenanthroline (Bphen) as organic matrix compound, and Bathophenanthroline (Bphen) as intermediate layer in comparative example 1, A6 is used as organic matrix compound and A6 as intermediate layer.

In inventive example 8, instead of Bathophenanthroline (Bphen) as organic matrix compound, and Bathophenanthroline (Bphen) as intermediate layer in comparative example 1, A3 is used as organic matrix compound and A3 as intermediate layer.

The device of the comparative example 1 exhibits an operational voltage of 7.37 V, and a high increase of the operational voltage over time (Vrise) of >10 V at 85°C. Moreover, the measurement of the life time at 85°C shows that the device reached LT97 already at approximately 2.2 h

The device of the comparative example 2 exhibits an operational voltage of 7.19 V, a high increase of the operational voltage over time (Vrise) of 1.817 V at 85°C, and a life time at 85°C of 17h. Thus, the stability of the device of the comparative example 2 is still not sufficient.

The device of the inventive example 1 exhibits an operational voltage of 7.07 V, and a very low increase of the operational voltage over time (Vrise) of 0.122 V at 85°C, and a life time at 85°C of 19h.

The device of the inventive example 2 exhibits an operational voltage of 6.98 V, and a very low increase of the operational voltage over time (Vrise) of 0.124 V at 85°C, and a life time at 85°C of 19h.

The device of the inventive example 3 exhibits an operational voltage of 6.97 V, and a very low increase of the operational voltage over time (Vrise) of 0.146 V at 85°C, and a life time at 85°C of 18h.

The device of the inventive example 4 exhibits an operational voltage of 7.02 V, and a very low increase of the operational voltage over time (Vrise) of 0.145 V at 85°C, and a life time at 85°C of 19h.

The device of the inventive example 5 exhibits an operational voltage of 6.98 V, and a very low increase of the operational voltage over time (Vrise) of 0.138 V at 85°C, and a life time at 85°C of 18h.

The device of the inventive example 6 exhibits an operational voltage of 7.07 V, and a very low increase of the operational voltage over time (Vrise) of 0.128 V at 85°C, and a life time at 85°C of 20h.

The device of the inventive example 7 exhibits an operational voltage of 6.96 V, and a very low increase of the operational voltage over time (Vrise) of 0.114 V at 85°C, and a life time at 85°C of 18h.

The device of the inventive example 8 exhibits an operational voltage of 6.98 V, and a very low increase of the operational voltage over time (Vrise) of 0.160 V at 85°C, and a life time at 85°C of 18h.

All device according to the inventive examples exhibit a lower operational voltage, a lower operational voltage over time (Vrise) and a higher life time than the comparative example 1 and even the comparative example 2. Thus, using an organic matrix compound of formula (I) and an organic electron transport compound of formula leads to a synergistic improvement of the stability of the device, i.e. to a reduction of the operational voltage over time and an increase of the life time at elevated temperature.

A lower operating voltage may be important for the battery life of organic electronic devices, in particular mobile devices.

A long lifetime may result in improved long-term stability of electronic devices.

A low voltage rise over time may result in improved long-term stability of electronic devices.

The particular combinations of elements and features in the above detailed embodiments are exemplary only; the interchanging and substitution of these teachings with other teachings in this and the patents/applications incorporated by reference are also expressly contemplated. As those skilled in the art will recognize, variations, modifications, and other implementations of what is described herein can occur to those of ordinary skill in the art without departing from the spirit and the scope of the invention as claimed. Accordingly, the foregoing description is by way of example only and is not intended as limiting. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. The invention’s scope is defined in the following claims and the equivalents thereto. Furthermore, reference signs used in the description and claims do not limit the scope of the invention as claimed.

## Claims

**1.** An organic electroluminescent device comprising an anode layer, a cathode layer, a first light-emitting unit, a second light-emitting unit and at least one intermediate connecting region, wherein the at least one intermediate connecting region is arranged between the first and the second light-emitting unit,

wherein the first light-emitting unit comprises a first emission layer,
wherein the second light-emitting unit comprises a second emission layer,
wherein the at least one intermediate connecting region comprises an n-type charge generation layer, an intermediate layer, and a p-type charge generation layer,
wherein the n-type charge generation layer is arranged closer to the anode layer than the p-type charge generation layer;
wherein the p-type charge generation layer is arranged closer to the cathode layer than the n-type charge generation layer; and
wherein the intermediate layer is arranged between the n-type charge generation layer and the p-type charge

generation layer,
wherein the n-type charge generation layer is in direct contact to the intermediate layer, wherein p-type charge generation layer comprises a p-dopant, or a p-dopant and a hole transport matrix compound,
wherein the n-type charge generation layer comprises a metal dopant and an organic matrix compound, wherein the organic matrix compound is a compound of formula (I)

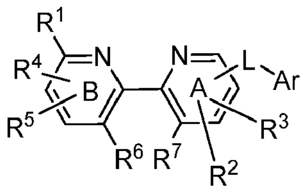
(I)

wherein A denotes pyridine moiety A, and B denotes pyridine moiety B;
wherein $R^1$ is selected from the group consisting of H, D, a substituted or unsubstituted $C_6$ to $C_{30}$ aryl or a substituted or unsubstituted $C_2$ to $C_{30}$ heteroaryl, a substituted or unsubstituted $C_1$ to $C_{16}$ alkyl, a substituted or unsubstituted $C_1$ to $C_{16}$ alkoxy, a substituted or unsubstituted $C_3$ to $C_{16}$ branched alkyl, a substituted or unsubstituted $C_3$ to $C_{16}$ cyclic alkyl, a substituted or unsubstituted $C_3$ to $C_{16}$ branched alkoxy, a substituted or unsubstituted $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy, $-PX^a(R^a)_2$, F or CN;
the one or more substituents on $R^1$ are independently selected from the group consisting of D, a substituted or unsubstituted $C_1$ to $C_{16}$ alkyl, a substituted or unsubstituted $C_6$ to $C_{30}$ aryl or a substituted or unsubstituted $C_2$ to $C_{30}$ heteroaryl, a substituted or unsubstituted $C_1$ to $C_{16}$ alkoxy, a substituted or unsubstituted $C_3$ to $C_{16}$ branched alkyl, a substituted or unsubstituted $C_3$ to $C_{16}$ cyclic alkyl, a substituted or unsubstituted $C_3$ to $C_{16}$ branched alkoxy, a substituted or unsubstituted $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy, $-PX^a(R^a)_2$, F or CN;
the one or more substituents are independently selected from the group consisting of D, $C_6$ to $C_{18}$ aryl, $C_3$ to $C_{20}$ heteroaryl, $C_1$ to $C_{16}$ alkyl, $C_1$ to $C_{16}$ alkoxy, $C_3$ to $C_{16}$ branched alkyl, $C_3$ to $C_{16}$ cyclic alkyl, $C_3$ to $C_{16}$ branched alkoxy, $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to C16 alkyl, partially or perdeuterated $C_1$ to $C_{16}$ alkoxy, $-PX^a(R^a)_2$, F or CN;
wherein $R^2$, $R^3$, $R^4$ and $R^5$ are independently selected from the group consisting of H, D, a substituted or unsubstituted $C_6$ to $C_{30}$ aryl or a substituted or unsubstituted $C_2$ to $C_{30}$ heteroaryl, a substituted or unsubstituted $C_1$ to $C_{16}$ alkyl, a substituted or unsubstituted $C_1$ to $C_{16}$ alkoxy, a substituted or unsubstituted $C_3$ to $C_{16}$ branched alkyl, a substituted or unsubstituted $C_3$ to $C_{16}$ cyclic alkyl, a substituted or unsubstituted $C_3$ to $C_{16}$ branched alkoxy, a substituted or unsubstituted $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy, $-PX^a(R^a)_2$, F or CN; and whereby $R^2$, $R^3$, and /or $R^4$ and $R^5$ may form a substituted or unsubstituted ring, preferably a 5- or 6-membered ring, preferably an aromatic or heteroaromatic ring.
the one or more substituents $R^2$, $R^3$, $R^4$ and $R^5$ are independently selected from the group consisting of D, a substituted or unsubstituted $C_1$ to $C_{16}$ alkyl, a substituted or unsubstituted $C_6$ to $C_{30}$ aryl or a substituted or unsubstituted $C_2$ to $C_{30}$ heteroaryl, a substituted or unsubstituted $C_1$ to $C_{16}$ alkoxy, a substituted or unsubstituted $C_3$ to $C_{16}$ branched alkyl, a substituted or unsubstituted $C_3$ to $C_{16}$ cyclic alkyl, a substituted or unsubstituted $C_3$ to $C_{16}$ branched alkoxy, a substituted or unsubstituted $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy, $-PX^a(R^a)_2$, F or CN;
the one or more substituents are independently selected from the group consisting of D, $C_6$ to $C_{18}$ aryl, $C_3$ to $C_{20}$ heteroaryl, $C_1$ to $C_{16}$ alkyl, $C_1$ to $C_{16}$ alkoxy, $C_3$ to $C_{16}$ branched alkyl, $C_3$ to $C_{16}$ cyclic alkyl, $C_3$ to $C_{16}$ branched alkoxy, $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to C16 alkyl, partially or perdeuterated $C_1$ to $C_{16}$ alkoxy, $-PX^a(R^a)_2$, F or CN;
wherein $R^6$ and $R^7$ are independently selected from the group consisting of a bond, H, D, a substituted or unsubstituted $C_1$ to $C_{16}$ alkyl, a substituted or unsubstituted $C_2$ to $C_8$ alkylene, a substituted or unsubstituted $C_6$ to $C_{30}$ aryl, a substituted or unsubstituted $C_6$ to $C_{30}$ arylene or a substituted or unsubstituted $C_2$ to $C_{30}$ heteroaryl, a substituted or unsubstituted $C_2$ to $C_{30}$ heteroarylene, a substituted or unsubstituted $C_1$ to $C_{16}$

alkoxy, a substituted or unsubstituted $C_3$ to $C_{16}$ branched alkyl, a substituted or unsubstituted $C_3$ to $C_{16}$ cyclic alkyl, a substituted or unsubstituted $C_3$ to $C_{16}$ branched alkoxy, a substituted or unsubstituted $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy, $-PX^a(R^a)_2$, F or CN;

the one or more substituents on $R^6$ and $R^7$ are independently selected from the group consisting of D, a substituted or unsubstituted $C_1$ to $C_8$ alkyl, a substituted or unsubstituted $C_6$ to $C_{30}$ aryl or a substituted or unsubstituted $C_2$ to $C_{30}$ heteroaryl, a substituted or unsubstituted $C_1$ to $C_{16}$ alkoxy, a substituted or unsubstituted $C_3$ to $C_{16}$ branched alkyl, a substituted or unsubstituted $C_3$ to $C_{16}$ cyclic alkyl, a substituted or unsubstituted $C_3$ to $C_{16}$ branched alkoxy, a substituted or unsubstituted $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy, $-PX^a(R^a)_2$, F or CN;

the one or more substituents are independently selected from the group consisting of D, $C_6$ to $C_{18}$ aryl, $C_3$ to $C_{20}$ heteroaryl, $C_1$ to $C_{16}$ alkyl, $C_1$ to $C_{16}$ alkoxy, $C_3$ to $C_{16}$ branched alkyl, $C_3$ to $C_{16}$ cyclic alkyl, $C_3$ to $C_{16}$ branched alkoxy, $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to C16 alkyl, partially or perdeuterated $C_1$ to $C_{16}$ alkoxy, $-PX^a(R^a)_2$, F or CN;

wherein $R^6$ and $R^7$ can form a condensed ring system with the pyridine moiety A and B;

wherein $R^6$ and $R^7$ together can represent ethenylene, which can be further substituted, whereby the substituents are independently chosen from D, a substituted or unsubstituted $C_1$ to $C_{16}$ alkyl, a substituted or unsubstituted $C_2$ to $C_8$ alkylene, a substituted or unsubstituted $C_6$ to $C_{30}$ aryl, a substituted or unsubstituted $C_6$ to $C_{30}$ arylene or a substituted or unsubstituted $C_2$ to $C_{30}$ heteroaryl, a substituted or unsubstituted $C_2$ to $C_{30}$ heteroarylene, a substituted or unsubstituted $C_1$ to $C_{16}$ alkoxy, a substituted or unsubstituted $C_3$ to $C_{16}$ branched alkyl, a substituted or unsubstituted $C_3$ to $C_{16}$ cyclic alkyl, a substituted or unsubstituted $C_3$ to $C_{16}$ branched alkoxy, a substituted or unsubstituted $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy, $-PX^a(R^a)_2$, F or CN;

wherein L-Ar can be bound to a part of the condensed ring system, if present, formed by $R^6$ and $R^7$ and the pyridine moiety A and B;

wherein L-Ar can be bound to ethenylene if $R^6$ and $R^7$ together represents ethenylene; wherein L is selected from the group consisting of an substituted or unsubstituted $C_6$ to $C_{24}$ arylene or substituted or unsubstituted $C_3$ to $C_{22}$ heteroarylene,

wherein the one or more substituents on L are independently selected from the group consisting of D, a substituted or unsubstituted $C_1$ to $C_{16}$ alkyl, a substituted or unsubstituted $C_6$ to $C_{30}$ aryl or a substituted or unsubstituted $C_2$ to $C_{30}$ heteroaryl, a substituted or unsubstituted $C_1$ to $C_{16}$ alkoxy, a substituted or unsubstituted $C_3$ to $C_{16}$ branched alkyl, a substituted or unsubstituted $C_3$ to $C_{16}$ cyclic alkyl, a substituted or unsubstituted $C_3$ to $C_{16}$ branched alkoxy, a substituted or unsubstituted $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy, $-PX^a(R^a)_2$, F or CN;

the one or more substituents are independently selected from D, $C_6$ to $C_{18}$ aryl, $C_3$ to $C_{20}$ heteroaryl, $C_1$ to $C_{16}$ alkyl, $C_1$ to $C_{16}$ alkoxy, $C_3$ to $C_{16}$ branched alkyl, $C_3$ to $C_{16}$ cyclic alkyl, $C_3$ to $C_{16}$ branched alkoxy, $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to C16 alkyl, partially or perdeuterated $C_1$ to $C_{16}$ alkoxy, $-PX^a(R^a)_2$, F or CN;

wherein Ar is selected from the group consisting of a substituted or unsubstituted $C_6$ to $C_{30}$ aryl or a substituted or unsubstituted $C_2$ to $C_{30}$ heteroaryl,

the one or more substituents on Ar are independently selected from the group consisting of D, a substituted or unsubstituted $C_1$ to $C_{16}$ alkyl, substituted or unsubstituted $C_2$ to $C_{16}$ alkenyl, a substituted or unsubstituted $C_6$ to $C_{30}$ aryl or a substituted or unsubstituted $C_2$ to $C_{30}$ heteroaryl, a substituted or unsubstituted $C_1$ to $C_{16}$ alkoxy, a substituted or unsubstituted $C_3$ to $C_{16}$ branched alkyl, a substituted or unsubstituted $C_3$ to $C_{16}$ cyclic alkyl, a substituted or unsubstituted $C_3$ to $C_{16}$ branched alkoxy, a substituted or unsubstituted $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy, $-PX^a(R^a)_2$, F or CN;

the one or more substituents are independently selected from the group consisting of D, $C_6$ to $C_{18}$ aryl, $C_3$ to $C_{20}$ heteroaryl, $C_1$ to $C_{16}$ alkyl, $C_1$ to $C_{16}$ alkoxy, $C_3$ to $C_{16}$ branched alkyl, $C_3$ to $C_{16}$ cyclic alkyl, $C_3$ to $C_{16}$ branched alkoxy, $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to C16 alkyl, partially or perdeuterated $C_1$ to $C_{16}$ alkoxy, $-PX^a(R^a)_2$, F or CN;

wherein $X^a$ may be selected from S or O; and

wherein $R^a$ are independently selected from the group consisting of $C_6$ to $C_{12}$ aryl, $C_3$ to $C_{12}$ heteroaryl, $C_1$ to

$C_{16}$ alkyl, $C_1$ to $C_{16}$ alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy;

and wherein the intermediate layer consists of or consists essentially of one or more organic electron transport compounds, wherein at least one of the one or more organic electron transport compounds is a compound of formula (I),

wherein the organic matrix compound and the organic electron transport compound of formula (I) can be selected the same or different,

wherein the organic electron transport compound has a LUMO energy level and the organic matrix compound has a LUMO energy level,

wherein the LUMO energy level of the organic matrix compound of formula (I) and the LUMO energy level of the organic electron transport compound of formula (I) in the intermediate layer have a difference of ±0.5 eV when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

**2.** The organic electroluminescent device according to claim 1, wherein the intermediate layer is free or essentially free of metal dopant.

**3.** An organic electroluminescent device according to claim 1 or 2, whereby the intermediate layer consists of or consists essentially of one or more organic electron transport compounds of formula (I).

**4.** The organic electroluminescent device according to any one of claims 1 or 3, wherein the intermediate layer has a thickness of equal or less than 5.0 nm.

**5.** The organic electroluminescent device according to any one of claims 1 to 4, wherein the organic matrix compound of formula (I) and the organic electron transport compound of formula (I) are selected the same.

**6.** The organic electroluminescent device according to any of the claims 1 to 5, whereby the compound of formula (I) is selected from the compounds of formula (II)

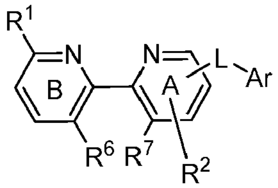

(II)

**7.** The organic electroluminescent device according to any of the claims 1 to 6, wherein the compound of formula (I) is selected from formulae (IIIa) and (IIIb)

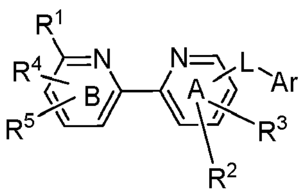

(IIIa)

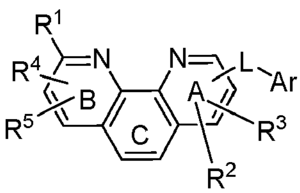

(IIIb)

wherein L-Ar can be bound to ring moiety A or ring moiety C, if present.

**8.** The organic electroluminescent device according to any one of claims 1 to 7, wherein in the compound of formula (I) $R^3$ to $R^5$ are H and $R^1$ and $R^2$ are independently selected from H, unsubstituted phenyl or unsubstituted pyridinyl.

**9.** The organic electroluminescent device according to any one of claims 1 to 8, wherein L is selected from the moieties L1 to L26:

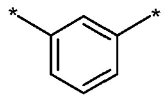

L1,

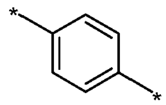

L2,

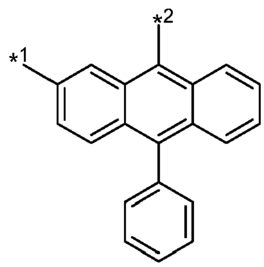

L3,

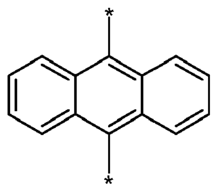

L4,

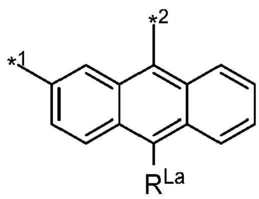

L5,

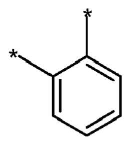

L6,

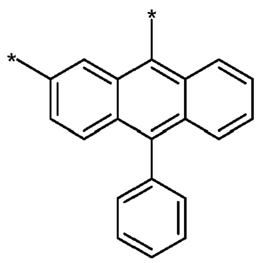

L7,

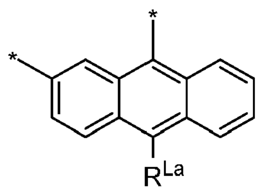

L8,

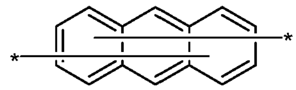

L9,

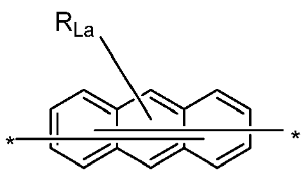

L10,

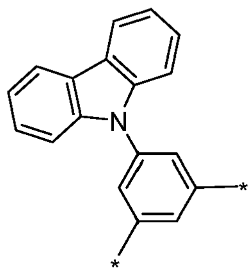

L11,

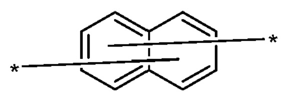

L12,

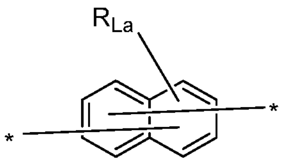

L13,

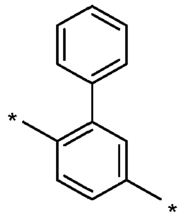

L14,

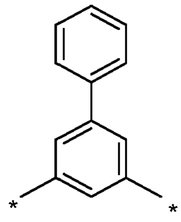

L15,

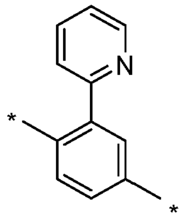

L16,

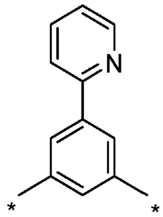

L17,

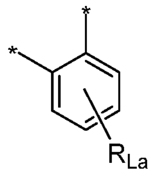

L18,

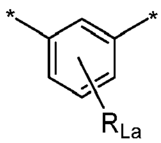

L19,

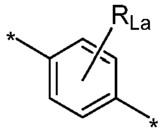

L20,

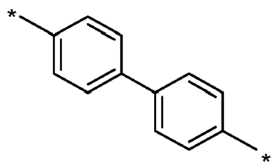

L21,

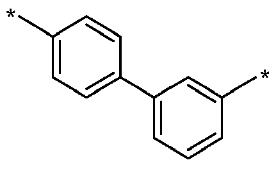

L22,

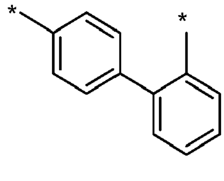

L23,

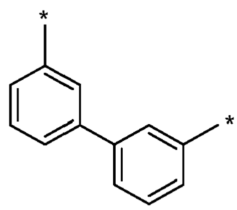

L24,

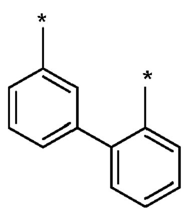

L25,

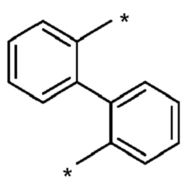

L26,

wherein

the asterisk "*" denotes the binding position to the pyridine moiety A or Ar, and wherein the asterisk "*1" denotes the binding position to the pyridine moiety A, and the asterisk "*2" denotes the binding position to Ar;
$R^{La}$ is selected from group consisting of D, a substituted or unsubstituted $C_1$ to $C_{16}$ alkyl, a substituted or unsubstituted $C_6$ to $C_{30}$ aryl or a substituted or unsubstituted $C_2$ to $C_{30}$ heteroaryl, a substituted or unsubstituted $C_1$ to $C_{16}$ alkoxy, a substituted or unsubstituted $C_3$ to $C_{16}$ branched alkyl, a substituted or unsubstituted $C_3$ to $C_{16}$ cyclic alkyl, a substituted or unsubstituted $C_3$ to $C_{16}$ branched alkoxy, a substituted or unsubstituted $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy, $-PX^a(R^a)_2$, F or CN;
the one or more substituents are independently selected from the group consisting of D, $C_6$ to $C_{18}$ aryl, $C_3$ to $C_{20}$ heteroaryl, $C_1$ to $C_{16}$ alkyl, $C_1$ to $C_{16}$ alkoxy, $C_3$ to $C_{16}$ branched alkyl, $C_3$ to $C_{16}$ cyclic alkyl, $C_3$ to $C_{16}$ branched alkoxy, $C_3$ to $C_{16}$ cyclic alkoxy, partially or perfluorinated $C_1$ to $C_{16}$ alkyl, partially or perfluorinated $C_1$ to $C_{16}$ alkoxy, partially or perdeuterated $C_1$ to C16 alkyl, partially or perdeuterated $C_1$ to $C_{16}$ alkoxy, $-PX^a(R^a)_2$, F or CN;
wherein $\mathbf{X^a}$ may be selected from S or O; and
wherein $\mathbf{R^a}$ are independently selected from the group consisting of $C_6$ to $C_{12}$ aryl, $C_3$ to $C_{12}$ heteroaryl, $C_1$ to $C_{16}$ alkyl, $C_1$ to $C_{16}$ alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy.

**10.** The organic electroluminescent device according to any one of claims 1 to 9, whereby Ar is selected from substituted or unsubstituted phenyl, biphenyl, fluorenyl, benzofluorenyl, naphthyl, phenanthryl, anthracenyl, triphenylenyl, pyrenyl, perylenyl, benzofuranyl, benzothiophenyl, dibenzofuranyl, dibenzothiophenyl, pyridyl, pyrimidinyl, triazinyl, pyrazinyl, imidazo[1,5-a]pyridinyl, quinolinyl, benzoquinolinyl, phenanthrolinyl, acridinyl, benzoacridinyl, dibenzoacridinyl, fluorene, benzofluorene, dibenzofluorene, 9,9'-spirobi[fluorene], 13H-indeno[1,2-1]phenanthrene, naphthalene, anthracene, phenanthrene, triphenylene, pyrene, perylene, triphenylene, rubrene, chrysene, fluoranthene, spiro[benzo[de]anthracene-7,9'-fluorene], acridine, benzoacridine, dibenzoacridine, imidazo[1,5-a]pyridine, benzoquinoline, quinoline, quinazoline, quinoxaline, benzoquinoline, phenanthroline, benzimidazole, aza-triphenylene, carbazole, dibenzofurane, dibenzothiophene, dibenzoselenophene, aza-dibenzofuran, aza-dibenzothiophene, aza-dibenzoselenophene, di-aza-dibenzothiophene, di-azadibenzoselenophene.

**11.** The organic electroluminescent device according to any one of claims 1 to 10, wherein the moiety L-Ar is in $\alpha$-position to a nitrogen in either Ring A or B.

**12.** The organic electroluminescent device according to any one of claims 1 to 11, whereby the metal dopant in the n-type charge generation layer is selected from Li, Mg or Yb.

**13.** The organic electroluminescent device according to any one of claims 1 to 12, wherein the p-type charge generation layer is in direct contact to the intermediate layer.

**14.** A display device comprising an organic electroluminescent device according to any of the claims 1 to 13.

**15.** A method for preparation of an organic electroluminescent device, preferably an organic light emitting device according to any of the claims 1 to 13, comprising the steps of:

- forming an n-type charge generation layer comprising an organic matrix compound and a metal dopant by depositing an organic matrix compound and a metal dopant, wherein the organic matrix compound is a compound of formula (I);
- forming an intermediate layer comprising or consisting of or consisting essentially of at least one or more organic electron transport compounds by depositing one or more organic electron transport compounds directly on the n-type charge generation layer, wherein at least one of the one or more organic electron transport compounds is a compound of formula (I);
- forming a p-type charge generation layer by depositing a hole transport matrix compound and a p-dopant directly on the intermediate layer,

wherein the organic matrix compound of formula (I) and the organic electron transport compound of formula (I) can be selected the same or different,
wherein the organic electron transport compound of formula (I) has a LUMO energy level and the organic matrix compound of formula (I) has a LUMO energy level,
wherein the LUMO energy level of the organic matrix compound of formula (I) and the LUMO energy level of the organic electron transport compound of formula (I) in the intermediate layer have a difference of $\pm 0.5$ eV

when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

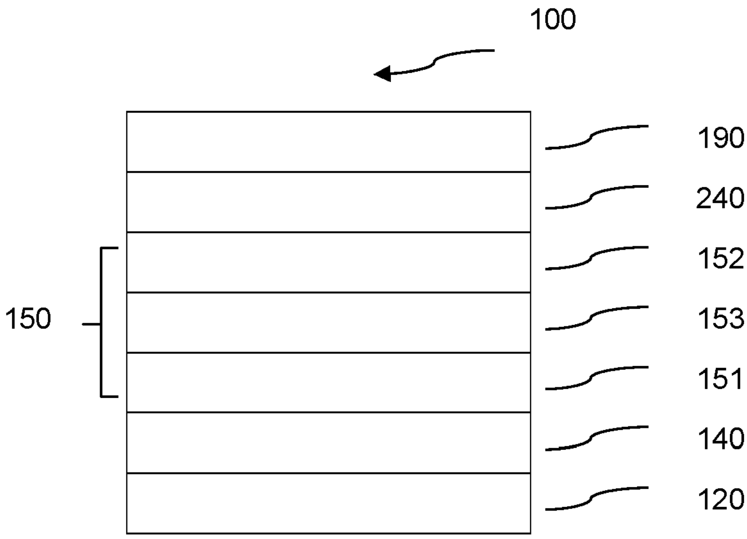


Fig. 1

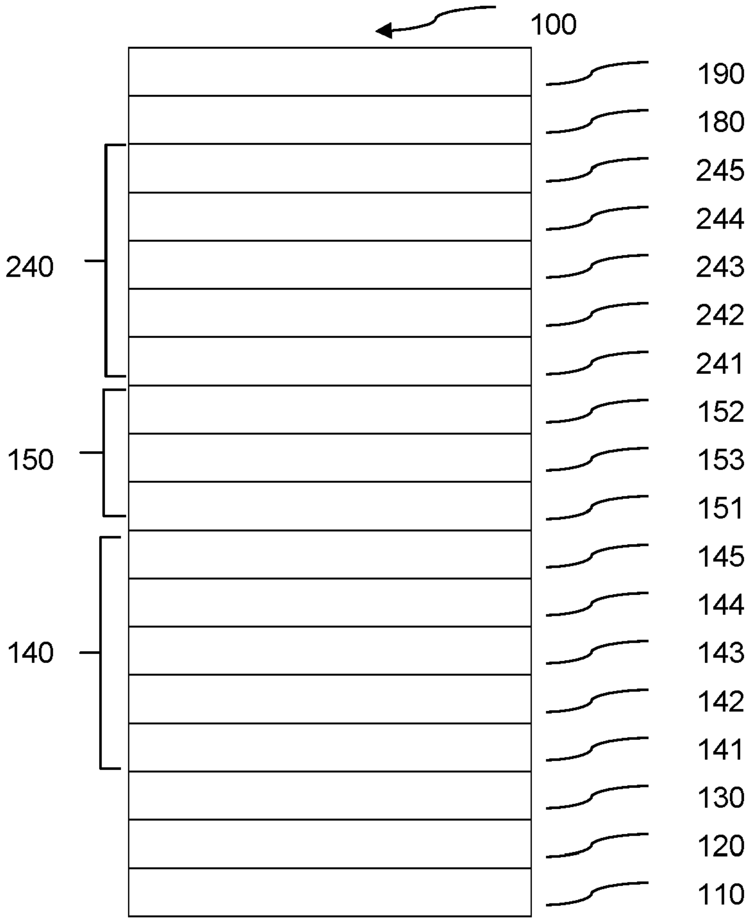
100
190
180
245
244
243
242
241
152
153
151
145
144
143
142
141
130
120
110
240
150
140

**Fig .2**

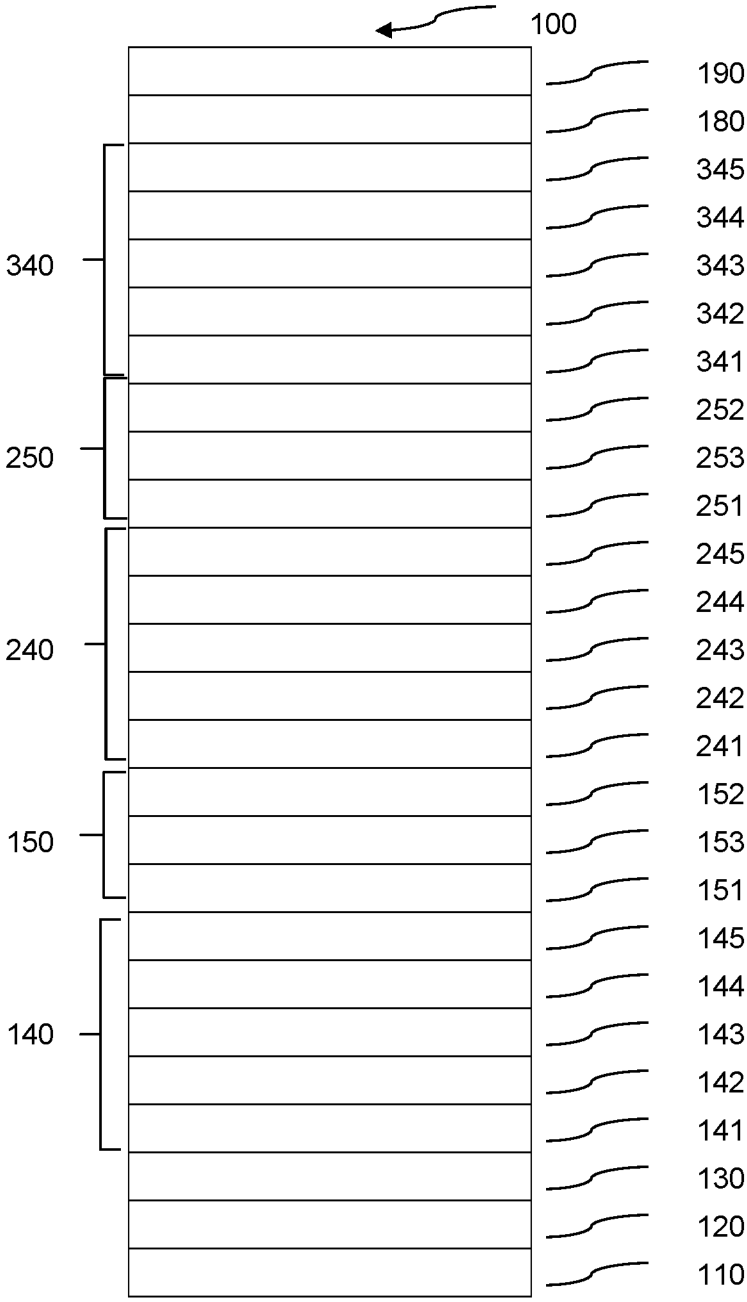
100
190
180
345
344
343
342
341
252
253
251
245
244
243
242
241
152
153
151
145
144
143
142
141
130
120
110
340
250
240
150
140

Fig. 3

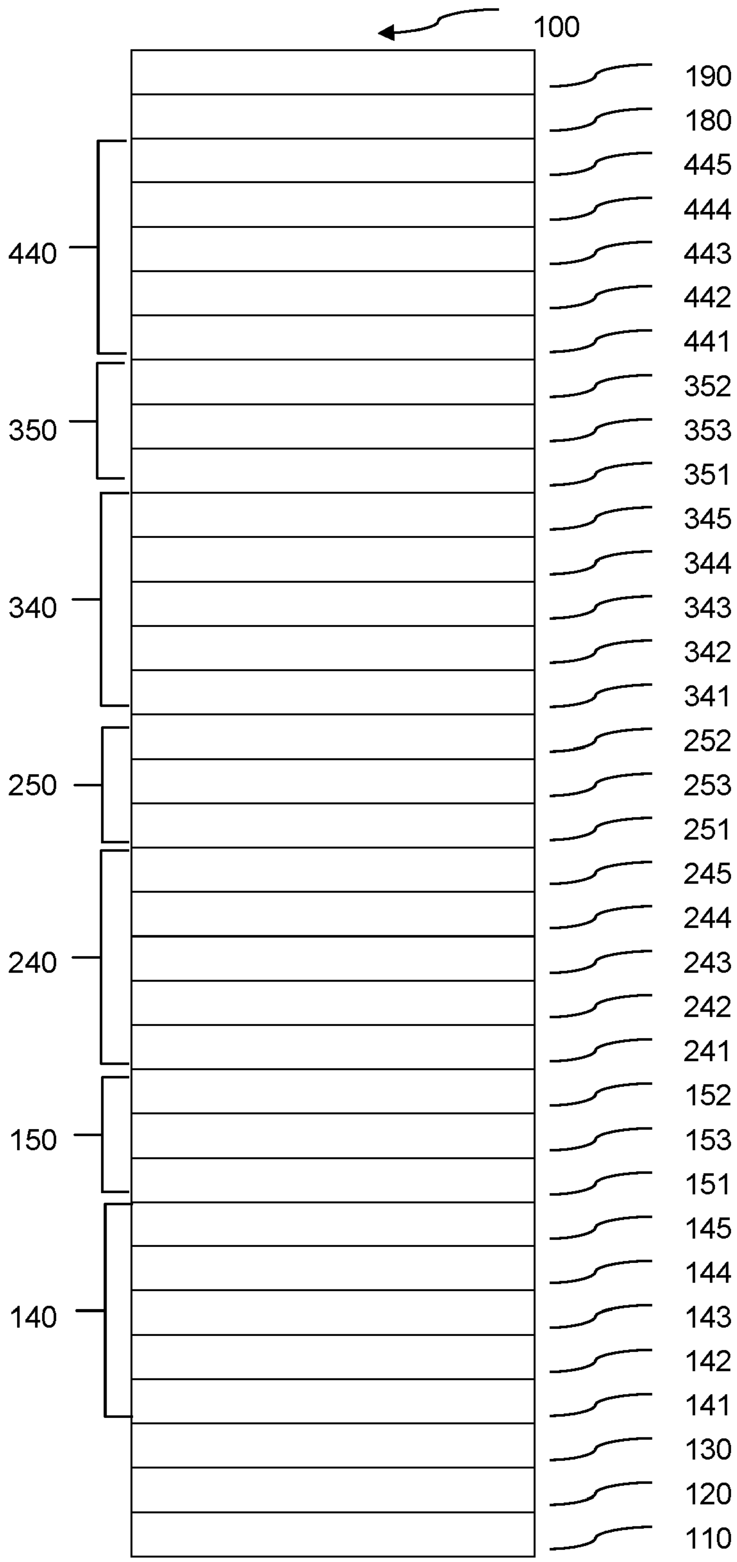
100
190
180
445
444
443
442
441
352
353
351
345
344
343
342
341
252
253
251
245
244
243
242
241
152
153
151
145
144
143
142
141
130
120
110
440
350
340
250
240
150
140

Fig. 4

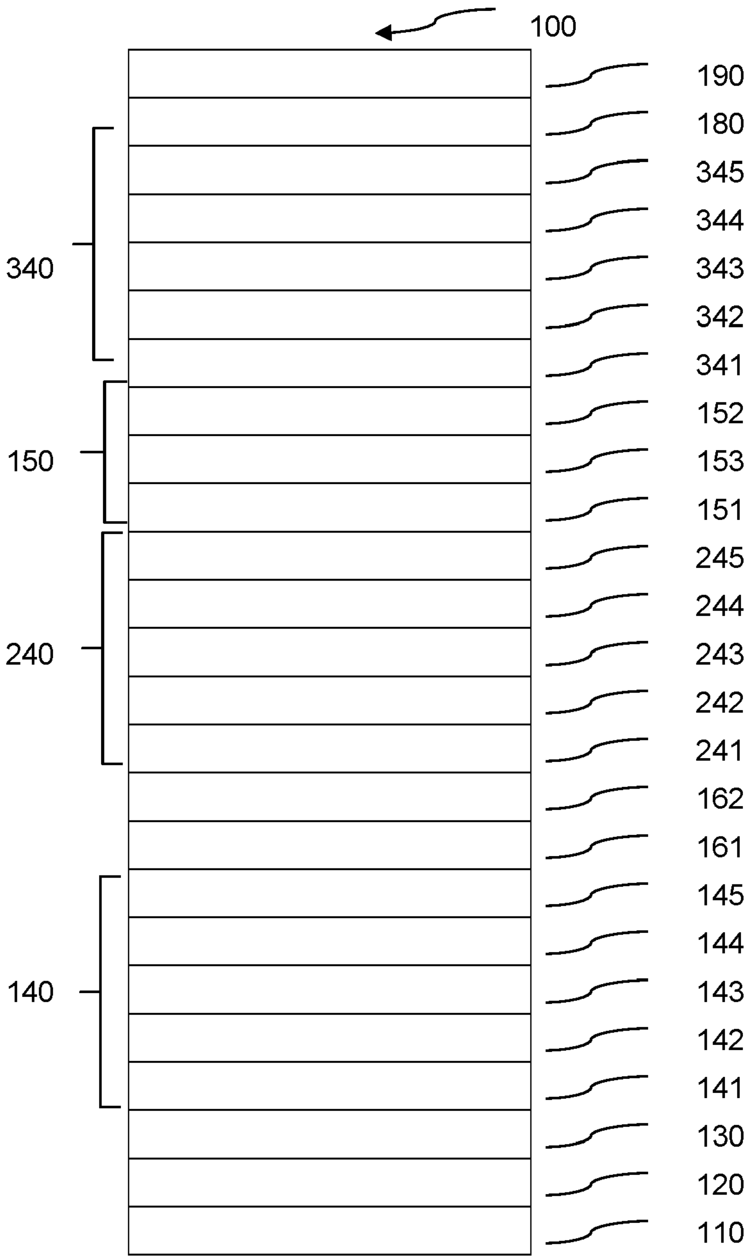
100
190
180
345
344
343
342
341
152
153
151
245
244
243
242
241
162
161
145
144
143
142
141
130
120
110
340
150
240
140

Fig. 5

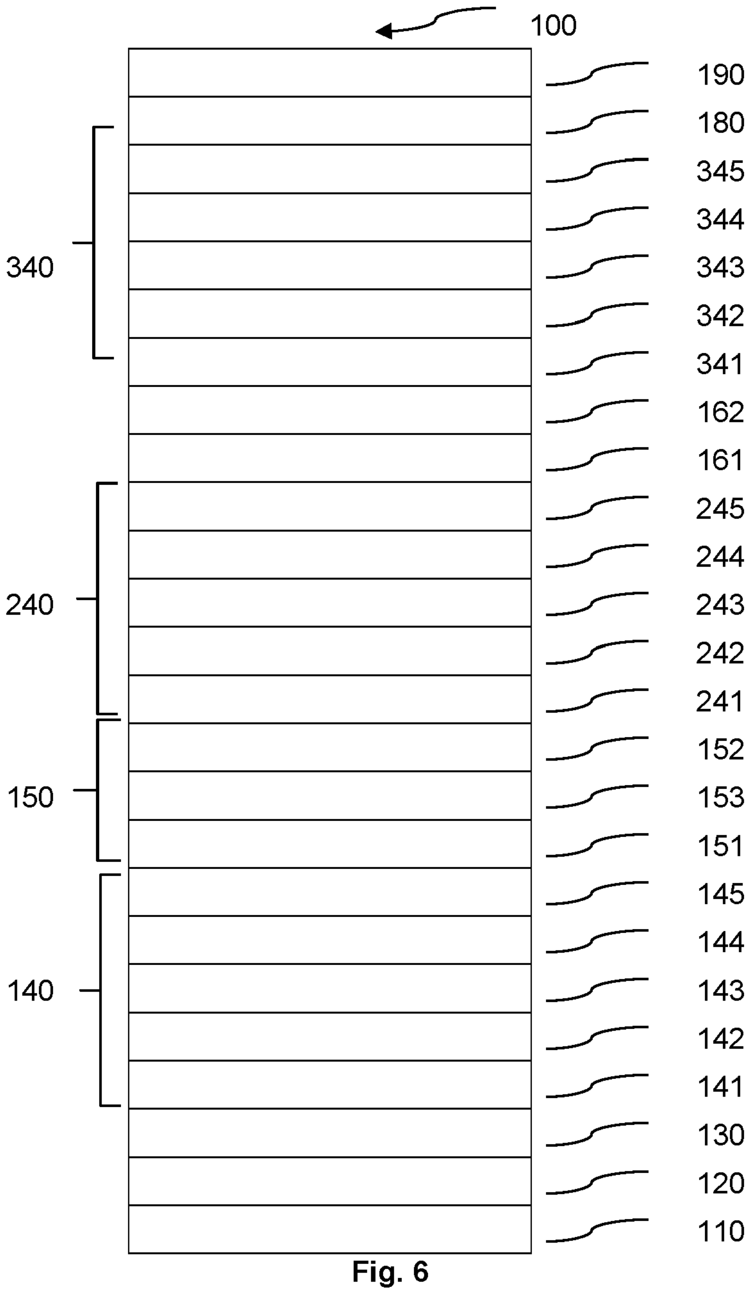
100
190
180
345
344
343
342
341
162
161
245
244
243
242
241
152
153
151
145
144
143
142
141
130
120
110
340
240
150
140
Fig. 6

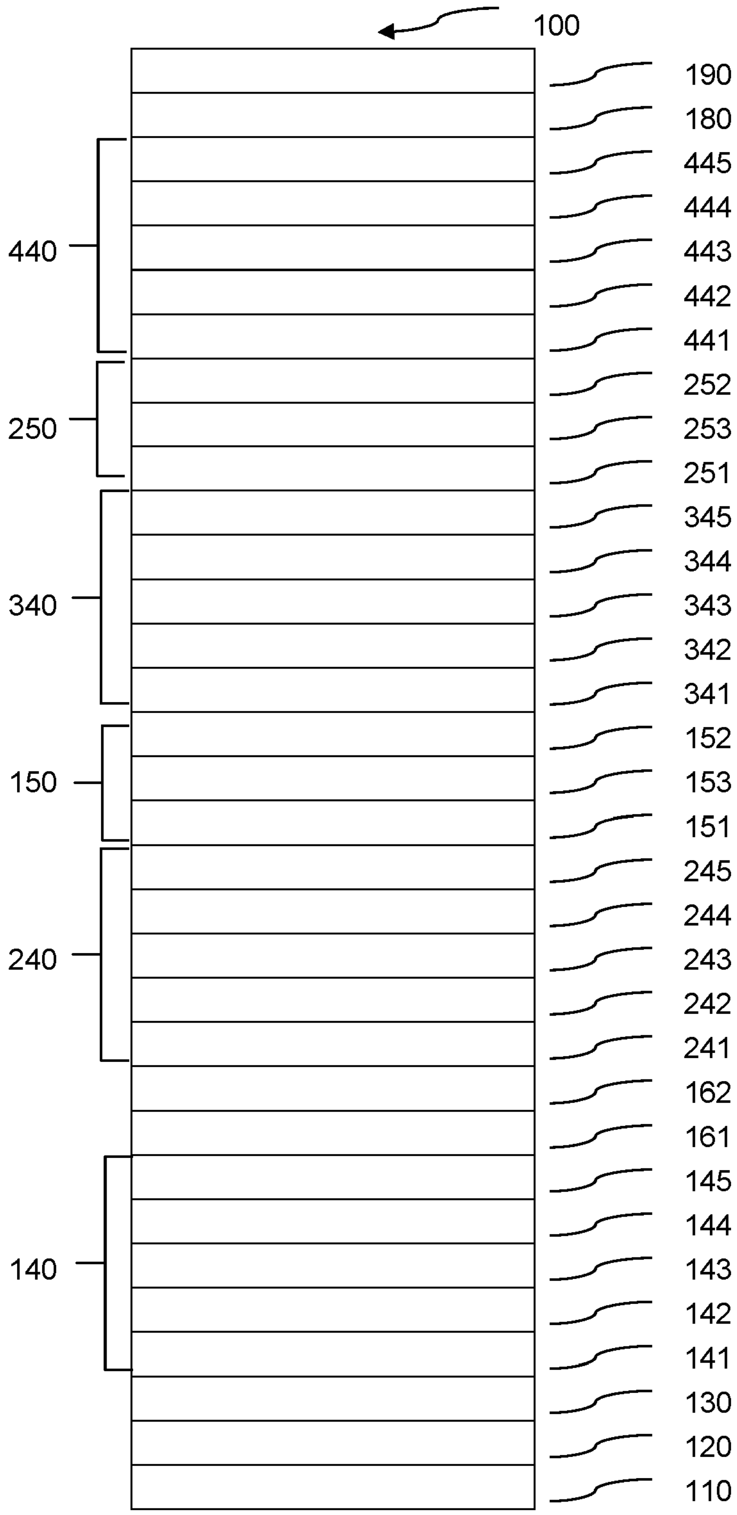
100
190
180
445
444
443
442
441
252
253
251
345
344
343
342
341
152
153
151
245
244
243
242
241
162
161
145
144
143
142
141
130
120
110
440
250
340
150
240
140

Fig. 7

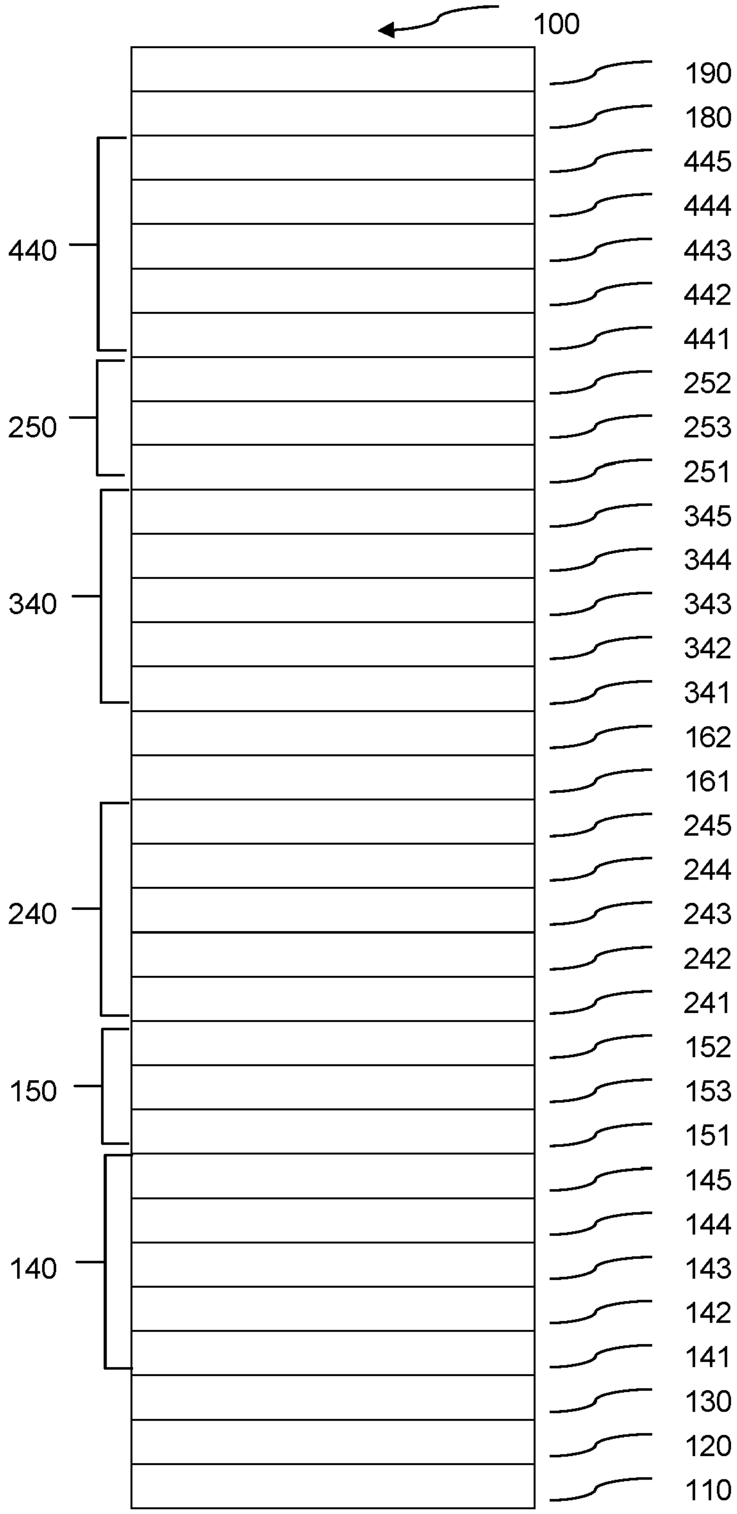
100
190
180
445
444
443
442
441
252
253
251
345
344
343
342
341
162
161
245
244
243
242
241
152
153
151
145
144
143
142
141
130
120
110
440
250
340
240
150
140

Fig. 8

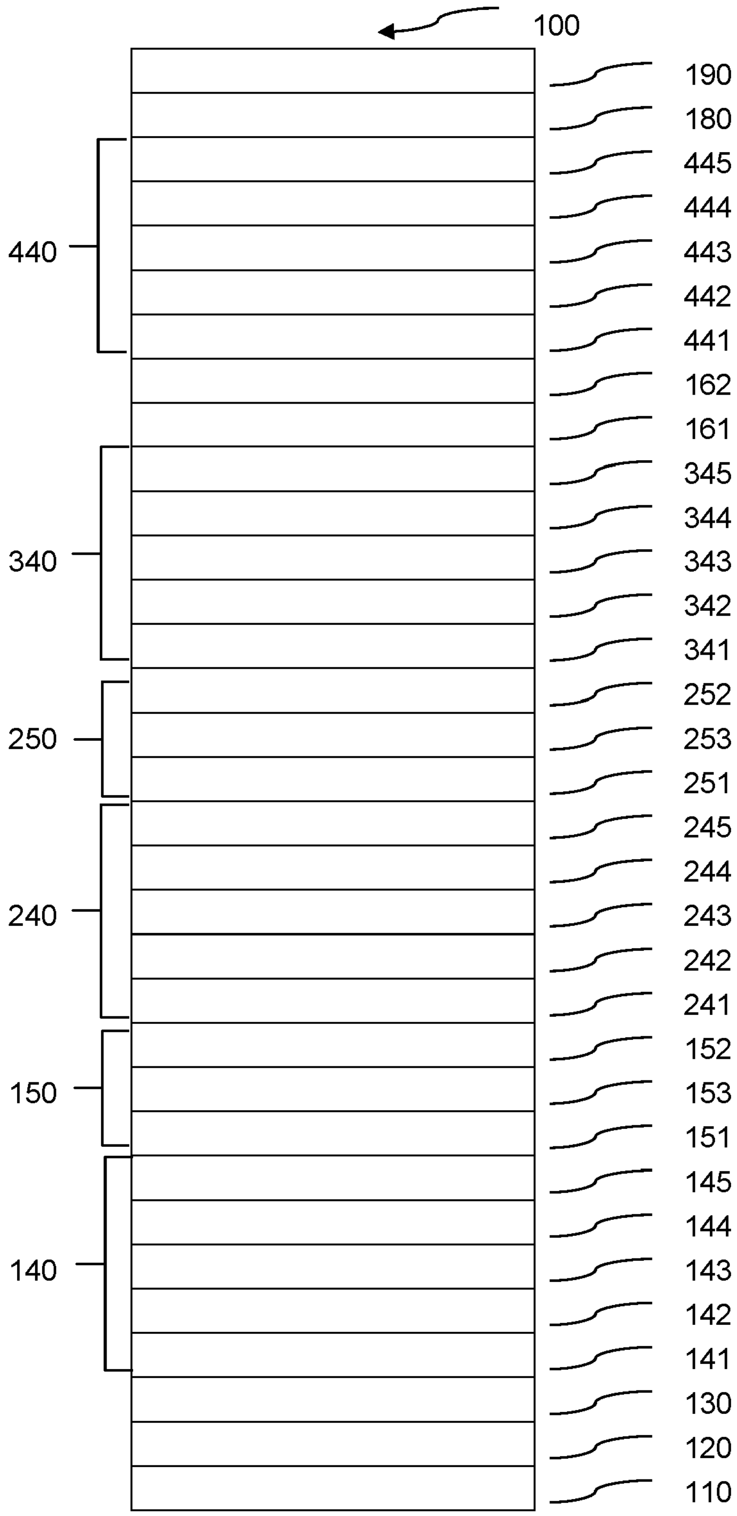
100
190
180
445
444
443
442
441
162
161
345
344
343
342
341
252
253
251
245
244
243
242
241
152
153
151
145
144
143
142
141
130
120
110
440
340
250
240
150
140

Fig. 9

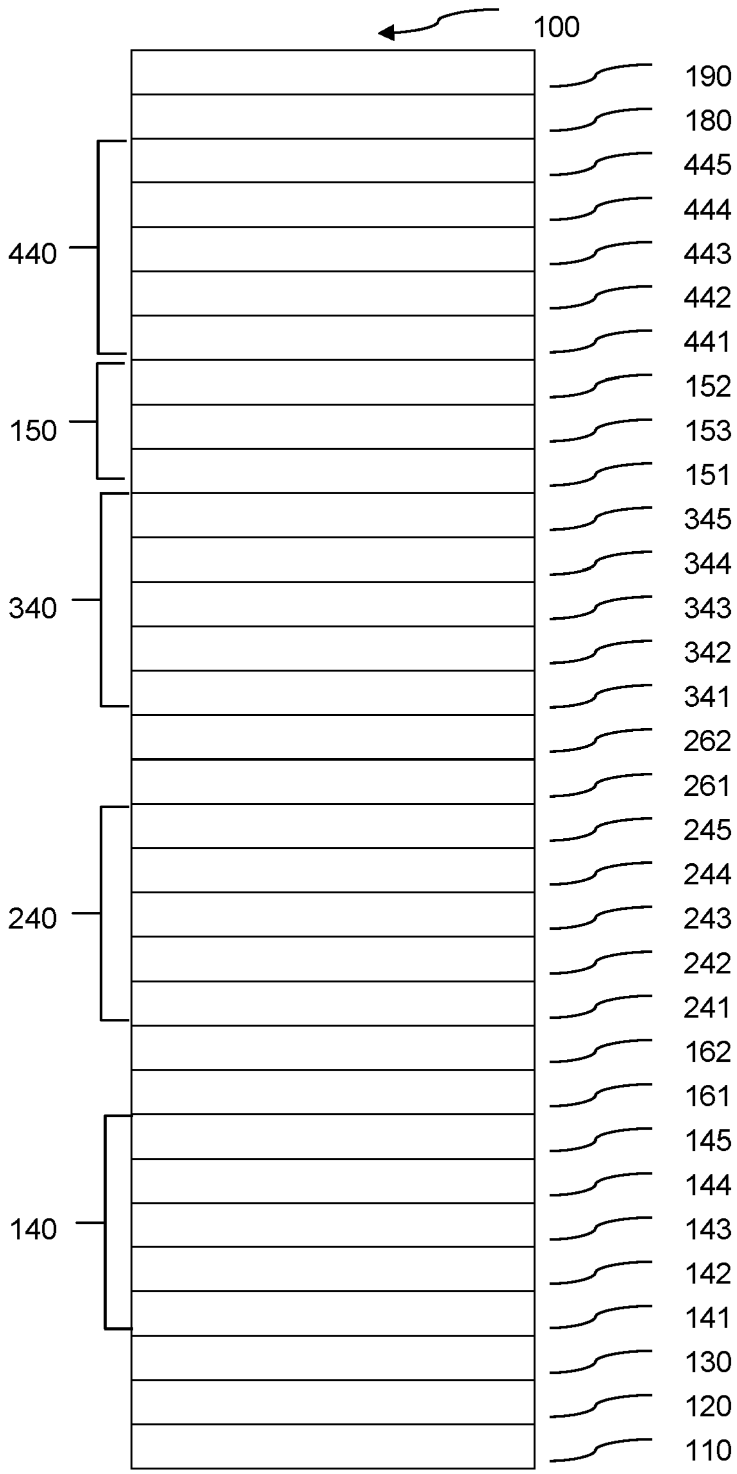
100
190
180
445
444
443
442
441
152
153
151
345
344
343
342
341
262
261
245
244
243
242
241
162
161
145
144
143
142
141
130
120
110
440
150
340
240
140

Fig. 10

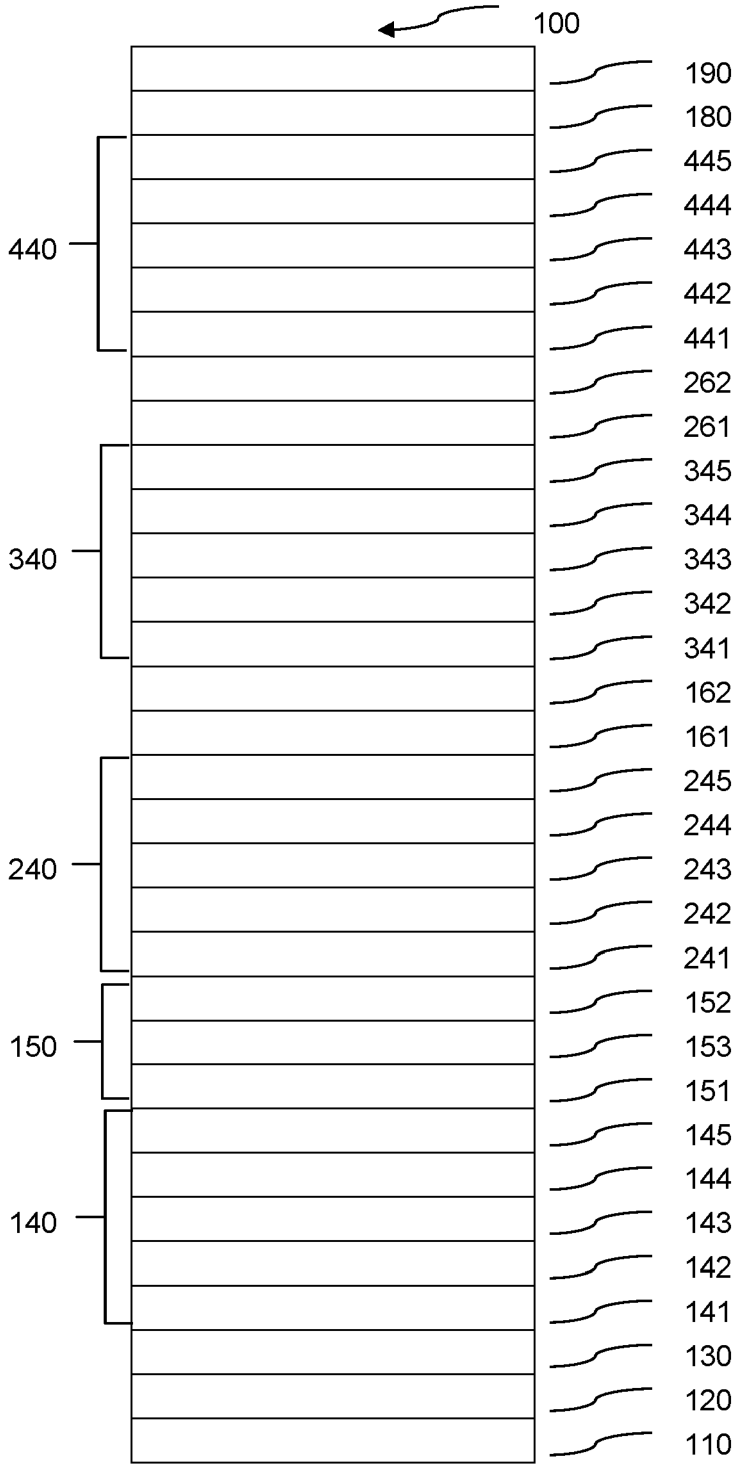
100
190
180
445
444
443
442
441
262
261
345
344
343
342
341
162
161
245
244
243
242
241
152
153
151
145
144
143
142
141
130
120
110
440
340
240
150
140

Fig. 11

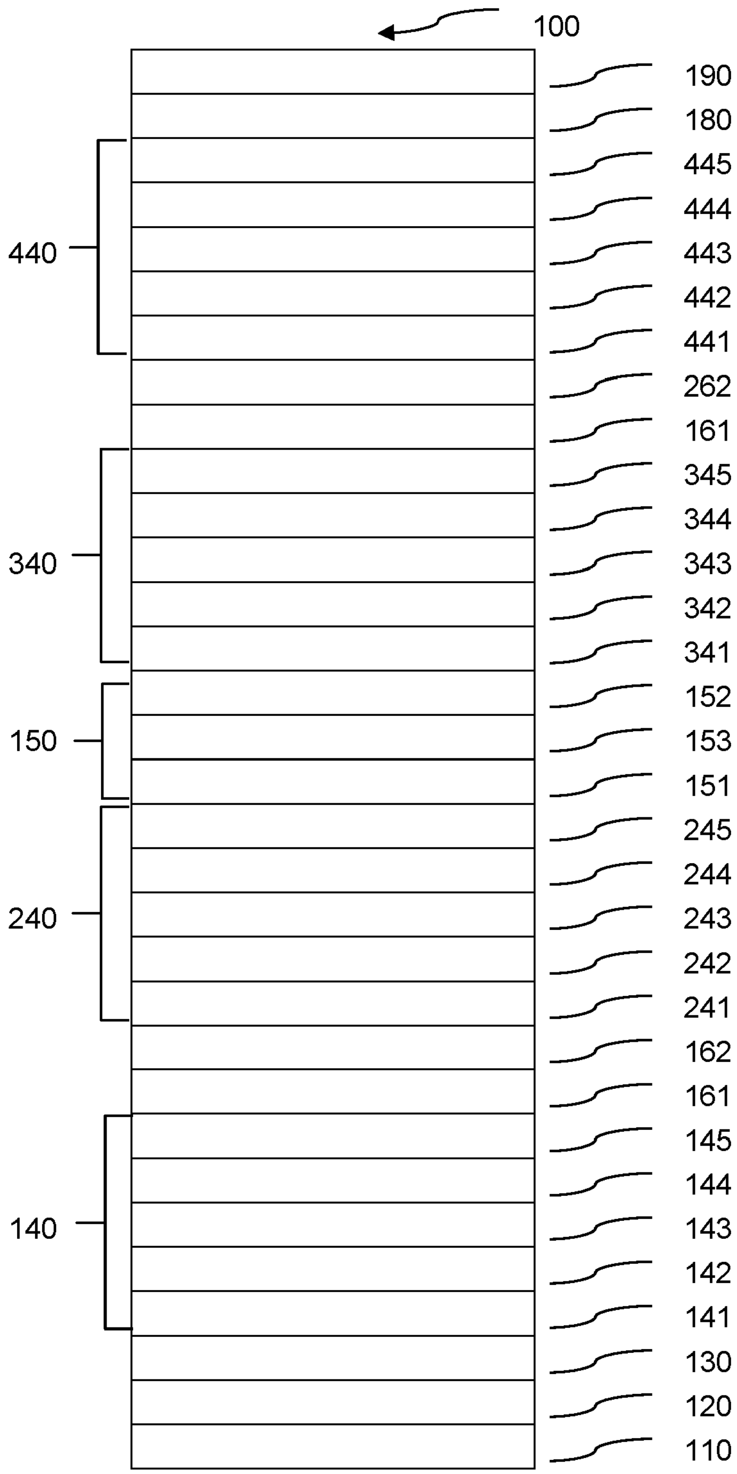
100
190
180
445
444
443
442
441
262
161
345
344
343
342
341
152
153
151
245
244
243
242
241
162
161
145
144
143
142
141
130
120
110
440
340
150
240
140

Fig. 12

Europäisches Patentamt
European Patent Office
Office européen des brevets

# EUROPEAN SEARCH REPORT

Application Number
EP 23 16 7016

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br>Y | US 2021/104707 A1 (KIM DONGCHAN [KR] ET AL) 8 April 2021 (2021-04-08)<br>* paragraphs [0068] - [0075] *<br>* paragraphs [0120] - [0143] *<br>* paragraphs [0339] - [0368] *<br>* paragraphs [0313], [0424], [0426] *<br>* table 1 *<br>* compounds ET37,HAT-CN,CuI,Li *<br>* figures 1,2 *<br>----- | 1-7, 12-15<br>8-11 | INV.<br>H10K50/19<br>H10K85/60 |
| Y | US 2019/103565 A1 (HUMMERT MARKUS [DE] ET AL) 4 April 2019 (2019-04-04)<br>* paragraph [0132] *<br>* compound F3 *<br>----- | 8-11 | |

TECHNICAL FIELDS SEARCHED (IPC)

H10K

The present search report has been drawn up for all claims

1

| Place of search | Date of completion of the search | Examiner |
|---|---|---|
| Munich | 11 August 2023 | Pfattner, Raphael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 23 16 7016

This annex lists the patent family members relating to the patent documents cited in the above-mentioned European search report. The members are as contained in the European Patent Office EDP file on
The European Patent Office is in no way liable for these particulars which are merely given for the purpose of information.

11-08-2023

| Patent document cited in search report | Publication date | Patent family member(s) | Publication date |
|---|---|---|---|
| US 2021104707 A1 | 08-04-2021 | CN 112614948 A | 06-04-2021 |
| | | EP 3800682 A1 | 07-04-2021 |
| | | KR 20210041160 A | 15-04-2021 |
| | | US 2021104707 A1 | 08-04-2021 |
| US 2019103565 A1 | 04-04-2019 | CN 109599494 A | 09-04-2019 |
| | | EP 3462516 A1 | 03-04-2019 |
| | | JP 2019068074 A | 25-04-2019 |
| | | KR 20190039014 A | 10-04-2019 |
| | | US 2019103565 A1 | 04-04-2019 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 2722908 A1


### Non-patent literature cited in the description


- **YASUHIKO SHIROTA ; HIROSHI KAGEYAMA.** *Chem. Rev.,* 2007, vol. 107, 953-1010